(19) Europäisches Patentamt
European Patent Office
Office européen des brevets

(11) **EP 1 825 646 B1**

(12) **EUROPÄISCHE PATENTSCHRIFT**

(45) Veröffentlichungstag und Bekanntmachung des Hinweises auf die Patenterteilung:
**02.07.2008   Patentblatt 2008/27**

(21) Anmeldenummer: **05815945.0**

(22) Anmeldetag: **12.12.2005**

(51) Int Cl.:
*H04L 27/26* *(2006.01)*

(86) Internationale Anmeldenummer:
**PCT/EP2005/013294**

(87) Internationale Veröffentlichungsnummer:
**WO 2006/063760 (22.06.2006 Gazette 2006/25)**

(54) **Konvertieren eines komplexwertigen Startsignals in ein komplexwertiges Endsignal mit einer höheren oder niedrigeren Frequenz**

Converting a Complex Start Signal into a Complex Final Signal with a Higher or Lower Frequency

Conversion d'un signal de début complexe en un signal de fin complexe d'une fréquence plus haute ou plus basse

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **13.12.2004   DE 102004059940**

(43) Veröffentlichungstag der Anmeldung:
**29.08.2007   Patentblatt 2007/35**

(73) Patentinhaber: **Fraunhofer-Gesellschaft zur Förderung der angewandten Forschung e.V.**
**80686 München (DE)**

(72) Erfinder: **BREILING, Marco**
**91052 Erlangen (DE)**

(74) Vertreter: **Pfenning, Meinig & Partner GbR Patent- und Rechtsanwälte**
**Joachimstaler Strasse 10-12**
**10719 Berlin (DE)**

(56) Entgegenhaltungen:
- SAMUELI H ET AL: "A VLSI Architecture for a High-Speed All-Digital Quadrature Modulator and Demodulator for Digital Radio Applications" IEEE JOURNAL ON SELECTED AREAS IN COMMUNICATIONS, IEEE SERVICE CENTER, PISCATAWAY, NJ, US, Bd. 8, Nr. 8, 1. Oktober 1990 (1990-10-01), Seiten 1512-1519, XP002141835 ISSN: 0733-8716
- TANAI H ET AL: "A MODEM IMPLEMENTATION USING A PERIODICALLY TIME VARYING DIGITAL FILTER" IEICE TRANSACTIONS, INSTITUTE OF ELECTRONICS INFORMATION AND COMM. ENG. TOKYO, JP, Bd. E74, Nr. 11, 1. November 1991 (1991-11-01), Seiten 3569-3574, XP000280934 ISSN: 0917-1673

**Beschreibung**

Die vorliegende Erfindung bezieht sich auf einen Signalkonvertierer und ein Verfahren zum Konvertieren eines Startsignals in ein Endsignal, und insbesondere bezieht sich die vorliegende Erfindung auf einen Signalkonvertierer und ein Verfahren zum Konvertieren eines Startsignals in ein Endsignal, die unter Verwendung von digitalen Signalverarbeitungskomponenten in der Nachrichten- oder Hochfrequenztechnik einsetzbar sind.

Um in der Nachrichtentechnik ein Signal von einer derzeitigen Frequenz (Aktuell-Frequenz) in eine höhere Übertragungsfrequenz (Zielfrequenz) zu verschieben, werden zumeist Mischer eingesetzt. Für eine solche Verschiebung bieten sich beispielsweise im Sender mehrere verschiedene Möglichkeiten an. Zunächst kann ein Signal mit einer niedrigen Bandbreite $B_{low}$ zu verschiedenen Mittenfrequenzen innerhalb einer großen Bandbreite B verschoben werden. Wenn diese Mittenfrequenz über einen längeren Zeitraum konstant ist, dann bedeutet dies nichts anderes als die Auswahl eines Teilbandes innerhalb des größeren Frequenzbandes. Eine solche Vorgehensweise wird als "Tuning" bezeichnet. Wird die Mittenfrequenz, auf die das Signal verschoben werden soll, relativ schnell variiert, bezeichnet man ein solches System als ein Frequency-Hopping-System oder Spread-Spectrum-System. Als Alternative lassen sich auch innerhalb einer großen Bandbreite B mehrere Sendesignale mit einer jeweils niedrigen Bandbreite $B_{low}$ im Frequenzmultiplexer parallel ausstrahlen.

Analog zu diesen Vorgehensweisen im Sender sind die jeweiligen Empfänger entsprechend auszugestalten. Dies bedeutet einmal, dass ein Teilband der großen Bandbreite B auszuwählen ist, wenn die Mittenfrequenz des gesendeten Signals über einen längeren Zeitraum konstant ist. Das Tuning erfolgt dann zu der vorgegebenen Mittenfrequenz. Wird die Mittenfrequenz relativ schnell variiert, wie dies bei einem Frequency-Hopping-System der Fall ist, muss auch im Empfänger ein schneller zeitlicher Wechsel der Mittenfrequenz des gesendeten Signals erfolgen. Sind mehrere Sendesignale im Frequenzmultiplexer parallel ausgesandt worden, muss auch ein paralleler Empfang dieser mehreren frequenzgemultiplexten Signale innerhalb der größeren Bandbreite B erfolgen.

Herkömmlicherweise wird für ein oben skizziertes Tuning-System und ein Frequency-Hopping-System ein analoger oder digitaler Mischer eingesetzt, wobei das digitale Mischen üblicherweise mit einer einzigen Mischerstufe erfolgt. Bei einem analogen Mischer ist ein hoher schaltungstechnischer Aufwand notwendig, da für eine präzise Mischung auf die Zielfrequenz hochgenaue Mischerbauteile erforderlich sind, die die Kosten des herzustellenden Senders deutlich erhöhen. Zu einem digitalen Mischer ist anzumerken, dass ein teils hoher schaltungstechnischer (bzw. numerischer) Aufwand notwendig ist, wenn das Signal auf eine frei wählbare beliebige Zielfrequenz gemischt werden soll.

Für ein paralleles Senden und Empfangen mehrerer TeilFrequenzbänder wird ferner häufig das OFDM (OFDM = orthogonal frequency division multiplexing = orthogonaler Frequenzmultiplex) und damit verwandte Multiträgermodulation- bzw. Multitone-Modulation-Verfahren verwendet. Diese erfordern durch die Verwendung der Fourier-Transformation einen teils erheblichen Rechenaufwand, insbesondere wenn nur wenige der Teilfrequenzbänder aus einem großen Frequenzband mit vielen einzelnen Teilfrequenzbändern benötigt werden.

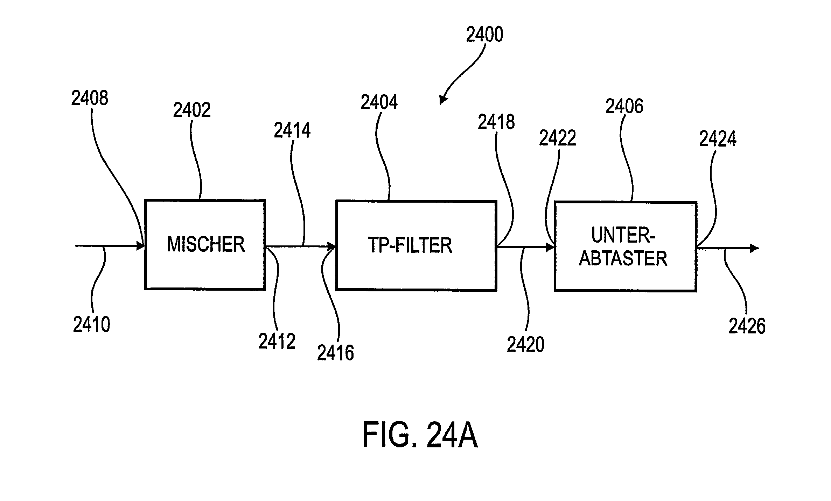

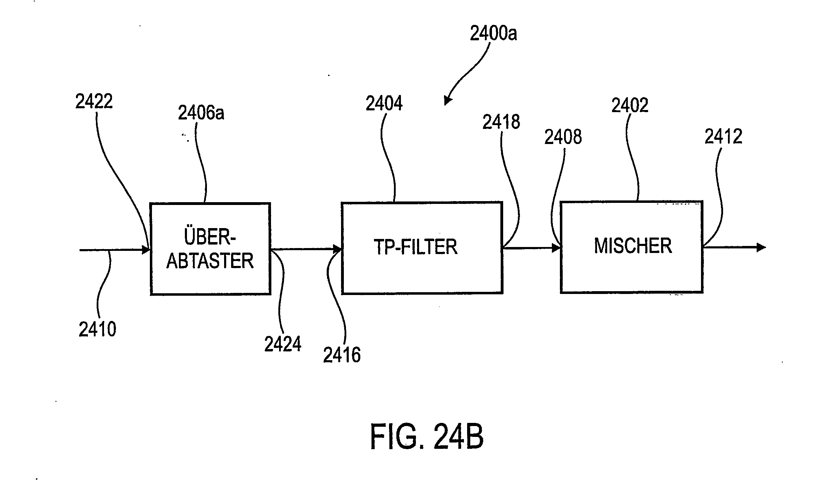

Herkömmliche Mischer können dabei ähnlich der Mischervorrichtung 2400 ausgebildet sein, wie sie in Fig. 24A dargestellt ist, wobei diese Mischervorrichtung 2400 auf eine Abwärtsmischung bezogen ist. Ohne Beschränkung der Allgemeinheit lässt sich jedoch auch eine entsprechende Anordnung der in Fig. 24A dargestellten Komponenten der Mischervorrichtung für eine Aufwärtsmischung einsetzen. Eine derartige Mischervorrichtung ist in Fig. 24B dargestellt.

Die Mischervorrichtung 2400 in Fig. 24A kann einen Mischer 2402, ein Tiefpassfilter 2404 und einen Unterabtaster 2406 enthalten. Der Mischer 2402 umfasst einen Eingang 2408 zum Empfangen eines zu mischenden Signals 2410. Ferner umfasst der Mischer 2402 einen Ausgang 2412 zum Ausgeben des von der Aktuellfrequenz auf eine Zwischenfrequenz umgesetzten Signals 2414, welches über einen Eingang 2416 des Tiefpassfilters 2404 demselben zugeführt wird. Weiterhin umfasst das Tiefpassfilter 2404 einen Ausgang 2418 zum Ausgeben eines frequenzumgesetzten tiefpassgefilterten Signals 2420, welches über einen Eingang 2422 des Unterabtasters 2406 demselben zuführbar ist. Der Unterabtaster 2406 umfasst einen Ausgang 2424 zum Ausgeben eines unterabgetasteten Signals 2426, welches zugleich ein von der Mischervorrichtung 2400 ausgegebenes Ausgangssignal ist. In Fig. 24B sind Komponenten dargestellt, die dem Mischer 2402, dem Tiefpass-Filter 2404 und dem Unterabtaster 2406 entsprechen, wobei in der Zusammenschaltung gemäß Fig. 24B ein Aufwärtsmischer 2400a realisiert ist. Hierzu ist die Abfolge der Komponenten verändert, derart, dass zuerst ein dem Unterabtaster 2406 für eine Aufwärtsmischung entsprechender Überabtaster 2406a vor das Tiefpass-Filter 2404 und nachfolgend den Mischer 2402 geschaltet ist. Die Funktionalität des in Fig. 24B dargestellten Mischers 2400a lässt sich analog zu der nachfolgend näher beschriebenen Funktionalität des Mischers 2400 erläutern, wobei der in Fig. 24B gezeigte Mischer 2400a ausgebildet ist, um eine Wirkung des Mischers 2400 aus Fig. 24A auf ein Signal rückgängig zu machen.

Wird der Mischervorrichtung 2400 in Fig. 24A das Eingangssignal 2410 mit der Aktuellfrequenz zugeführt, wobei das Startsignal 2410 auf einer ersten Abtastfrequenz beruht, die einen Abstand von zwei zeitdiskreten Signalwerten definiert, erfolgt durch den Mischer 2402 ein Umsetzen der Aktuellfrequenz auf eine Zwischenfrequenz, wodurch das Zwischenfrequenzsignal 2414 resultiert. In diesem Zwischenfrequenzsignal 2414 ist lediglich die Frequenz, auf der sich das Startsignal 2410 befindet (d. h. die Aktuellfrequenz), auf eine Zwischenfrequenz umgesetzt, wobei die Abtastfrequenz durch den Mischer 2402 nicht verändert wird. Bei einer geeigneten Wahl der Aktuellfrequenz und der Abtastfrequenz lässt sich auf numerisch oder schaltungstechnisch einfache Weise eine Mischung auf das Zwischenfrequenzsignal 2414 mit der Zwischenfrequenz realisieren. Beträgt beispielsweise der spektrale Abstand zwischen der Aktuellfrequenz und der Zwischenfrequenz betragsmäßig einem Viertel der Abtastfrequenz, kann eine Mischung durch eine Multiplikation mit den Werten 1, i, -1 und -i erfolgen bzw. durch eine Negation von Realteil- oder Imaginärteilwerten des Startsignals 2410 erfolgen sowie durch eine Vertauschung von Real- und Imaginärteilwerten von Startsignalwerten des Startsignals 2410. Ein solcher numerisch oder hardwaretechnisch einfach umzusetzender Ansatz ist beispielsweise in Marvin E. Frerking, Digital Signal Processing in Communication Systems, Kluwer Academic Publishes zu finden.

Hieran anschließend erfolgt eine Tiefpassfilterung des Zwischenfrequenzsignals 2414 mit der ersten Abtastfrequenz durch das Tiefpassfilter 2404, woraus ein tiefpassgefiltertes Zwischenfrequenzsignal 2402 resultiert, welchem wiederum die erste Abtastfrequenz zugrunde liegt. Durch den Unterabtaster 2406 erfolgt dann eine Unterabtastung des tiefpassgefilterten Zwischenfrequenzsignals 2402, woraus eine Reduktion der Abtastfrequenz erfolgt, ohne dabei das Signal nochmals spektral umzusetzen.

Ein derartiger Ansatz eines numerisch oder schaltungstechnisch einfach zu realisierenden Mischers 2402 weist den Nachteil auf, dass durch den vorbestimmten Zusammenhang zwischen der Aktuellfrequenz und der Abtastfrequenz lediglich Zwischenfrequenzen erreichbar sind, die in einem spektralen Abstand von einem Viertel der Abtastfrequenz um die Aktuellfrequenz angeordnet sind. Dies reduziert die Einsetzbarkeit eines derartigen numerisch oder schaltungstechnisch effizient realisierten Mischers 2402. Sollen auch Zwischenfrequenzen erreichbar sein, die einen anderen Abstand zur Aktuellfrequenz aufweisen als ein Viertel der Abtastfrequenz, ist eine Multiplikation der einzelnen Startsignalwerte des Startsignals 2410 mit dem rotierenden komplexen Zeiger $e^{j2\pi k f_C/f_S}$ notwendig, wobei k ein laufender Index der Startsignalwerte, $f_C$ die gewünschte Mittenfrequenz (d.h. die Zwischenfrequenz) und $f_S$ die Abtastfrequenz eines Signals kennzeichnen. Zu berücksichtigen ist aber, dass bei der Multiplikation der Startsignalwerte mit dem rotierenden komplexen Zeiger nicht nur rein reelle bzw. rein imaginäre Multiplikationsfaktoren zu verwenden sind, sondern die verwendeten Multiplikationsfaktoren Real- und Imaginärteile aufweisen. Hierdurch lässt sich eine numerisch und schaltungstechnisch effiziente Lösung, wie sie vorstehend skizziert wurde, nicht verwenden. Wünschenswert wäre aber ein Mischer, der die Möglichkeit bietet, auf numerisch und schaltungstechnisch effiziente Weise die Mischung von Startsignalwerten von einer Aktuellfrequenz auf eine beliebige Zwischenfrequenz durchführen zu können.

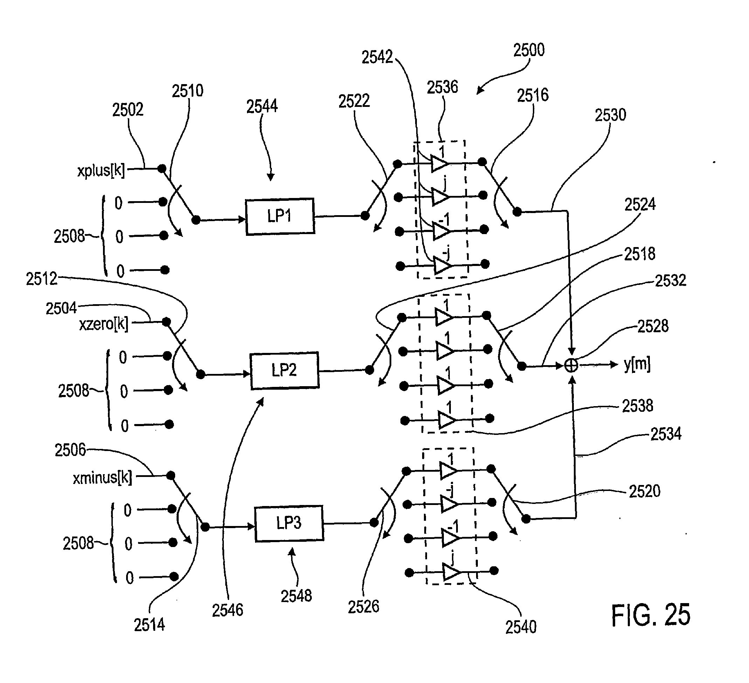

Weiterhin lässt sich auch ein zum Unterabtasten ähnliches Konzept zur spektralen Mischung mit Überabtastung realisieren. Ein auf diesem Konzept beruhender Frequenzumsetzer oder Signalkonvertierer ist beispielsweise in Fig. 25 durch den abgebildeten Signalkonvertierer 2500 dargestellt. Der in Fig. 25 dargestellte Signalkonvertierer 2500 weist ferner die Möglichkeit auf, verschiedene Startsignale überabzutasten und nachfolgend spektral umzusetzen. Hieran anschließend erfolgt ein Zusammenführen der überabgetasteten und spektral umgesetzten Startsignale auf ein gemeinsames Endsignal.

Um eine derartige Funktionalität bereitzustellen, weist der Signalkonvertierer 2500 einen ersten Eingang 2502 zum Empfangen eines ersten Startsignals xplus[k], einen zweiten Startsignaleingang 2504 zum Empfangen eines zweiten Startsignals xzero[k] sowie einen dritten Startsignaleingang 2506 zum Empfangen eines dritten Startsignals xminus [k] auf. Ferner weist der Signalkonvertierer 2500 eine Mehrzahl von Null-Eingängen 2508 zum Beaufschlagen des Signalkonvertierers mit dem Wert 0 auf. Zusätzlich weist der Signalkonvertierer 2500 einen ersten Multiplexer 2510, einen zweiten Multiplexer 2512, einen dritten Multiplexer 2514, einen vierten Multiplexer 2516, einen fünften Multiplexer 2518 sowie einen sechsten Multiplexer 2520 auf. Außerdem hat der Signalkonvertierer 2500 einen ersten Demultiplexer 2522, einen zweiten Demultiplexer 25524 sowie einen dritten Demultiplexer 2526. Ferner umfasst der Signalkonvertierer 2500 ein erstes Tiefpass-Filter LP1, ein zweites Tiefpass-Filter LP2 und ein drittes Tiefpass-Filter LP3. Schließlich umfasst der Signalkonvertierer 2500 einen Addierer 2528 zum Addieren eines Ausgangssignals des vierten Multiplexers 2516, eines Ausgangssignals des fünften Multiplexers 2518 und eines Ausgangssignals 2534 des sechsten Multiplexers 2520, um ein Endsignal y[m] bereitzustellen. Außerdem weist der Signalkonvertierer 2500 eine erste Verarbeitungseinrichtung 2536, eine zweite Verarbeitungseinrichtung 2538 sowie eine dritte Verarbeitungseinrichtung 2540 auf. Jede der Verarbeitungseinrichtungen 2536, 2538 sowie 2540 weist vier Teilverarbeitungseinrichtungen 2542 auf, die ausgebildet sind, um eine komplexe Multiplikation eines Eingangssignals mit einem komplexen Multiplikationsfaktor durchzuführen.

Der Signalkonvertierer 2500 ist derart verschaltet, dass durch den ersten Multiplexer einem Eingang des ersten Tiefpass-Filters LP1 eine Folge bestehend aus einem Abtastwert des ersten Startsignals xplus[k] und einer Folge von drei aufeinander folgenden Null-Werten zugeführt wird. Ein Ausgang des ersten Tiefpass-Filters LP1 ist mit dem ersten Demultiplexer 2522 verbunden. Der erste Demultiplexer 2522 ist ausgebildet, um das vom ersten Tiefpass-Filter LP1 empfangene tiefpass-gefilterte Signal in zeitlich aufeinander folgender Reihenfolge zuerst einer ersten Teilverarbeitungseinrichtung der ersten Verarbeitungseinrichtung 2536 zuzuweisen, dann einer zweiten Teilverarbeitungseinrichtung zuzuweisen, nachfolgend einer dritten Teilverarbeitungseinrichtung und schließlich einer vierten Teilverarbeitungseinrichtung zuzuweisen. Die erste Teilverarbeitungseinrichtung ist hierbei ausgebildet, um eine Multiplikation eines Signalwertes mit dem Faktor 1 durchzuführen, was insbesondere schaltungstechnisch dadurch realisierbar ist, dass ein Signal in der ersten Teilverarbeitungseinrichtung unverändert belassen wird. Die zweite Teilverarbeitungseinrichtung ist ausgebildet, um ein Signal mit dem komplexen Wert j zu multiplizieren, während die dritte Teilverarbeitungseinrichtung ausgebildet ist, um eine Negation eines Signals durchzuführen. Ferner ist die vierte Teilverarbeitungseinrichtung ausgebildet ist, um eine komplexe Multiplikation eines Signalwertes mit dem Faktor -j durchzuführen. Ferner ist der vierte Multiplexer 2516 mit der ersten Verarbeitungseinrichtung 2536 derart verbunden, dass in zeitlich aufeinander folgender Reihenfolge zunächst ein durch die erste Teilverarbeitungseinrichtung verarbeitetes Signal, dann ein durch die zweite Teilverarbeitungseinrichtung verarbeitetes Signal, dann ein durch die dritte Teilverarbeitungseinrichtung verarbeitetes Signal und schließlich ein durch die vierte Teilverarbeitungseinrichtung verarbeitetes Signal auf das Ausgangssignal 2530 des vierten Multiplexers 2516 gemultiplext wird. Analog zu der vorstehend beschriebenen Verschaltung des ersten Multiplexers 2510 mit dem ersten Tiefpass-Filter LP1, dem ersten Demultiplexer 2522, der ersten Verarbeitungseinrichtung 2536 und dem vierten Multiplexer 2516 im ersten Verarbeitungszweig kann auch der zweite Multiplexer 2512, das zweite Tiefpass-Filter LP2, der zweite Demultiplexer 2524, die zweite Verarbeitungseinrichtung 2538 und der fünfte Multiplexer 2518 miteinander verschaltet werden. Im Unterschied zu der Verschaltung im Verschaltung im ersten Verarbeitungszweig 2544 wird im zweiten Verarbeitungszweig 2546 jedoch das zweite Startsignal xzero[k] auf das zweite Tiefpass-Filter LP2 gemultiplext, während jede der Teilverarbeitungseinrichtungen der zweiten Verarbeitungseinrichtung 2538 ausgebildet sind, um eine Multiplikation mit dem Faktor 1 durchzuführen. Anders ausgedrückt, bedeutet dies, dass in den Teilverarbeitungseinrichtungen der zweiten Verarbeitungseinrichtung 2538 keine Veränderung des Signals durchgeführt werden braucht. Die zweite Verarbeitungseinrichtung 2538 kann somit auch als Redundant betrachtet werden und ist in Fig. 25 lediglich aus darstellungstechnischen Gründen wiedergegeben, um ein besseres Verständnis einer Signalverarbeitung im ersten Verarbeitungszweig 2544 und im dritten Verarbeitungszweig 2548 zu ermöglichen.

Analog zu der Verschaltung der Komponenten im ersten Verarbeitungszweig 2544 lässt sich auch eine Verschaltung der Komponenten im dritten Verarbeitungszweig 2548 beschreiben. Hierbei wird durch den dritten Multiplexer 2514 entweder ein Wert des dritten Startsignals xminus[k] oder einer von drei aufeinander folgenden Null-Werten dem dritten Tiefpass-Filter LP3 zugeführt. Hieran anschließend wird ein vom dritten Tiefpass-Filter LP3 ausgegebenes Signal durch den dritten Demultiplexer 2526 auf eine erste, zweite, dritte oder vierte Teilverarbeitungseinrichtung der dritten Verarbeitungseinrichtung 2540 gelegt. Hierbei ist die erste Teilverarbeitungseinrichtung ausgebildet, um eine Multiplikation mit dem Wert 1 durchzuführen, die zweite Teilverarbeitungseinrichtung ausgebildet, um eine Multiplikation mit dem Wert -j auszuführen, die dritte Teilverarbeitungseinrichtung ausgebildet, um eine Negation eines Signalswertes durchzuführen und die vierte Teilverarbeitungseinrichtung ausgebildet, um einen Signalwert mit dem Wert j zu multiplizieren. Ferner wird ein Ausgangswert der ersten, zweiten, dritten oder vierten Teilverarbeitungseinrichtung durch den sechsten Multiplexer 2520 sequentiell auf den Ausgang 2536 des sechsten Multiplexers 2520 gemultiplext.

Die Funktionsweise eines derartigen Signalkonvertierers 2500 lässt sich nun wie folgt beschreiben. Zunächst wird das erste Startsignal xplus[k] am ersten Eingang 2502 angelegt und durch den ersten Multiplexer 2510 derart gemultiplext, dass eine Folge bestehend aus einem Wert des ersten Startsignals xplus[k] und drei nachfolgenden Null-Werten (d.h. dem Wert 0) dem ersten Tiefpass-Filter LP1 im ersten Verarbeitungszweig 2544 zugeführt wird. Hierbei weist der erste Multiplexer 2510 meist eine Takt- oder Multiplexrate auf, die dem Vierfachen einer Abtastrate des ersten Startsignals entspricht. Dadurch werden zwischen jedem Abtastwert des ersten Startsignals drei Nullen eingeführt, was zu einem "Überabtasten" (Hochtasten) bzw. Upsampling des Signals führt. Im ersten Tiefpass-Filter LP1 des ersten Verarbeitungszweiges 2544 erfolgt nun beispielsweise auf der Basis einer FIR-Filtervorschrift eine Tiefpass-Filterung des hochgetasteten Signals, um durch das Überabtasten entstandene Spiegelfrequenzen zu unterdrücken. Das nunmehr tiefpassgefilterte überabgetastete Signal wird nachfolgend an den ersten Demultiplexer 2522 geführt, der mit der hohen, d.h. der vierfachen Abtastfrequenz im Vergleich zu der Abtastfrequenz des Startsignals das tiefpassgefilterte Signal den Teilverarbeitungseinrichtungen 2542 der ersten Verarbeitungseinrichtung 2536 zuführt. In den einzelnen Teilverarbeitungseinrichtungen 2542 der ersten Verarbeitungseinrichtung 2536 erfolgt nunmehr die Multiplikation eines der Teileinrichtung zugeführten Signals mit einem Multiplikationsfaktor. Die Multiplikationsfaktoren in den einzelnen Teilverarbeitungseinrichtungen sind dabei derart gewählt, dass sich unter Berücksichtigung der Aufspaltung des Tiefpassgefilterten Signals durch den ersten Demultiplexer 2522 und dem den Teilverarbeitungseinrichtungen 2524 nachgeschalteten vierten Multiplexer 2516 ein Signal am Ausgang 2530 des vierten Demultiplexers 2516 ergibt, das einem aufwärts gemischten Tiefpass-gefilterten Signal entspricht. Der spektrale Abstand zwischen dem Tiefpass-gefilterten Signal und dem aufwärts gemischten Tiefpass-gefilterten Signal am Ausgang 2530 des vierten Multiplexers 2516 beträgt hierbei ein Viertel der hohen Abtastfrequenz, d.h. der vierfachen Abtastfrequenz des ersten Startsignals xplus[k].

Ein analoges Verarbeiten des zweiten Startsignals xzero[k] erfolgt ferner im zweiten Verarbeitungspfad 2546, wobei wiederum durch den zweiten Multiplexer 2512 ein Einfügen von Null-Werten und damit ein Hochtasten des zweiten Startsignals xzero[k] erfolgt. Dieses hochgetastete Signal wird nunmehr dem zweiten Tiefpass-Filter LP2 zum Entfernen der durch die Hochtastung entstandene Spiegelfrequenzen zugeführt. Nachfolgend wird wiederum durch den zweiten Demultiplexer 2524 die Aufteilung des Tiefpass-gefilterten Signals auf die Teilverarbeitungseinrichtungen durchgeführt, wobei eine Gewichtung eines Signalwerts mit dem Wert 1 erfolgt. Wie vorstehend bereits ausgeführt wurde, entspricht eine derartige Operation in Verbindung mit der Funktion des zweiten Demultiplexers 2524 und der Funktion des fünften Multiplexers 2518 einem direkten "Durchschleifen" des Tiefpass-gefilterten Signals auf den Ausgang 2532 des fünften Multiplexers 2518.

Analog zu der Funktionsweise der Signalverarbeitung in dem ersten Verarbeitungspfad 2544 und dem zweiten Verarbeitungspfad 2546 erfolgt nun eine Verarbeitung des dritten Startsignals xminus[k] im dritten Verarbeitungszweig 2548. Hierbei wird wiederum durch den dritten Multiplexer 2514 das dritte Startsignal hochgetastet, wobei zwischen jedem Abtastwert des dritten Startsignals drei Null-Werte eingefügt werden. Das derart hochgetastete dritte Startsignal wird nun im dritten Tiefpass-Filter LP3 tiefpassgefiltert, um die durch die Hochtastung entstandenen Spiegelfrequenzen zu unterdrücken. Analog zu der Funktionsweise des ersten Demultiplexers 2522, der ersten Verarbeitungseinrichtung 2536 und dem vierten Multiplexer 2516 im ersten Verarbeitungszweig 2544 erfolgt durch den dritten Demultiplexer 2526, die dritte Verarbeitungseinrichtung 2540 und den sechsten Multiplexer 2520 eine spektrale Umsetzung des durch das dritte Tiefpass-Filter LP3 tiefpassgefilterte Signal. Dadurch, dass nun in den einzelnen Teilverarbeitungseinrichtungen der dritten Verarbeitungseinrichtung 2540 die Multiplikationsfaktoren 1, -j, -1 und j in der angegebenen Reihenfolge verwendet werden, entspricht das am Ausgang 2534 des sechsten Multiplexers 2520 anliegende Signal einem um ein Viertel der (hohen) Abtastfrequenz herunter gemischten Signal, wie es am Ausgang des dritten Tiefpass-Filters LP3 anliegt. Durch die nachgeschaltete Addiereinrichtung 2528 werden nun das am Ausgang 2530 des vierten Multiplexers 2516 anliegende (aufwärts gemischte) Signal, das am Ausgang 2532 des fünften Multiplexers 2518 anliegende Signal und das am Ausgang 2534 des sechsten Multiplexers 2520 anliegende (abwärts gemischte) Signal addiert. Hieraus resultiert somit ein Endsignal y[m], das die Möglichkeit gleichzeitig auf einem ersten (hohen), einem zweiten (mittleren) und einem dritten (niedrigen) Frequenzband Informationen auszusenden. Dabei ist im ersten Frequenzband eine Information des ersten Startsignals xplus[k], im zweiten Frequenzband eine Information des zweiten Startsignals xzero[k] und im dritten Frequenzband eine Information des dritten Startsignals xminus[k] enthalten.

Ein derartiger Signalkonvertierer 2500 weist zwar den Vorteil auf, dass hierdurch auf eine relativ günstige Art und Weise durch die Verwendung der ersten Verarbeitungseinrichtung 2536 der zweiten Verarbeitungseinrichtung 2538 und der dritten Verarbeitungseinrichtung 2540 eine effiziente spektrale Umsetzung durchführbar ist. Nachteilig am Signalkonvertierer 2500 ist jedoch, dass für eine Realisierung, wie sie in Fig. 25 dargestellt ist, eine Anzahl von neun Multiplexern und Demultiplexern notwendig ist. Hierdurch erfordert eine Schaltungsstruktur, wie sie in Fig. 25 dargestellt ist, einen hohen Verdrahtungsaufwand und zugleich einen hohen Platzverbrauch auf einem integrierten Schaltkreis, wodurch sich die Herstellungskosten eines derartigen Signalkonvertierers erhöhen.

SAMUELI H ET AL: "A VLSI Architecture for a High-Speed All-Digital Quadrature Modulator and Demodulator for Digital Radio Applications" IEEE JOURNAL ON SELECTED AREAS IN COMMUNICATIONS offenbart einen Modulator der I Werte mit einem Kosinus-signal multipliziert und Q Werte mit einem Sinus-signal multipliziert.

Es ist somit die Aufgabe der vorliegenden Erfindung, einen Signalkonvertierer und ein Verfahren zum Konvertieren eines Signals zu schaffen, wobei für den Signalkonvertierer oder das Verfahren zum Konvertieren des Signals ein geringerer Aufwand gegenüber dem Stand der Technik notwendig ist.

Diese Aufgabe wird durch einen Signalkonvertierer gemäß Anspruch 1 sowie ein Verfahren zum Konvertieren eines Signals gemäß Anspruch 17 gelöst.

Die vorliegende Erfindung schafft einen Signalkonvertierer zum Konvertieren eines Startsignals in ein Endsignal mit folgenden Merkmalen:

eine Einrichtung zum Kopieren des Startsignals, um eine Mehrzahl von kopierten Startsignalen zu erhalten, wobei ein kopiertes Startsignal als Zweigsignal in einen Verarbeitungszweig einspeisbar ist;

eine erste Zweigverarbeitungseinrichtung in einem ersten Verarbeitungszweig zum Verarbeiten eines ersten Zweigsignals gemäß einer ersten Verarbeitungsvorschrift, um ein erstes verarbeitetes Zweigsignal zu erhalten;

einer zweiten Zweigverarbeitungseinrichtung in einem zweiten Verarbeitungszweig zum Verarbeiten eines zweiten Zweigsignals gemäß einer zweiten Verarbeitungsvorschrift, um ein zweites verarbeitetes Zweigsignal zu erhalten, wobei sich die zweite Verarbeitungsvorschrift von der ersten Verarbeitungsvorschrift unterscheidet und wobei die erste Verarbeitungsvorschrift und die zweite Verarbeitungsvorschrift ausgebildet sind, um eine Tiefpass-Polyphasenfilterung der kopierten Startsignale zu bewirken; und

eine Auswahleinrichtung zum sequentiellen Auswählen des ersten verarbeiteten Zweigsignals und dann des zweiten verarbeiteten Zweigsignals, um das Endsignal zu erhalten.

Ferner schafft die vorliegende Erfindung ein Verfahren zum Konvertieren eines Startsignals in ein Endsignal mit folgenden Schritten:

Kopieren des Startsignals, um eine Mehrzahl von kopierten Startsignalen zu erhalten, wobei ein kopiertes Startsignal als Zweigsignal in einen Verarbeitungszweig einspeisbar ist;

Verarbeiten eines ersten Zweigsignals in einer erster Zweigverarbeitungseinrichtung in einem ersten Verarbeitungszweig gemäß einer ersten Verarbeitungsvorschrift, um ein erstes verarbeitetes Zweigsignal zu erhalten;

Verarbeiten eines zweiten Zweigsignals in einer zweiten Zweigverarbeitungseinrichtung in einem zweiten Verarbeitungszweig gemäß einer zweiten Verarbeitungsvorschrift, um ein zweites verarbeitetes Zweigsignal zu erhalten, wobei sich die zweite Verarbeitungsvorschrift von der ersten Verarbeitungsvorschrift unterscheidet und wobei die erste Verarbeitungsvorschrift und die zweite Verarbeitungsvorschrift ausgebildet sind, um eine Tiefpass-Polyphasenfilterung der kopierten Startsignale zu bewirken; und

Sequentielles Auswählen des ersten verarbeiteten Zweigsignals und dann des zweiten verarbeiteten Zweigsignals, um das Endsignal zu erhalten.

Der vorliegenden Erfindung liegt die Erkenntnis zugrunde, dass sich ein gegenüber dem Stand der Technik unaufwendigerer Signalkonvertierer und ein gegenüber dem Stand der Technik unaufwendigeres Verfahren zum Konvertieren eines Signals dadurch bereitstellen lässt, dass zunächst mit einer Einrichtung zum Kopieren das Startsignal vervielfältigt wird, woraus eine Mehrzahl von kopierten Startsignalen resultiert. Ein erstes der kopierten Startsignale wird dann in einem ersten Verarbeitungszweig gemäß einer ersten Verarbeitungsvorschrift verarbeitet, um ein erstes verarbeitetes Zweigsignal zu erhalten. Ferner wird ein zweites kopiertes Startsignal in einer zweiten Verarbeitungseinrichtung in einem zweiten Verarbeitungszweig gemäß einer zweiten Verarbeitungsvorschrift verarbeitet. Sind nun die erste Verarbeitungsvorschrift und die zweite Verarbeitungsvorschrift derart ausgestaltet, dass durch beide Verarbeitungsvorschriften eine Tiefpass-Filterung realisierbar ist, entspricht dies der vorstehend erläuterten Tiefpass-Filterung zum Entfernen von Spiegelfrequenzen, die bei einer Überabtastung des Startsignals auftreten. Sind weiterhin die erste Verarbeitungsvorschrift und die zweite Verarbeitungsvorschrift so miteinander gekoppelt, das durch die erste und die zweite Verarbeitungsvorschrift eine Polyphasen-Filterung ausführbar ist, lässt sich hierdurch das Tiefpass-Filter unaufwendiger bereitstellen, als dies im Stand der Technik möglich ist. Hierzu kann beispielsweise die erste Verarbeitungsvorschrift ausgebildet sein, um eine Filterung der ersten Polyphase durchzuführen und die zweite Verarbeitungsvorschrift ausgebildet sein, um eine Filterung der zweiten Polyphase durchzuführen, wobei die Filterung der beiden Polyphasen mit einer niedrigeren Taktfrequenz als im Stand der Technik möglich ist. Ferner kann die erste Verarbeitungseinrichtung oder die zweite Verarbeitungseinrichtung ausgebildet sein, um zusätzliche Verarbeitungsoperationen durchzuführen, wobei die zusätzliche Verarbeitungsoperation eine Negation, eine komplexe Linksdrehoperation oder eine komplexe Rechtsdrehoperation umfasst. Hierdurch ist es möglich, durch den Signalkonvertierer neben der Überabtastung eine spektrale Umsetzung des (überabgetasteten) Startsignals in das Endsignal vorzunehmen. Ein Zusammenfügen des aus der ersten Verarbeitungseinrichtung resultierenden ersten verarbeiteten Zweigsignals mit dem aus der zweiten Verarbeitungseinrichtung resultierenden zweiten verarbeiteten Zweigsignals kann dann in der Auswahleinrichtung zum sequentiellen Auswählen erfolgen, an deren Ausgang erst das Signal mit der (hohen) Abtastfrequenz vorliegt. Hierzu ist die Auswahleinrichtung mit einem derartigen Takt anzusteuern, der dem resultierenden Abtasttakt des Endsignals entspricht.

Die vorliegende Erfindung bietet somit den Vorteil, dass durch das Kopieren des Startsignals und dem Verwenden von mehreren kopierten Startsignalen in (vorzugsweise parallel angeordneten) Verarbeitungszweigen des Signalkonvertierers eine unaufwendigere Realisierung des Signalkonvertierers gegenüber einem herkömmlichen Signalkonvertierer möglich ist. Insbesondere durch das Kopieren und das Verwenden der kopierten Signale in einer Polyphasen-Filterung lässt sich somit ein Einfügen von Nullen in den Signalstrom des Startsignals vermeiden, um ein überabgetastetes Startsignal zu erhalten. In diesem Fall können daher die im Stand der Technik notwendigen Multiplexer zum Einfügen der "Nullen" entfallen, wodurch bereits ein erster Beitrag zur Realisierung eines unaufwendigeren Signalkonvertierers geleistet wird. Ferner kann durch die Aufspaltung eines Tiefpass-Filters auf mehrere Polyphasen-Filter erreicht werden, dass eine Filterung bei einer niedrigeren Frequenz als im Stand der Technik realisierbar ist, was einen zweiten Beitrag zur Realisierung eines unaufwendigeren Signalkonvertierers bietet. Dies resultiert insbesondere aus der parallelen Verarbeitungsweise in einer Polyphasen-Filterstruktur.

Ferner kann in jedem Verarbeitungszweig zusätzlich zu einer Tiefpass-Filterungsoperation eine weitere Verarbeitungsoperation durchgeführt werden, die eine spektrale Umsetzung des Startsignals bewirken kann. Analog zu der Multiplikation mit den Multiplikationsfaktoren von beispielsweise 1, j, -1 und -j kann somit bei einem Vorhandensein von vier Verarbeitungszweigen in jedem Verarbeitungszweig eine Multiplikation mit einem anderen Multiplikationsfaktor stattfinden, wodurch letztendlich die Frequenzverschiebung um ein Viertel der Abtastfrequenz in eine positive Richtung realisiert werden kann. Alternativ kann auch bei einer entsprechenden Wahl der Multiplikationsfaktoren eine negative Frequenzverschiebung realisiert werden. Dadurch, dass bei der Verwendung von vier Verarbeitungszweigen auch bereits vier Polyphasen-Teilfilter durch die vier Verarbeitungseinrichtungen realisiert sind, kann somit weiter eine Reduktion des numerischen Aufwandes erfolgen, indem beispielsweise kein Demultiplexer notwendig ist, um das Tiefpass-gefilterte Signal auf mehrere Teilverarbeitungseinrichtungen aufzuspalten. Vielmehr kann direkt ein Zweigsignal in einem Verarbeitungszweig verwendet werden. Dabei kann zugleich jedes der Zweigsignale mit einem anderen Multiplikationsfaktor gewichtet werden, woraus sich schließlich die Frequenzverschiebung (in positive oder negative Richtung) ergibt. Vorzugsweise kann eine derartige Verarbeitungsoperation auch dadurch realisiert sein, dass nicht eine (komplexe) Multiplikation mit komplexen Multiplikationsfaktoren durchgeführt werden braucht. Liegen nämlich die mit den vorstehend genannten Multiplikationsfaktoren zu multiplizierenden komplexen Signale bereits in der Form eines Real- und Imaginärteils vor, kann beispielsweise eine Multiplikation mit -1 allein durch eine Negation des zumeist binär dargestellten Signalwertes (d.h. eine Umkehrung des Vorzeichens) durchgeführt werden. Alternativ kann bei einer Multiplikation mit dem komplexen Wert j eine komplexe Linksdrehoperation ausgeführt werden, bei der im wesentlichen eine Real-Imaginärteilvertauschung mit einer Negation des Imaginärteils durchzuführen ist. Dies lässt sich numerisch oder schaltungstechnisch durch eine einfache "Umverdrahtung" oder Umordnung der einzelnen Real- oder Imaginärteilwerte eines vorliegenden Signals in einem Speicher realisieren. Analog hierzu kann auch bei einer Multiplikation mit dem komplexen Faktor -j eine komplexe Rechtsdrehoperation ausgeführt werden, wobei eine derartige Operation wiederum durch eine Real-Imaginärteilvertauschung mit einer Negation des Realteils durchführbar ist.

Ferner kann zu einem oben beschriebenen (ersten) Signalkonvertierer noch ein weiterer entsprechend verschalteter Signalkonvertierer parallel geschaltet werden. Hierbei sind dann ein Ausgangssignal des ersten Signalkonvertierers mit einem Ausgangssignal des zweiten Konvertierers zu summieren, um ein Gesamtausgangssignal zu erhalten. Bei einer derartigen Anordnung kann beispielsweise eine Tiefpass-Filtercharakteristik des ersten Signalkonvertierers einer Tiefpass-Filtercharakteristik des zweiten Konvertierers entsprechen. Ferner kann ein Satz von Multiplikationsfaktoren, der eine erste (komplexe) Drehoperation im ersten Signalkonvertierer bewirkt, von einem Satz von Multiplikationsfaktoren verschieden sein, der eine zweite (komplexe) Drehoperation im zweiten Signalkonvertierer bewirkt. Ein derartiger Signalkonvertierer mit den beiden einzelnen, parallel geschalteten Signalkonvertierern weist den Vorteil auf, dass durch eine technisch unaufwendig realisierbare Schaltungsstruktur bereits ein Signalkonvertierer bereitgestellt werden kann, der einen Frequenzmultiplexer eines ersten Startsignals auf das erste Endsignal und eines zweiten Startsignals auf das zweite Endsignal konvertiert, wobei beispielsweise eine Startfrequenz des ersten Startsignals einer Startfrequenz des zweiten Startsignals entspricht und eine Endfrequenz des ersten Endsignals nicht einer zweiten Endfrequenz des zweiten Startsignals entspricht.

Ferner kann auch ein dritter Signalkonvertierer, wie er oben beschrieben wurde, zu dem ersten und zweiten Signalkonvertierer parallel geschaltet werden, wodurch sich ein zusätzlicher Freiheitsgrad bei dem Entwurf und der Verwendung eines derartigen Signalkonvertierers ergibt.

Gemäß einem weiteren Ausführungsbeispiel der vorliegenden Erfindung kann der Signalkonvertierer eine weitere Einrichtung zum Kopieren eines zweiten Startsignals umfassen, um eine Mehrzahl von kopierten zweiten Startsignalen zu enthalten. Zusätzlich kann der Signalkonvertierer einen Zweigaddierer in jedem Verarbeitungszweig umfassen, wobei der Zweigaddierer ausgebildet ist, um eines der Mehrzahl von kopierten zweiten Startsignalen oder ein von der Mehrzahl von kopierten zweiten Startsignalen abgeleitetes Signal mit dem kopierten Startsignal in dem Zweig oder einem von dem kopierten Startsignal abgeleiteten Signal zu kopieren, um ein Additionssignal zu erhalten, und wobei der Zweigaddierer ferner so angeordnet ist, um das Additionssignal gemäß der Verarbeitungsvorschrift für den Zweig zu verarbeiten. Ein derart ausgestalteter Signalkonvertierer bietet den Vorteil einer weiteren Reduktion des für die Realisierung des Signalkonvertierers notwendigen technischen Aufwandes, da für das Verarbeiten und Zusammenführen des ersten Startsignals mit dem zweiten Startsignal nicht zwei parallel aufgebaute Signalkonvertierer (mit zwei parallelen Verarbeitungszweigstrukturen) notwendig sind, sondern dass bereits durch die Zweigaddierer ein Zusammenführen von Signalen, die auf dem ersten oder zweiten Startsignal basieren, möglich ist. Die nachfolgende Verarbeitung des zusammengeführten Signals erfolgt dann nur noch in einer einzigen Verarbeitungszweigstruktur mit parallel angeordneten Zweigverarbeitungseinrichtungen, was gegenüber der zuvor dargestellten parallelen Anordnung von zwei separaten Signalkonvertierern eine weitere Reduktion des technischen Aufwandes zulässt. Ferner kann ein Zweigaddierer ausgebildet sein, um zu bewirken, dass das von dem kopierten zweite Startsignal abgeleitete Signal einem in der komplexen Zahlenebene rechts- oder linksgedrehten kopierten zweiten Startsignal entspricht. Dieses bietet den Vorteil, dass zusätzlich zu dem Zusammenführen des ersten Startsignals mit dem zweiten Startsignal eine individuelle Gewichtung des zweiten Startsignals möglich ist, wodurch sich eine zusätzliche Flexibilität eines derartigen Signalkonvertierers ergibt.

Ferner kann ein derartiger Signalkonvertierer mit Zweigaddierern eine Einrichtung zum Kopieren eines dritten Startsignals umfassen, um eine Mehrzahl von kopierten dritten Startsignalen zu erhalten. Hierbei kann der Zweigaddierer in jedem Verarbeitungszweig ausgebildet sein, um eines der Mehrzahl von kopierten dritten Startsignalen oder ein von der Mehrzahl von kopierten dritten Startsignalen abgeleitetes Signal mit dem kopierten Startsignal, dem von dem kopierten Startsignal abgeleiteten Signal, dem kopierten zweiten Startsignal, dem von dem kopierten zweiten Startsignal abgeleiteten Signal oder dem Additionssignal zu addieren, um ein weiteres Additionssignal bereitzustellen, wobei der Zweigaddierer so angeordnet ist, um das weitere Additionssignal gemäß der Verarbeitungsvorschrift für den Verarbeitungszweig zu verarbeiten. Ein derart ausgebildeter Signalkonvertierer weist durch die Verwendungsmöglichkeit eines dritten Startsignals einen zusätzlichen Freiheitsgrad und somit eine erhöhte Flexibilität für den Einsatzbereich des Signalkonvertierers auf.

Ferner lassen sich auch zwei Signalkonvertierer, wie sie vorstehend beschrieben wurden, miteinander kaskadiert anordnen, wodurch sich eine Erhöhung der durch die kaskadierte Anordnung der Signalkonvertierer verwendbaren Frequenzen oder Frequenzbänder ergibt.

Bevorzugte Ausführungsbeispiele der vorliegenden Erfindung werden nachfolgend Bezug nehmend auf die beiliegenden Zeichnungen näher erläutert. Es zeigen:

Fig. 1A    ein Blockschaltbild eines ersten Ausführungsbeispiels des erfindungsgemäßen Signalkonvertierers;

Fig. 1B    ein Blockschaltbild eines zweiten Ausführungsbeispiels des erfindungsgemäßen Signalkonvertierers;

Fig. 2    eine Darstellung der erreichbaren Zielfrequenzen bei einer Kaskadierung von mehreren Signalkonvertierern;

Fig. 3    eine tabellarische Darstellung von Werten der Cosinus- und Sinusfunktion, wie sie bei einer positiven oder negativen Frequenzverschiebung gemäß dem erfindungsgemäßen Ansatz auftreten;

Fig. 4    eine tabellarische Darstellung der Real- und Imaginärteilwerte bei einer Multiplikation der Signaleingangswerte gemäß dem in Fig. 5 dargestellten Ansatz;

Fig. 5    ein Blockschaltbild des Ansatzes der Multiplikation eines Signalwerts mit einem Satz von Multiplikationsfaktoren;

Fig. 6    ein Blockschaltbild eines Überabtasters (Upsamplers), dem der im Zusammenhang mit erfindungsgemäßen Ansatz verwendet werden kann;

Fig. 7    ein Blockschaltbild, das eine detailliertere Darstellung des in Fig. 6 gezeigten Blocks wiedergibt;

Fig. 8    ein Blockschaltbild, das eine detailliertere Darstellung eines in Fig. 7 dargestellten Blocks wiedergibt;

Fig. 9    eine tabellarische Darstellung von Filterkoeffizienten gemäß einem Ausführungsbeispiel des in Fig. 8 dargestellten Blocks;

Fig. 10    ein Blockschaltbild, das eine detailliertere Darstellung eines Blocks aus Fig. 7 wiedergibt;

Fig. 11A    ein Blockschaltbild, das ein Ausführungsbeispiel eines Mischers bei Verwendung des Mischers als Abwärtsmischer wiedergibt;

Fig. 11B    ein Blockschaltbild einer möglichen Verwendung der Ausgänge des in Fig. 11A gezeigten Mischers unter Verwendung von mehreren Korrelatoren;

Fig. 11C    ein Diagramm einer möglichen Belegung von Frequenzen bei der Verwendung der in Fig. 11B dargestellten Korrelatoren;

Fig. 11D    ein weiteres Diagramm einer möglichen Belegung von Frequenzen bei der Verwendung der in Fig. 11B dargestellten Korrelatoren;

Fig. 12    eine tabellarische Darstellung der Wortbreite, Datenrate und des Datentyps der in Fig. 11A dargestellten Signale;

Fig. 13    eine tabellarische Darstellung der Umrechnung eines in Fig. 11A dargestellten Eingangssignals eines Blockes in ein Ausgangssignal eines Blockes unter Verwendung eines spezifischen Parameters;

Fig. 14    ein Blockschaltbild, das eine detailliertere Struktur eines in Fig. 11A dargestellten Blockes wiedergibt;

Fig. 15    eine tabellarische Darstellung von Wortbreiten, Datenraten und Datentypen von in Fig. 14 dargestellten Signalen;

Fig. 16    eine tabellarische Darstellung der Zuordnung von Signalwerten zu Filterkoeffizienten im Zeitablauf;

Fig. 17    eine tabellarische Darstellung der Zuordnung von Signalwerten zu verschiedenen Polyphasen eines Polyphasenfilters;

Fig. 18        ein Blockschaltbild eines weiteren Ausführungsbeispiels der vorliegenden Erfindung;

Fig. 19        eine tabellarische Darstellung der Zuordnung von Real- bzw. Imaginärteilen von Signalwerten zu verschiedenen Polyphasen eines Polyphasenfilters;

Fig. 20        eine tabellarische Darstellung einer Zuordnung von Real- und Imaginärteilwerten von Signalwerten zu Polyphasen eines Polyphasenfilters;

Fig. 21        eine tabellarische Darstellung der Zuordnung von Real- und Imaginärteilwerten von Signalwerten zu einzelnen Polyphasen eines Polyphasenfilters;

Fig. 22        eine tabellarische Darstellung von Real- und Imaginärteilwerten zu einzelnen Polyphasenfiltern und dem aus den Polyphasenfiltern resultierenden Ergebnis;

Fig. 23        eine tabellarische Darstellung einer Berechnungsvorschrift für Real- und Imaginärteilwerte eines Ausgangssignals des Polyphasenfilters unter Berücksichtigung einer Frequenzverschiebung in positiver oder negativer Richtung oder unter Vermeidung einer Frequenzverschiebung;

Fig. 24A und 24B        ein Blockschaltbild von herkömmlichen Signalkonvertierern für eine Abwärts- und Aufwärtsmischung; und

Fig. 25        ein Blockschaltbild eines herkömmlichen Signalkonvertierers.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei auf eine wiederholte Beschreibung dieser Elemente verzichtet wird.

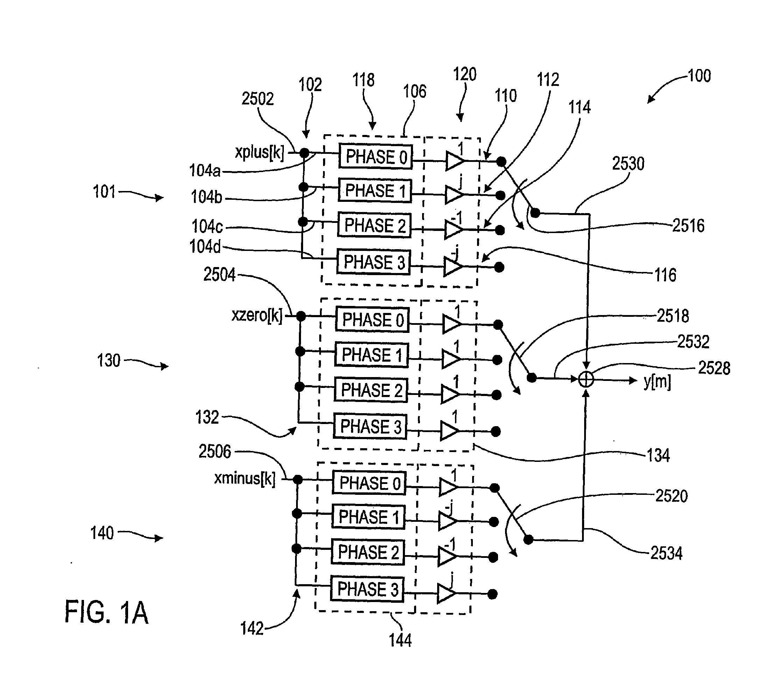

Fig. 1A zeigt ein erstes Ausführungsbeispiel des erfindungsgemäßen Signalkonvertierers 100. Hierbei weist der Signalkonvertierer 100 wiederum einen ersten Starteingang 2502 zum Anlegen eines ersten Startsignals xplus[k], einen zweiten Starteingang 2504 zum Anlegen eines zweiten Startsignals xzero[k] sowie einen dritten Starteingang 2506 zum Anlegen eines dritten Startsignals xminus[k] auf. Ferner weist der Signalkonvertierer einen ersten Teilkonvertierer 101 mit einer Einrichtung 102 zum Kopieren des ersten Startsignals xplus[k] auf, um eine Mehrzahl von kopierten (ersten) Startsignalen 104a bis 104d zu erhalten. Außerdem weist der Signalkopierer einen ersten Satz von Zweigverarbeitungseinrichtungen 106 auf, der vier Eingänge und vier Ausgänge umfasst. Die vier Ausgänge der Gruppe von Zweigverarbeitungseinrichtungen 106 können über einen Multiplexer 2516 auf einen Ausgang 2530 des Multiplexers 2516 gemultiplext werden. Die Gruppe der Zweigverarbeitungseinrichtungen 106 umfasst hierbei eine erste Zweigverarbeitungseinrichtung in einem ersten Verarbeitungszweig 110, eine zweite Zweigverarbeitungseinrichtung im zweiten Verarbeitungszweig 112, eine dritte Zweigverarbeitungseinrichtung in einem dritten Verarbeitungszweig 114 sowie eine vierte Zweigverarbeitungseinrichtung in einem vierten Verarbeitungszweig 116. Jede dieser Zweigverarbeitungseinrichtungen umfasst eine Einrichtung 118 zum Filtern, insbesondere zum Tiefpass-Filtern, sowie eine Einrichtung 120 zum Gewichten. Die Einrichtungen 118 zum Filtern können derart ausgelegt sein, dass durch einzelne oder alle Einrichtungen 118 zum Filtern der ersten Gruppe von Zweigverarbeitungseinrichtungen 106 eine Tiefpasscharakteristik ausgebildet ist. Dies bedeutet mit anderen Worten, dass durch die Einrichtungen 118 zum Filtern beispielsweise ein Polyphasen-Filter realisiert ist, wobei die Einrichtung zum Filtern im ersten Verarbeitungszweig 110 ein Polyphasen-Teilfilter mit der Phase 0, die Einrichtung zum Filtern im zweiten Verarbeitungszweig 112 ein Polyphasen-Teilfilter mit der Phase 1, die Einrichtung zum Filtern im dritten Verarbeitungszweig 114 ein Polyphasen-Teilfilter mit der Phase 2 und die Einrichtung zum Filtern im vierten Verarbeitungszweig 116 ein Polyphasen-Teilfilter mit der Phase 3 umfasst. Ferner kann die Einrichtung 120 zum Multiplizieren ausgebildet sein, um ein Signal im ersten Verarbeitungszweig mit dem Multiplikationsfaktor 1 zu multiplizieren (oder wie vorstehend dargelegt wurde auch einfach "durchzuschleifen"). Die Einrichtung zum Multiplizieren im zweiten Verarbeitungszweig 112 ist ausgebildet, um ein Ergebnis einer komplexen Multiplikation mit dem (rein imaginären) Multiplikationsfaktor j zu ermitteln, wogegen die Einrichtung zum Multiplizieren im dritten Verarbeitungszweig 114 ausgebildet ist, um eine Negation durchzuführen. Weiterhin ist die Einrichtung zum Multiplizieren im vierten Verarbeitungszweig 116 ausgebildet, um ein Ergebnis einer Multiplikation mit dem (rein imaginären) Multiplikationsfaktor -j durchzuführen ist.

Analog hierzu ist ein zweiter Teilsignakonvertierer 130 zum Konvertieren des zweiten Startsignals xzero[k] aufgebaut. Insbesondere umfasst der zweite Teilsignalkonvertierer 130 wieder eine Einrichtung 132 zum Kopieren des zweiten Startsignals xzero[k], um eine Mehrzahl von kopierten zweiten Startsignalen zu erhalten. Weiterhin umfasst der zweite Teilsignalkonvertierer eine Gruppe 134 von Zweigverarbeitungseinrichtungen. Jede der Zweigverarbeitungseinrichtungen der zweiten Gruppe von Zweigverarbeitungseinrichtungen 134 umfasst wiederum eine Einrichtung zum Filtern 118 und eine Einrichtung zum Multiplizieren 120. Hierbei kann wiederum die Einrichtung zum Filtern 118 in einer Polyphasen-Struktur mit den Polyphasen-Teilfiltern Phase 0, Phase 1, Phase 2 und Phase 3 ausgebildet sein. Die einzelnen Polyphasen-Teilfilter der zweiten Gruppe von Verarbeitungseinrichtungen können den entsprechenden (d.h. gleichbenannten) Polyphasen-Teilfiltern der ersten Gruppe von Verarbeitungseinrichtungen entsprechen. Insbesondere kann eine Filtercharakteristik (beispielsweise eine Tiefpass-Filtercharakteristik), die durch die Einrichtungen 118 zum Filtern der ersten Gruppe von Zweigverarbeitungseinrichtungen 106 bereitgestellt wird, einer Filtercharakteristik der durch die Einrichtungen 118 zum Filtern der zweiten Gruppe 134 von Zweigverarbeitungseinrichtungen des zweiten Signalkonvertierers 130 entsprechen. Insbesondere sind dann Filterkoeffizienten (eines beispielsweise als FIR-Filters) ausgebildeten Polyphasen-Filters Phase 0 der zweiten Gruppe von Zweigverarbeitungseinrichtungen 134 mit Filterkoeffizienten des (beispielsweise ebenfalls als FIR-Filter ausgebildeten) Polyphasen-Teilfilters Phase 0 der ersten Gruppen von Zweigverarbeitungeneinrichtungen 106 identisch. Analoges gilt dann auch für Filterkoeffizienten des zweiten Polyphasen-Teilfilters Phase 1, des dritten Polyphasen-Teilfilters Phase 2 und des vierten Polyphasen-Teilfilters Phase 3 in den jeweiligen Gruppen von Zweigverarbeitungseinrichtungen. Ferner kann die zweite Gruppe von Zweigverarbeitungseinrichtungen 134 Einrichtungen 120 zum Gewichten umfassen, wobei in dem in Fig. 1A dargestellten Beispiel die Einrichtungen 120 zum Gewichten in der zweiten Gruppe von Zweigverarbeitungseinrichtungen ausgebildet sind, um eine Multiplikation eines in dem Verarbeitungszweig zu verarbeitenden Signals mit dem Multiplikationsfaktor 1 vorzunehmen. Entsprechend den obigen Ausführungen kann dieses Multiplizieren mit dem Multiplikationsfaktor 1 auch durch ein direktes Weiterverwenden des aus den Polyphasen-Teilfiltern jeweils resultierenden Signals erfolgen. Die einzelnen durch die Zweigverarbeitungseinrichtungen der zweiten Gruppe 134 ermittelten Signale können nachfolgend durch einen Multiplexer 2518 auf einen Multiplexerausgang 2532 sequentiell gemultiplext werden.

Analog hierzu ist in Fig. 1A ein dritter Teilsignalkonvertierer 140 des Signalkonvertierers 100 mit dem zweiten Teilsignalkonvertierer 130 und dem ersten Teilsignalkonvertierer 101 verschaltet. Hierbei umfasst der dritte Teilsignalkonvertierer 140 den Eingang 2506 zum Empfangen des dritten Startsignals xminus[k], eine dritte Einrichtung zum Kopieren 142, um eine Mehrzahl von kopierten dritten Startsignalen zu erhalten, eine dritte Gruppe von Zweigverarbeitungseinrichtungen 144, einen dritten Multiplexer 2520 zum Multiplexen von durch die Zweigverarbeitungseinrichtungen der dritten Gruppe 144 verarbeiteten Zweigsignale auf einen Ausgang 2534 des dritten Multiplexers 2520. Hierbei kann wiederum jede der Zweigverarbeitungseinrichtungen der dritten Gruppe 144 eine Einrichtung 118 zum Filtern und eine Einrichtung 120 zum Multiplizieren umfassen. Die Einrichtungen 118 zum Filtern der dritten Gruppe von Zweigverarbeitungseinrichtungen 144 können ferner wieder, wie oben beschrieben wurde, in einer Polyphasen-Struktur mit einem ersten Polyphasen-Teilfilter Phase 0, einem zweiten Polyphasen-Teilfilter Phase 1, einem dritten Polyphasen-Teilfilter Phase 2 sowie einem vierten Polyphasen-Teilfilter Phase 3 aufgebaut sein. Ferner können die Einrichtungen 120 zum Gewichten ausgebildet sein, um ein in einem ersten Verarbeitungszweig zu verarbeitenden Signal mit einem Multiplikationsfaktor von 1 zu gewichten. Dieses Gewichten kann beispielsweise wieder, wie zuvor beschrieben wurde, durch ein "Durchführen" des Signals erfolgen. Ferner ist die Einrichtung 120 zum Gewichten im zweiten Verarbeitungszweig der dritten Gruppe 144 ausgebildet, um eine Gewichtung eines in diesem Verarbeitungszweig zu verarbeitenden Signals mit einem (rein imaginären) Multiplikationsfaktor von -j zu multiplizieren. Die Einrichtung 120 zum Gewichten im dritten Verarbeitungszweig, der das dritte Polyphasen-Teilfilter Phase 2 umfasst, ist ausgebildet, um eine Negation eines im dritten Verarbeitungszweig zu verarbeitenden Signals durchzuführen. Letztlich ist die Einrichtung 120 zum Gewichten im vierten Verarbeitungszweig, der das vierte Polyphasen-Teilfilter Phase 3 umfasst, ausgebildet, um ein im vierten Verarbeitungszweig zu verarbeitendes Signal mit dem komplexen Faktor j zu multiplizieren.

Schließlich umfasst der Signalkonvertierer 100 noch einen Addierer 160 zum Addieren eines am Ausgang 2530 des ersten Multiplexers 2516 anliegenden Signals mit einem am Ausgang 2532 des zweiten Multiplexers 2518 anliegenden Signal sowie einem am Ausgang 2534 des dritten Multiplexers 2520 anliegenden Signal, um ein Ausgangssignal y[m] zu erhalten. Die Addition erfolgt dann abtastwertweise, d.h. ein erster Wert des am Ausgang 2530 anliegenden Signals, ein gleichzeitig mit dem ersten Wert anliegender zweiter Wert eines am Ausgang 2532 des zweiten Multiplexers 2518 anliegenden Signals und ein gleichzeitig mit dem ersten Wert anliegender dritter Wert eines am Ausgang 2534 des dritten Multiplexers 2520 anliegenden Signals werden miteinander addiert, um einen Wert des Ausgangssignals y[m] zu erhalten.

Gegenüber einem herkömmlichen Signalkonvertierer, wie er beispielsweise in Fig. 25 durch den Signalkonvertierer 2500 dargestellt ist, benötigt der in Fig. 1A dargestellte Signalkonvertierer 100 einen geringeren schaltungstechnischen Aufwand oder numerischen Aufwand, wenn die Struktur des in Fig. 1A dargestellten Signalkonvertierers als Softwarelösung implementiert wird. Dadurch, dass durch die Einrichtungen 102, 132 und 142 zum Kopieren eine Mehrzahl von zu den entsprechenden Startsignalen identischen kopierten Startsignalen bereitgestellt werden und die Ausbildung der Einrichtungen zum Filtern 118 der entsprechenden Gruppen von Zweigverarbeitungseinrichtungen als Polyphasen-Filterstruktur ausgebildet sind, lässt sich somit bereits eine Reduktion des numerischen Aufwandes gegenüber dem Stand der Technik erzielen, da die in Fig. 25 dargestellten und mit dem Bezugszeichen 2510, 2512 und 2514 versehenen Multiplexer entfallen können. Ferner ist es möglich, die Tiefpass-Filter LP1, LP2 und LP3 effizient durch die Polyphasen-Filterstruktur zu realisieren. Insbesondere die Kombination aus der Einrichtung zum Kopieren in Verbindung mit der Polyphasen-Filterstruktur trägt somit zu einer erheblichen Aufwandsreduktion gegenüber dem Stand der Technik bei. Da in den einzelnen Verarbeitungszweigen in den entsprechenden Gruppen von Zweigverarbeitungseinrichtungen bereits vier Teilsignale vorliegen, kann jedes Teilsignal durch eine Einrichtung 120 zum Gewichten oder Multiplizieren gewichtet oder multipliziert werden. Hierbei lassen sich durch die Auswahl von verschiedenen Multiplikations- bzw. Gewichtungsfaktoren in den einzelnen Verarbeitungszweigen innerhalb einer Gruppe von Zweigverarbeitungseinrichtungen eine komplexe Drehoperation in der Form einer Multiplikation oder Gewichtung mit dem rein imaginären Faktoren j und -j durchführen, wie sie vorstehend bereits beschrieben wurde. Insbesondere durch die Kombination der Polyphasen-Filterstruktur mit der Multiplikation durch die (vier unterschiedlichen) Multiplikationsfaktoren lässt sich somit eine weitere Reduktion des notwendigen Aufwandes erzielen, derart, das gegenüber dem in Fig. 25 dargestellten Signalkonvertierer 2500 die mit dem Bezugszeichen 2522, 2524 und 2526 gekennzeichneten Demultiplexer entfallen können. Die nachfolgende Verschaltungsstruktur, insbesondere der Einsatz der durch die Bezugszeichen 2516, 2518 und 2520 versehenen Demultiplexer und die Additionsoperation unter Verwendung der Einrichtung zum Addieren 2528 entspricht dem in Fig. 25 dargestellten Signalkonvertierer 2500. Zusammenfassend lässt sich somit sagen, dass durch eine Verschaltungsstruktur, wie sie in Fig. 1A dargestellt ist, durch das Entfallen von drei Multiplexern, drei Demultiplexern und einer schaltungstechnisch günstigeren Realisierung der Tiefpass-Filter eine deutliche Reduktion des technisch notwendigen Aufwandes für den Signalkonvertierer 100 gegenüber dem herkömmlichen Signalkonvertierer 2500 möglich ist. Auch lässt sich durch eine derartige unaufwendigere Realisierung eines Signalkonvertierers eine Beschleunigung der Signalkonversion durchführen, wenn der Signalkonvertierer gemäß der in Fig. 1A dargestellten Schaltungsstruktur mit einer gleichen Taktrate beaufschlagt wird, wie der herkömmliche, in Fig. 25 dargestellte Signalkonvertierer 2500. Alternativ kann jedoch auch der Signalkonvertierer 100 mit einer niedrigeren Taktrate als der herkömmliche Signalkonvertierer 2500 betrieben werden, was sich dann weiter kostensparend und damit aufwandsreduzierend auswirkt.

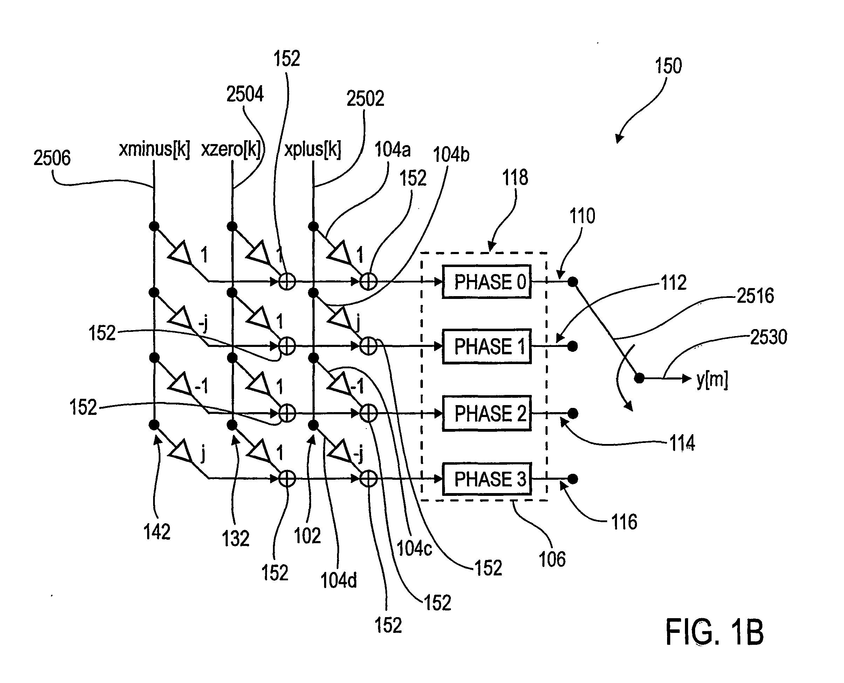

Fig. 1B zeigt ein weiteres Ausführungsbeispiel des erfindungsgemäßen Signalkonvertierers 150. Der Signalkonvertierer 150 hat wieder einen ersten Starteingang 2502 zum Beaufschlagen des Signalkonvertierers 150 mit dem ersten Startsignal xplus[k], einen zweiten Starteingang 2504 zum Beaufschlagen des Signalkonvertierers 150 mit dem zweiten Startsignal xzero[k] und einen dritten Starteingang 2506 zum Beaufschlagen des Signalkonvertierers 150 mit dem dritten Startsignal xminus[k]. Ferner umfasst der Signalkonvertierer 150 wiederum eine Einrichtung zum Kopieren 102, um aus dem Startsignal xplus[k] eine Mehrzahl von (zu dem Startsignal xplus[k] identischen) kopierten Startsignalen 104a-d zu erzeugen. Jedes der kopierten Startsignale 104a-d kann nachfolgend in einen von vier Verarbeitungszweigen, analog den in Fig. 1A dargestellten und mit den Bezugszeichen 110, 112, 114 und 116 bezeichneten ersten, zweiten, dritten und vierten Verarbeitungszweigen eingespeist werden. In jedem der Verarbeitungszweige ist ferner wiederum eine Gruppe von Zweigverarbeitungseinrichtungen angeordnet, wobei diese Gruppe von Zweigverarbeitungseinrichtungen im Wesentlichen den in Fig. 1A dargestellten Einrichtungen 118 zum Filtern, insbesondere zum Tiefpass-Filtern entspricht. Insbesondere ist hierbei auch eine Polyphasen-Struktur implementiert, analog zu der Polyphasen-Struktur in Fig. 1A mit den Polyphasen-Teilfiltern Phase 0, Phase 1, Phase 2 und Phase 3. Jedes der in den einzelnen Verarbeitungszweigen 110, 112, 114 und 116 verarbeiteten Signale kann nachfolgend durch einen Multiplexer, analog dem in Fig. 1A dargestellten Multiplexer 2516 auf ein Ausgangssignal 2530 des Multiplexers 2516 gemultiplext werden. Beim Signalkonvertierer 150 entspricht jedoch der Ausgang 2530 des Multiplexers 2516 dem Signalausgang y[m] des Signalkonvertierers 150.

Ferner kann jedes der kopierten Startsignale 104a bis 104d durch eine Einrichtung zum Multiplizieren mit einem (beispielsweise komplexen) Multiplikationsfaktor gewichtet werden. Beispielsweise kann das erstes kopierte Startsignal 104a mit dem Faktor 1 multipliziert (oder einfach "durchgeführt") werden. Das zweite Teilsignal 104b kann durch die Einrichtung zum Multiplizieren mit einem Multiplikationsfaktor von j multipliziert werden. Das dritte kopierte Startsignal 104c kann mit einem Multiplikationsfaktor von - 1 multipliziert werden, während das vierte kopierte Startsignal 104d mit einem (rein imaginären) komplexen Multiplikationsfaktor von -j multipliziert werden kann. Eine derartige Multiplikation der vier kopierten Startsignale 104a bis 104d entspricht somit einer Multiplikation von Signalen, wie sie durch die in Fig. 1A dargestellte Einrichtung 101 zum Multiplizieren realisiert wird. Derart multiplizierte kopierte Startsignale 104 bis 104d können nun weiter einer Gruppe von Zweigverarbeitungseinrichtungen, analog der ersten Gruppe von Zweigverarbeitungseinrichtungen 106 in Fig. 1A, zugeführt werden. Gemäß dem in Fig. 1B dargestellten Signalkonvertierer 150 umfasst die Gruppe von Zweigverarbeitungseinrichtungen jedoch lediglich eine Mehrzahl von Einrichtungen 118 zum Filtern, wie sie in Fig. 1A durch die Polyphasen-Filterstruktur mit den Polyphasen-Teilfiltern Phase 0, Phase 1, Phase 2 und Phase 3 abgebildet ist; die Einrichtungen 120 zum Multiplizieren bzw. Gewichten sind in dem Signalkonvertierer 150 nicht enthalten. Die Funktionalität und die Aufteilung von Filterkoeffizienten auf die einzelnen Polyphasen-Teilfilter in Fig. 1B kann der Funktionalität und der Aufteilung von Filterkoeffizienten auf die einzelnen Polyphasen-Teilfilter gemäß Fig. 1A entsprechen.

Im Unterschied zu der in Fig. 1A dargestellten Struktur eines Signalkonvertierers 100 entfällt somit in der in Fig. 1B dargestellten Struktur eines Signalkonvertierers 150 die Additionseinrichtung 2528 zum Addieren der Ausgangssignale des zweiten Multiplexers 2518 und des dritten Multiplexers 2520. Eine derartige Struktur mit lediglich dem einen Multiplexer 2516 kann aber auch in einem Anwendungsfall verwendet werden, wenn ein Zusammenführen des (ersten) Startsignals xplus[k] mit einem zweiten Startsignal xzero[k] durchzuführen ist. In diesem Fall weist der Signalkonvertierer 150 eine weitere Einrichtung zum Kopieren 132 auf, um eine Mehrzahl von kopierten zweiten Startsignalen aus dem zweiten Startsignal xzero[k] zu erhalten. Diese zweiten Startsignale können nun wiederum in jeweils einen der Verarbeitungszweige 110, 112, 114 und 116 eingespeist werden. Dieses Einspeisen kann wiederum unter Verwendung einer Gewichtungseinrichtung erfolgen, wobei die Gewichtungseinrichtung ausgebildet ist, um jedes in einen Verarbeitungszweig einführbares kopiertes zweites Startsignal mit einem Gewichtungsfaktor zu gewichten. In Fig. 1B ist eine derartige Gewichtung mit dem Gewichtungsfaktor von 1 für alle kopierten zweiten Startsignale durchgeführt worden, was sich auch durch das vorstehend erläuterte "Durchführen" effizient umsetzen lässt. Die gewichteten kopierten zweiten Startsignale können dann mit den gewichteten kopierten Startsignalen 104a bis 104d in den entsprechenden Zweigen durch einen Zweigaddierer in jedem der Verarbeitungszweige 110, 112, 114 und 116 addiert werden, um ein Additionssignal zu erhalten. Ein Ergebnis der entsprechenden Zweigaddierer 152 kann auf je eines der Polyphasen-Teilfilter Phase 0, Phase 1, Phase 2 und Phase 3 in einem der Verarbeitungszweige 110, 112, 114 und 116 gelegt werden. Ein derartiges "Vorziehen" der Addition vor die Filterung ist durch die Anwendung von Vorschriften für lineare Systeme möglich. Ebenso können auf analoge Weise beispielsweise auch das in Fig. 1B dargestellte dritte Startsignal xminus[k] mit dem zweiten Startsignal xzero[k] und dem ersten Startsignal xplus[k] verarbeitet werden. Hierzu ist eine dritte Einrichtung 142 zum Kopieren des dritten Startsignals xminus [k] erforderlich, um eine Mehrzahl von dritten kopierten Startsignalen bereitzustellen, die in je einen der Verarbeitungszweige 110, 112, 114 oder 116 eingespeist werden können. In den entsprechenden Verarbeitungszweigen kann nun wieder eine Gewichtung unter Verwendung von Gewichtungsfaktoren erfolgen, wobei anschließend die gewichteten kopierten dritten Startsignale jeweils mit entsprechenden gewichteten kopierten zweiten Startsignalen oder gewichteten kopierten ersten Startsignalen 104a bis 104d addiert werden. In Fig. 1B sind hierzu in jedem Verarbeitungszweig zwei Zweigaddierer dargestellt; es ist jedoch auch möglich, eine Addition unter Verwendung eines einzigen Zweigaddierers 152 pro Zweig durchzuführen, wenn diese Zweigaddierer dann drei Eingänge und einen Ausgang aufweisen. Durch die Wahl der entsprechenden Gewichtungskoeffizienten für die kopierten Startsignale in jedem der unterschiedlichen Verarbeitungszweige kann ferner beeinflusst werden, ob das Startsignal eine positive oder negative Frequenzverschiebung erfährt, oder ob eine Frequenzverschiebung des eingespeisten Startsignals unterbleibt. In Bezug auf die Wahl der Gewichtungs- oder Multiplikationsfaktoren gelten die Ausführungen im Zusammenhang mit Fig. 1A und Fig. 25 analog. Ferner lassen sich auch weitere Startsignale auf analoge Weise zu dem Ausgangssignal y[m] zusammenführen, wobei in diesem Fall jedoch zu beachten ist, dass sich zwei spektral verschobene Startsignale im Endsignal nicht überlappen dürfen, um keinen Datenverlust hervorzurufen. Hierzu ist es notwendig, dass lediglich drei Startsignale eine gleiche Startfrequenz aufweisen dürfen, wobei jedes der Startsignale dann entweder in positive Richtung frequenzverschoben werden muss, nicht frequenzverschoben werden darf oder in negative Richtung frequenzverschoben werden muss, so dass im Ausgangssignal y[m] die drei Startsignale in unterschiedliche spektrale Bänder verschoben werden. Sollen weitere Startsignale auf das Endsignal zusammengeführt werden, ist es daher notwendig, dass die weiteren Startsignale eine Startfrequenz aufweisen, die sich von den ersten drei Startsignalen unterscheiden.

Durch eine in Fig. 1B dargestellte Struktur eines Signalkonvertierers 150, lässt sich gegenüber einer in Fig. 1A dargestellten Struktur eines Signalkonvertierers 100 eine Reduktion des technisch notwendigen Aufwandes erzielen. Dies resultiert insbesondere daraus, dass lediglich eine einzige Gruppe von Zweigverarbeitungseinrichtungen, nämlich die Einrichtungen 118 zum Filtern der Polyphasen-Struktur mit den Polyphasen-Teilfiltern Phase 0, Phase 1, Phase 2 und Phase 3 notwendig sind. Eine doppelte bzw. dreifache Ausbildung dieser Polyphasen-Teilfilter, wie in Fig. 1A dargestellt, ist somit nicht mehr notwendig und wirkt sich vereinfachend auf die Struktur des zu realisierenden Signalkonvertierers aus. Weiterhin kann das Bereitstellen von mehreren Multiplexern entfallen, da lediglich ein einziger Multiplexer, wie in Fig. 1B dargestellt, bereitzustellen ist. Dies wirkt sich zusätzlich aufwandsreduzierend aus. Erschwerend kommt jedoch hinzu, dass nunmehr vier Additionseinrichtungen bereitzustellen sind, wobei jedoch zu beachten ist, dass eine Additionseinrichtung technisch leichter zu realisieren ist, als ein Multiplexer und sich hierdurch eine insgesamt aufwandsreduzierte Schaltung gegenüber der Schaltung in Fig. 1A möglich ist. Diese technische Vereinfachung ergibt sich insbesondere daraus, dass der hier vorgeschlagene Signalkonvertierer mit einer mit einer niedrigeren Taktrate betrieben werden kann und somit eine gegenüber herkömmlichen Signalkonvertierern notwendige hohe Taktrate zur Taktung des Multiplexers entfallen kann.

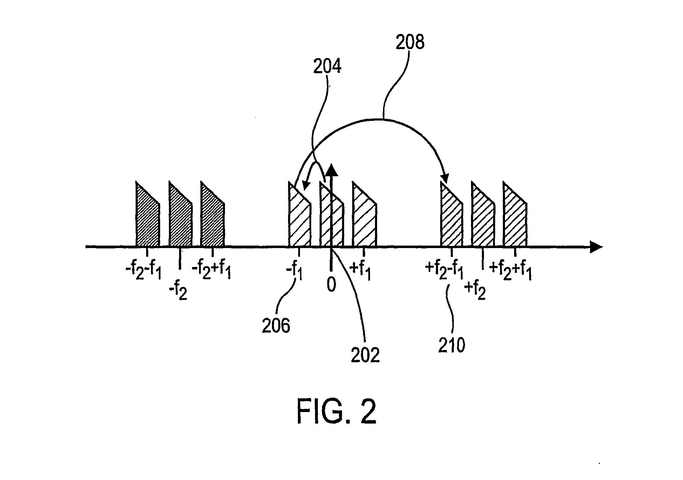

Weiterhin lassen sich auch die in Fig. 1A und 1B dargestellten Signalkonvertierer 100 und 150 kaskadieren, wobei zwischen den einzelnen Kaskadestufen vorzugsweise eine Abtastratenumsetzung eingefügt werden kann. Dies bietet den Vorteil, dass sich durch die erste Stufe beispielsweise drei Frequenzbänder bei Berücksichtigung der positiven und negativen Frequenzverschiebung und der "neutralen" Frequenzumsetzung (d.h. einer Frequenzumsetzung ohne spektrale Verschiebung des Signals in ein anderes Frequenzband) realisieren lassen, während durch die Abtastratenumsetzung eine weitere Frequenzverschiebung mit einem anderen Verschiebungsabstand durchführbar ist, woraus sich neun erreichbare Frequenzbänder mit einer derartigen Zweifach-Kaskadestufe realisieren lassen. Ein Schema der durch einen derartigen kaskadierten Signalkonvertierer erreichbaren Frequenzen ist in Fig. 2 dargestellt.

In diesem Zusammenhang ist ferner anzumerken, dass unter dem Begriff "digitales Mischen" eines komplexen Basisbandsignals das Multiplizieren eines Basisbandsignals mit einem rotierenden komplexen Zeiger $e^{j2\pi k f_c/f_s}$ verstanden wird, wobei k ein laufender Index eines Abtastwertes (d. h. Samples) des komplexen Basisbandsignals (oder Eingangssignals), $f_c$ die gewünschte neue Carrier- (d. h. Mitten-) Frequenz und $f_s$ die Abtastfrequenz (d. h. Sample-Frequenz) ist. Wenn man die Spezialfälle $f_c = 0$ oder $\pm f_s/4$ wählt, dann nimmt der rotierende komplexe Zeiger nur noch die Werte $\pm 1$ und $\pm j$ an. Wenn das komplexe Eingangssignal in I- und Q-Komponente vorliegt, dann sind diese Multiplikationen sehr einfach durch eine Negierung und ein Multiplexen der beiden Komponenten zu erreichen, z. B. Multiplikation mit -j bedeutet: $I_{Ausgangssignal} = Q_{Eingangssignal}$ und $Q_{Ausgangssignal} = - I_{Eingangssignal}$. Mit diesem vorstehend dargestellten Prinzip kann eine Mischung auf drei Teilfrequenzbänder mit den Mittenfrequenzen $f_c = 0$, $f_c = +f_s/4$ und $f_c = -f_s/4$ realisiert werden.

Anhand einer in Fig. 2 dargestellten Frequenzverteilung soll eine mögliche Aufwärts- und Abwärtsmischung durch die Kaskadierung von mehreren Signalkonvertierern näher erläutert werden. In diesem Zusammenhang ist anzumerken, dass eine Abwärtsmischung lediglich zu Zwecken der Veranschaulichung dient, sich der erfindungsgemäße Ansatz im wesentlichen aber auf die Aufwärtsmischung bezieht.

Um eine solche, vorstehend beschriebene einfach zu realisierende digitale Mischung für eine Aufwärtsmischung verwenden zu können, kann nun eine Kaskadierung der oben näher erläuterten Mischer erfolgen, wobei vor einer Mischung mit dem zweiten der kaskadierten Mischer eine Umsetzung der Abtastfrequenz erfolgt. Für einen solchen kaskadierten Mischer kann beispielsweise in einer ersten Mischerstufe, das Eingangssignal mit einer ersten (niedrigen) Abtastfrequenz $f_{s1}$ durch den ersten Mischer auf die Mittenfrequenzen $f_{c1} = 0$, $f_{c1} = +f_{s1}/4 = +f_1$ oder $f_{c1} = -f_{s1}/4 = -f_1$ gebracht werden.

Anschließend folgt ein Upsampling (d. h. eine Abtastfrequenzerhöhung) um beispielsweise den Faktor 4 auf eine zweite (höhere) Abtastfrequenz $f_{s2}$. Zum Erzeugen der $f_{s2}$-Samples gehört dabei vorzugsweise ein Einfügen von "0"-Werten (Samples) nach jedem $f_{s1}$-Sample (d.h. für dieses Beispiel mit $f_{s2} = 4 * f_{s1}$ ein Einfügen von drei "0"-Werten). Nachfolgend wird eine Tiefpassfilterung durchgeführt, um nur das upgesampelte $f_{s1}$-Signal und nicht seine Spectral Images (d.h. dessen bei der Überabtastung entstehende spektrale Spiegelfrequenzen) bei Vielfachen von der ersten Abtastfrequenz $f_{s1}$ zu behalten. Anschließend kann wieder eine digitale Mischung durchgeführt werden, diesmal auf die Mittenfrequenzen $f_{c2} = 0$, $f_{c2} = +f_{s2}/4 = +f_2$ oder $f_{c2} = -f_{s2}/4 = -f_2$. Insgesamt kann man auf diese Weise ausgehend von einem Signal in der Aktuellfrequenz neun verschiedene Mittenfrequenzen $f_c$ in Bezug zur Aktuellfrequenz $f_0$ erreichen:

$$f_c = f_0 - f_2 - f_1,$$

$$f_c = f_0 - f_2 + 0,$$

$$f_c = f_0 - f_2 + f_1,$$

$$f_c = f_0 - f_1,$$

$$f_c = f_0,$$

$$f_c = f_0 + f_1,$$

$$f_c = f_0 + f_2 - f_1,$$

$$f_c = f_0 + f_2,$$

und $f_c = f_0 + f_2 + f_1$. Eine solche Frequenzverteilung ist exemplarisch in Fig. 2 dargestellt.

Ein Mischer kann nun beispielsweise ein Signal der Aktuellfrequenz $f_0$ 202, d. h. der Mittenfrequenz $f_c = f_0$ durch eine erste Mischung 204, auf die Mittenfrequenz $f_c = f_0 - f_1$ gemischt werden. Hieran anschließend erfolgt nach einem Upsampling eine Erhöhung der Abtastfrequenz, worauf eine Mischung 208 des nunmehr in der Zwischenfrequenz mit Mittenfrequenz $f_c = f_0 - f_1$ befindlichen Signals auf die Zielfrequenz 210 mit der Mittenfrequenz $f_c = f_0 + f_2 - f_1$ durchgeführt werden.

Aus der Darstellung gemäß Fig. 2 wird ersichtlich, dass auch weitere Mischer kaskadiert werden können. Hierdurch ist es möglich, ein Signal mit einer Aktuellfrequenz auf beispielsweise 27 Mittenfrequenzen verschieben zu können, wenn eine dreistufige Mischeranordnung realisiert ist, oder ein Signal mit einer Aktuellfrequenz auf 81 Mittenfrequenzen verschieben zu können, wenn eine vierstufige Mischeranordnung realisiert ist. Eine derartige Kaskade kann beliebige fortgesetzt werden, wobei eine Anzahl von erreichbaren Mittenfrequenzen durch den Ausdruck $3^x$ gekennzeichnet ist und x die Anzahl von kaskadierten Mischern ist.

Analog zum Aufwärtsmischen im Sender erfolgt das Abwärtsmischen im Empfänger durch einen rotierenden komplexen Zeiger $e^{j2\pi k f_c / f_s}$. Genau wie im Sender kann deshalb für $f_c = 0$ und $\pm f_s/4$ das Abwärtsmischen mittels Negierung und Multiplexen der I- und Q-Komponente erreicht werden. Auf diese Weise können ebenfalls drei Teilfrequenzbänder empfangen werden. Analog zu der Kaskadierung von Mischerstufen im Sender kann wiederum eine Kaskadierung von Mischern, wie beispielsweise den in Fig. 1A oder 1B gezeigten Frequenzumsetzern, erfolgen, wodurch sich die Anzahl der numerisch oder schaltungstechnisch einfach zu trennenden Frequenzbänder erhöhen lässt. Sei beispielsweise die Abtastfrequenz am Empfängereingang gleich $f_{s2}$ und die Mittenfrequenz des empfangenen Signals gleich $f_c = f_0 - f_2 - f_1$,

$$f_c = f_0 - f_2 + 0,$$

$$f_c = f_0 - f_2 + f_1,$$

$$f_c = f_0 - f_1,$$

$$f_c = f_0,$$

$$f_c = f_0 + f_1,$$

$$f_c = f_0 + f_2 - f_1,$$

$$f_c = f_0 + f_2,$$

oder $f_c = f_0 + f_2 + f_1$. Insgesamt lassen sich neun Teilfrequenzbänder trennen. Alle diese Mittenfrequenzen werden durch Frequenzumsetzung mit 0 bzw. $\pm f_{s2}/4 = \pm f_2$ auf die Mittenfrequenzen $f_c = 0$ bzw. $f_c = \pm f_{s1}/4 = \pm f_1$ umgesetzt.

Während der Frequenzumsetzung kann in einem Frequenzumsetzer zugleich ein unterabtasten, d.h. ein Downsampling von der (höheren) Abtastfrequenz $f_{s2}$ auf die (niedrigere) Abtastfrequenz $f_{s1}$ erfolgen, wobei analog zum oben genannten Beispiel die niedrige Abtastfrequenz $f_{s1} = f_{s2}/4$. ist. Dabei wird vorzugsweise das bei der hohen Abtastfrequenz $f_{s2}$ vorliegende Signal in den Einrichtungen zum Gewichten in dem Frequenzumsetzer tiefpassgefiltert, um bei der Unterabtastung die entstehenden Spiegelfrequenzen auszublenden. Danach kann wieder eine Mischung mit 0 bzw. $\pm f_{s1}/4 = \pm f_1$ erfolgen, so dass letztendlich das Signal bei der Mittenfrequenz $f_0$ liegt. Beispielsweise kann das Empfangssignal bei einer Mittenfrequenz $f_c = f_0 + f_2 - f_1$ liegen, wie dies durch die Mittenfrequenz 210 in Fig. 2 dargestellt ist. Durch den ersten Frequenzumsetzer kann dann eine zur Mischung 208 inverse Umsetzung erfolgen, wobei das Signal dann auf eine Mittenfrequenz 206 von $f_c = f_0 - f_1$ geführt wird. Zugleich mit der Frequenzumsetzung kann in dem Frequenzumsetzer, wie oben ausgeführt, wieder eine Unterabtastung erfolgen. Das nunmehr unterabgetastete Signal bei der Mittenfrequenz 204 von $f_c = f_0 - f_1$ kann dann durch einem, dem zweiten Mischer entsprechenden Frequenzumsetzer in einer zur Mischung 204 inversen Mischung auf die Mittenfrequenz 202 von $f_c = f_0$ überführt werden.

Das Empfangssignal mit der hohen Abtastfrequenz wird daher durch die Abtastratenreduktion im Frequenzumsetzer von der Aktuellfrequenz auf ein Viertel der Aktuellfrequenz umgesetzt. Erfolgt ferner eine spektrale Umsetzung der Aktuellfrequenz um ein Viertel der hohen Abtastfrequenz resultiert nach der Abtastratenreduktion ein Ausgangssignal des ersten Frequenzumsetzers, bei dem die Mittenfrequenz neben der Reduktion auf ein Viertel der Aktuellfrequenz je nach Versatzrichtung des spektralen Umsetzens um ein Sechzehntel der Abtastfrequenz reduziert oder erhöht ist.

Analog zu den obigen Ausführungen können auch mehr als neun Teilfrequenzbänder (beispielsweise 27, 81 Teilfrequenzbänder) auf die zuvor beschriebene Weise empfangen oder getrennt werden, wenn eine entsprechende Anzahl von Mischerstufen bzw. Frequenzumsetzerstufen kaskadiert werden.

Im folgenden soll näher auf die mathematischen Grundlagen der numerisch oder schaltungstechnisch einfach zu realisierenden Frequenzverschiebung eingegangen werden. Im kontinuierlichen Bereich wird eine Frequenzverschiebung durch die Anwendung der Formel

$$f(t) * e^{j\omega_0 t}$$

erreicht, was einer Frequenzverschiebung $F(j(\omega-\omega_0))$ in positiver Richtung entspricht. Die Umsetzung in den diskreten Zeitbereich sieht wie folgt aus:

$$f[n] * e^{jn2\Pi f T_s} .$$

Speziell der Fall einer Frequenzverschiebung um $f_s/4$ (was einer Drehung um $\pi/2$ entspricht) wird näher betrachtet, x.

Setzt man für f in die obige Formel $f_s/4$ mit $f_s$ als Abtatsfrequenz ein (d. h. das Spektrum wird in die "positive" Richtung verschoben), so erhält man mit $f_s = 1/T_s$:

$$f[n] * e^{jn2\pi(1/(4T_s))T_s} = f[n] * e^{jn\pi/2} = y[n].$$

Gilt nun für ein Eingangssignal $f[n] = i[n] + j * q[n]$, so erhält man unter Verwendung der Eulerschen Formel für den Exponentialausdruck (d. h. $e^{jn\pi/2} = \cos(n\pi/2) + j * \sin(n\pi/2)$) Ausdrücke für den Real- und Imaginärteil von y[n] von

$$Re\{y[n]\} = i[n] * \cos(n\pi/2) - q[n] * \sin(n\pi/2)$$

$$Im\{y[n]\} = i[n] * \sin(n\pi/2) + q[n] * \cos(n\pi/2).$$

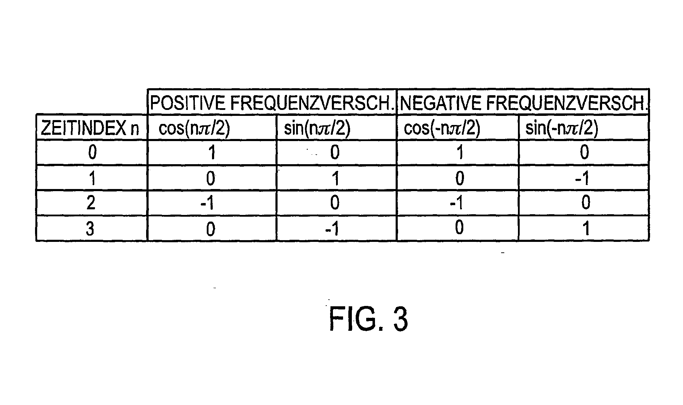

Für eine Frequenzverschiebung in positiver Richtung (d. h. eine Frequenzverschiebung des Eingangssignals zu einer höheren Frequenz des Ausgangssignals) ist dabei das Argument positiv, während bei einer Frequenzverschiebung in negativer Richtung (d. h. eine Frequenz eines Eingangssignals ist höher als eine Frequenz des Ausgangssignals) ist das Argument der Sinus- und Cosinusfunktion negativ. Eine tabellarische Darstellung der Wertepaare der Ausdrücke $\cos(n\pi/2)$ und $\sin(n\pi/2)$ für verschiedene Zeitindex-Werte n ist in Fig. 3 dargestellt. Hierbei sind die zuvor genannten Ausdrücke für die Sinus- und Cosinusfunktion jeweils für eine positive oder negative Frequenzverschiebung aufgelistet, wobei als Zeitindex die Werte n = 0, 1, 2 und 3 zugrunde gelegt wurden.

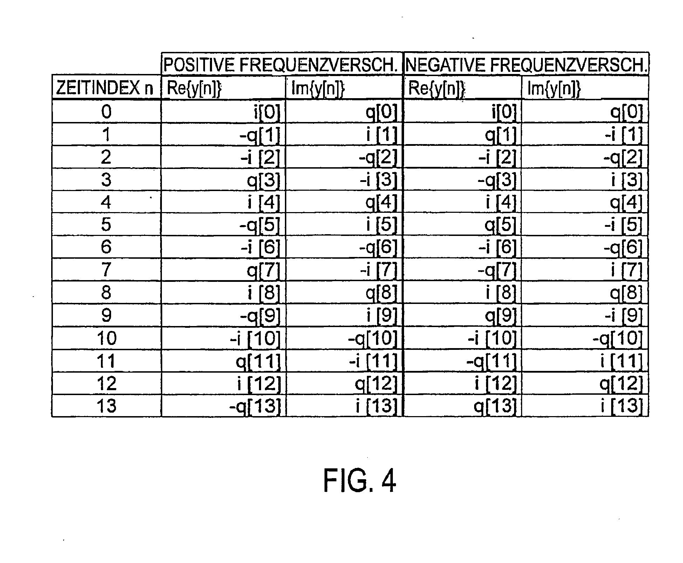

Anhand der in Fig. 3 dargestellten Tabelle und der obigen Formel ergibt sich eine Frequenzverschiebung des Eingangssignals $f[n]$ um $f_s/4$ für ein komplexes Eingangssignal $i[n] + j * q[n]$, wie sie in der tabellarischen Darstellung in Fig. 4 wiedergegeben ist. Wie zu erkennen ist, unterscheiden sich die jeweiligen Werte für Real- und Imaginärteil der positiven und negativen Verschiebungen für alle ungeraden Indizes nur durch das Vorzeichen. Außerdem ist anzumerken, dass bei allen ungeraden Zeitindizes der Imaginärteilwert $q[n]$ des Eingangssignals $f[n]$ dem Realteilwert des Ausgangssignals $y[n]$ entweder direkt oder in negierter Form zugewiesen wird. Ferner wird bei jedem ungeraden Zeitindex der Realteilwert $i[n]$ eines Eingangssignals $f[n]$ dem Imaginärteilwert eines Ausgangssignals $y[n]$ des entsprechenden Zeitindexes n entweder direkt oder in negierter Form zugewiesen. Die Real- und Imaginärteilwerte des Ausgangssignals y[n] eines Mischers können somit als Ergebniswerte einer komplexen Multiplikation eines Eingangswerts f[n] mit einem komplexwertigen Multiplikationsfaktor betrachtet werden.

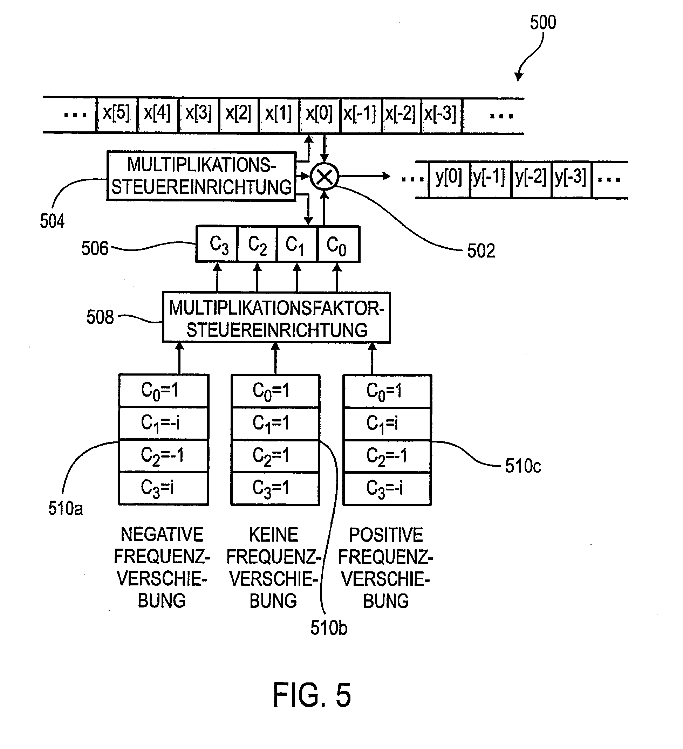

Eine derartige Multiplikation kann beispielsweise durch eine Multiplikationsvorrichtung 500 erreicht werden, wie sie in Fig. 5 dargestellt ist. Eine solche Multiplikationsvorrichtung 500 umfasst ein Multiplikationselement 502, eine Multiplikationssteuereinrichtung 504, ein Multiplikationsfaktorregister 506 mit mehreren Multiplikationsfaktoren $c_0$, $c_1$, $c_2$ und $c_3$. Ein erster Multiplikationsfaktorsatz 510a (mit den Koeffizienten $c_0$= 1, $c_1$=-i, $c_2$=-1, $c_3$=i) korrespondiert zu einer negativen Frequenzverschiebung, ein zweiter Multiplikationsfaktorsatz 510b (mit den Koeffizienten $c_0$= 1, $c_1$=1, $c_2$=1, $c_3$=1) entspricht einer Mischung, bei der keine Frequenzverschiebung erfolgt, während ein dritter Multiplikationsfaktorsatz 510c (mit den Koeffizienten $c_0$= 1, $c_1$=i, $c_2$=-1, $c_3$=-i) einer Mischung mit einer positiven Frequenzverschiebung entspricht. Ferner können dem Mischer 500 Eingangssignale x[n], mit n = -3, -2, -1, 0, 1, 2, 3, 4, 5, ..., zugeführt werden. Als Ergebnis kann der Mischer 500 Ausgangswerte y[n] mit n = -3, -2, -1, 0, ... ausgeben.

Die Funktionsweise des in Fig. 5 dargestellten Mischers 500 kann nun wie folgt beschrieben werden. Zunächst wird entsprechend einer gewünschten Frequenzverschiebung (beispielsweise unter Verwendung eines Steuersignals an in Fig. 5 nicht dargestellten Steuereingang des Mischers 500, mit dem die Richtung der Frequenzverschiebung einstellbar ist) einer der Multiplikationsfaktorsätze 510 unter zu Hilfenahme der Multiplikationsfaktorsteuereinrichtung 508 in das Multiplikationsfaktorregister 506 zum Speichern des verwendeten Multiplikationsfaktorsatzes geladen. Soll der Mischer 500 beispielsweise eine positive Frequenzverschiebung um ein Viertel der Abtastfrequenz durchführen, wird der Koeffizientensatz 510c in das Register 504 geladen. Um die Frequenzverschiebung nun durchzuführen, wird nun ein Eingangswert, beispielsweise der Wert x[0], in den Multiplikator 502 geladen und in dem Multiplikator mit dem Koeffizienten $c_0$ = 1 multipliziert, woraus als Ergebnis y[0] resultiert. Bei einer Multiplikation mit dem Multiplikationsfaktor $c_0$ = 1 erfolgt keine Negation oder Vertauschung der Real- und Imaginärteile des komplexen Signaleingangswerts x[0]. Dies ist auch aus der entsprechenden Zeile der Tabelle in Fig. 4 dargestellt, bei dem die Real- und Imaginärteile bei einer positiven Frequenzverschiebung für den Zeitindex 0 abgebildet sind und keine Veränderung des Real-oder Imaginärteils zeigen.

Als nächstes Element wird der nachfolgende Eingangswert x[1] in den Multiplikator 502 geladen und mit dem Multiplikationsfaktor $c_1$ (= i) multipliziert. Hieraus resultiert ein Ausgangssignalwert (d. h. ein Wert y[1]), bei dem der Realteil des Eingangswerts dem Imaginärteil des Ausgangssignalwerts zugeordnet wird und der Imaginärteil des Eingangswerts negiert und dem Realteil des Ausgangswerts zugeordnet wird, so wie es in Fig. 4 in der dem Zeitindex n = 1 entsprechenden Zeile für eine positive Frequenzverschiebung wiedergegeben ist.

Analog hierzu erfolgt im Multiplikator 502 eine Multiplikation des nächstfolgenden Signaleingangswerts x[2] mit dem Multiplikationsfaktor $c_2$ (= -1) und dem hieran anschließenden Signalwert x[3] mit dem Multiplikationsfaktor $c_3$ (= - i). Hieraus resultieren entsprechend die in Fig. 4 wiedergegebenen Werte für den Real- und Imaginärteil der entsprechenden Ausgangswerte y[n] für n = 2 und 3 gemäß der Zuordnung in der Spalte für eine positive Frequenzverschiebung.

Die nachfolgenden Signaleingangswerte lassen sich durch eine zyklische Wiederholung der vorstehend beschriebenen Multiplikationen unter Verwendung des im Register 506 abgelegten Multiplikationsfaktors auf entsprechende Signalausgangswerte y[n] umrechnen. Mit anderen Worten ausgedrückt kann somit gesagt werden, dass eine positive Frequenzverschiebung um ein Viertel der dem Eingangssignal x zugrundeliegenden Abtastfrequenz durch eine Multiplikation mit einem rein reellen oder rein imaginären Multiplikationsfaktor (wobei die Multiplikationsfaktoren vorzugsweise einen gleichen Betrag von beispielsweise dem Wert 1 haben) durchführbar ist, was wiederum zu der Vereinfachung führt, dass die Multiplikation lediglich durch eine Vertauschung von Real- und Imaginärteilwerten und/oder eine Negation der entsprechenden Werte ausgeführt werden kann. Die Ausführung der Multiplikation selbst ist somit nicht mehr notwendig, vielmehr kann das Ergebnis der Multiplikation durch diese Negations- oder Vertauschungsschritte ermittelt werden.

Für eine negative Frequenzverschiebung kann die Verwendung des Mischers 500 analog erfolgen, wobei in das Register 506 nunmehr der Multiplikationsfaktorsatz 510a zu laden ist. Analog lässt sich auch eine Mischung erreichen, bei der keine Frequenzverschiebung durchgeführt wird, wenn der Multiplikationsfaktorsatz 510b in das Register 506 geladen wird, da hierbei lediglich ein Signaleingangswert x mit dem neutralen Element der Multiplikation (d. h. mit einem Wert 1) multipliziert wird, wodurch sich der Wert des Eingangssignalwerts x zum Ausgangssignalwert y nicht ändert.

Im folgenden soll aus Gründen der Verständlichkeit des Gesamtsystems detaillierter sowohl auf ein Upsampling und eine Frequenzzuteilung eingegangen werden, wie sie beispielsweise in einem Sender zu finden sind, als auch auf eine entsprechende Ausgestaltung eines zu diesem Sender passenden Empfängers. Hierbei ist ebenfalls anzumerken, dass sich das erfindungsgemäße Konzept im wesentlichen auf den Sender, d.h. den Upconverter bezieht; eine Beschreibung des Downsamplings aber zu einem verbesserten Verständnis des Gesamtsystems beiträgt und eine nähere Beschreibung des Downsamplings daher an dieser Stelle miteingefügt ist.

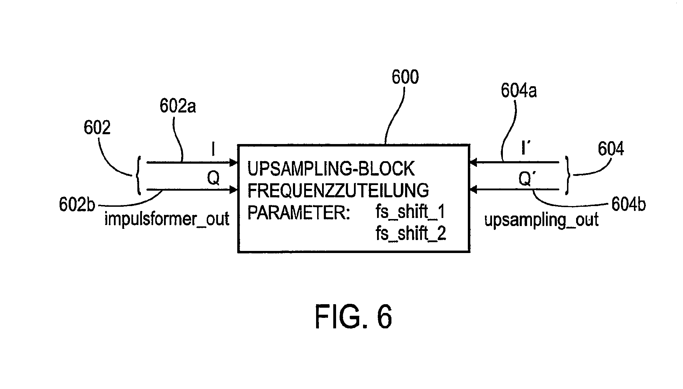

Zur Beschreibung des Upsampling lässt sich der Mischer als Upsampling-Block 600 darstellen, wie er in Fig. 6 gezeigt ist. Der Upsampling-Block 600 weist hierbei eine Eingangsschnittstelle 602 auf, über die der Upsampling-Block 600 komplexe Eingangsdaten, die in Form einer I-Komponente 602a und einer Q-Komponente 602b vorliegen, empfängt. Diese komplexen Eingangsdaten werden beispielsweise von einem (nicht dargestellten) Impulsformer ausgegeben, weshalb die Eingangsdaten bzw. der Eingangsdatenstrom in Fig. 6 auch mit der Bezeichnung "impulsformer_out" gekennzeichnet wird. Ferner umfasst der Upsampling-Block 600 eine Ausgangsschnittstelle 604 zum Ausgeben der upgesampelten (d.h. überabgetasteten) Daten, wobei die Ausgangsschnittstelle 604 wiederum eine erste Komponente I' 604a und eine zweite Komponente Q' 604b umfasst. Da es sich bei den ausgegebenen Daten bzw. dem Ausgangsdatenstrom um upgesampelte Daten handelt, wird dieser Datenstrom auch mit der Bezeichnung "upsampling_out" bezeichnet. Um eine Frequenzzuteilung, d. h. eine Frequenzverschiebung der Mittenfrequenz des Datenstroms "impulsformer_out" zu einer Mittenfrequenz des Datenstroms "upsampling_out" zu ermöglichen, werden im Upsampling-Block 600 die Parameter fs_shift_1 und fs_shift_2 verwendet, die den Frequenzen f1 (=fs_shift_1) und f2 (=fs_shift_2) aus Abbildung 2 entsprechen.

Zu dem Eingangsdatenform impulsformer_out ist ferner anzumerken, dass dieser beispielsweise eine Wortbreite von 8 Bit pro I- oder Q-Komponente aufweist, eine Datenraten von B_Clock_16 (d. h. einem Sechzehntel der Datenrate des Ausgangsdatenstroms) umfasst, wobei der Datentyp der Eingangsdaten als komplexwertig zu betrachten ist. Ferner ist zum Ausgangsdatenstrom upsampling_out anzumerken, dass dessen Wortbreite beispielsweise 6 Bit pro I- und Q-Komponente umfasst. Außerdem weist der Ausgangsdatenstrom upsampling_out eine Datenrate von B_Clock auf, die die höchste Datenrate bzw. Taktfrequenz des hier betrachteten Upsampling-Blocks 600 definiert. Außerdem ist der Datentyp der Daten des Ausgangsdatenstroms upsampling_out als komplexer Datentyp zu betrachten.

Von extern werden dem Upsampling-Block 600 lediglich die beiden verwendeten Frequenz-Parameter fs_shift_1 und fs_shift_2 übergeben. Diese bestimmen die Umsetzung der erzeugten Basisbandsignale (d. h. der im Eingangsdatenstrom Impulsformer_out enthaltenen Signale) auf eine Zwischenfrequenz von [-B_Clock_16, 0, B_Clock_16] bei einer Abtastrate von B_Clock_4 (Parameter fs_shift_1) oder eine Umsetzung auf eine Zwischenfrequenz von [-B_Clock_4, 0, B_Clock_4] bei einer Abtastrate von B_Clock (Parameter fs_shift_2). Die Abtastrate B_Clock_4 bezeichnet hierbei ei Viertel der Abtastrate bzw. des Abtasttaktes von B_Clock.

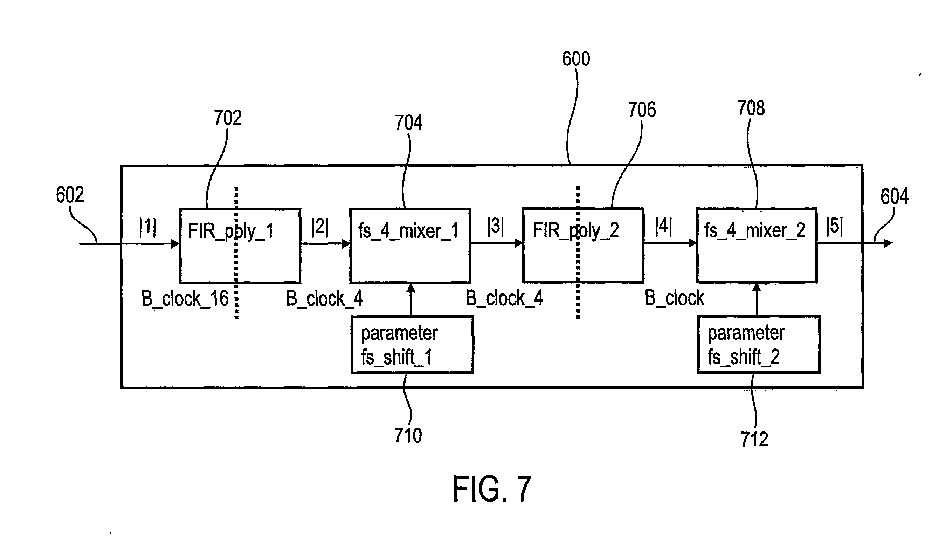

Fig. 7 zeigt ein detaillierteres Blockschaltbild des in Fig. 6 dargestellten Upsampling-Blocks 600. Der Upsampling-Block 600 kann auch als Mischer bezeichnet werden. Der Mischer 600 umfasst ein erstes Polyphasenfilter 702, einen ersten Mischer 704, ein zweites Polyphasenfilter 706, einen zweiten Mischer 708, einen ersten Parametersatz 710 und einen zweiten Parametersatz 712. Das erste Polyphasenfilter 702 umfasst einen Eingang zum Empfangen des Eingangsdatenstroms impulsformer_out, der äquivalent durch das Bezugszeichen 602 oder das Bezugszeichen |1| gekennzeichnet ist. Der Eingang des ersten Polyphasenfilters (das beispielsweise als FIR-Filter ausgebildet ist) wird somit direkt mit dem Eingang 602 des Mischers 600 verbunden. Ferner ist das erste Polyphasenfilter über den Port FIR_poly_1_out |2| mit dem ersten Mischer 704 verbunden. Weiterhin ist der erste Mischer 704 über den Port fs_4_Mischer_1_out |3| mit einem Eingang des zweiten Polyphasenfilters 706 verbunden. Das zweite Polyphasenfilter 706 weist ferner einen Ausgang auf, der über den Port FIR_poly_2_out |4| mit einem Eingang des zweiten Mischers 708 verbunden ist. Weiterhin weist der zweite Mischer 708 einen Ausgang auf, der über den Port upsampling_out |5| mit der Ausgangsschnittstelle 604 des Mischers 600 verbunden ist. Dieser Port bildet somit den Ausgang des gesamten Upsampling-Blocks 600 und wird in die nächsthöhere Hierarchieebene durchgeschleift. Ferner umfasst der Mischer 600 den ersten Koeffizientensatz 710, der dem ersten Mischer 704 zugeordnet ist, und den zweiten Koeffizientensatz 712, der dem zweiten Mischer 708 zugeordnet ist. Die Koeffizienten fs_shift_1 des ersten Koeffizientensatzes 710 und fs_shift_2 des zweiten Koeffizientensatzes 712 werden somit lediglich an die beiden Blöcke fs_4_Mischer_1 (d. h. den ersten Mischer 704) bzw. fs_4_Mischer_2 (d. h. den zweiten Mischer 708) entsprechend weitergereicht. Weitere Parameter sind in diesem Ausführungsbeispiel des Mischers 600 nicht vorhanden.

Ferner ist anzumerken, dass der durch das Bezugszeichen |1| gekennzeichnete Datenstrom Daten mit einer Wortbreite von 8 Bit pro I- und Q-Komponente aufweist, wobei die Daten mit einer Datenrate von B_Clock_16 (d. h. einem Sechzehntel des Taktes B_Clock) dem ersten Polyphasenfilter 702 zugeführt werden. Außerdem weisen die dem ersten Polyphasenfilter zugeführten Daten einen komplexwertigen Datentyp auf. Im ersten Polyphasenfilter 702 (das vorzugsweise als FIR-Filter ausgebildet ist) erfolgt eine Erhöhung des Abtasttaktes von beispielsweise B_Clock_16 auf B_Clock_4, was einer Vervierfachung des Abtasttaktes entspricht. Hierdurch zeichnet sich das mit dem Bezugszeichen |2| gekennzeichnete Signal FIR_poly_1_out dadurch aus, dass die Wortbreite ebenfalls 8 Bit pro Komponente beträgt und der Datentyp ebenfalls als komplexwertig zu betrachten ist, die Datenrate nunmehr auf B_Clock_4, d. h. auf ein Viertel des Maximaltaktes B_Clock, erhöht wurde.

Im ersten Mischer 704 erfolgt unter Verwendung des Parametersatzes 710 für den Parameter fs_shift_1 eine Frequenzumsetzung, wobei ein Unterschied zwischen einer Mittenfrequenz des durch das Bezugszeichen |2| gekennzeichneten Signals und einer Mittenfrequenz des durch das Bezugszeichen |3| gekennzeichneten Signals einem Viertel der Abtasttaktrate B_Clock_4 entspricht. Somit lässt sich sagen, dass das Signal mit dem Bezugszeichen |3| auf eine höhere Zwischenfrequenz verschoben wurde als das Signal FIR_poly_1_out, wobei eine Wortbreite des Signals fs_4_Mischer_1_out 8 Bit pro Komponente beträgt, der Datentyp komplexwertig ist und die Datenrate B_Clock_4 beträgt.

Weiterhin erfolgt im zweiten Polyphasenfilter 706 (das beispielsweise ebenfalls ein FIR-Filter umfasst) ein weiteres Überabtasten (Upsampling) derart, dass das mit dem Bezugszeichen |4| gekennzeichnete Signal FIR_poly_2_out bezeichnete Signal eine Abtastrate oder Datenrate von B_Clock (d. h. der in dem Mischer 600 maximal erreichbare Abtastrate) aufweist. Die Wortbreite des Signals FIR_poly_2_out beträgt hierbei ebenfalls 8 Bit pro I- und Q-Komponente, während der Datentyp dieses Signals ebenfalls komplexwertig ist. Anschließend erfolgt durch den zweiten Mischer 708, der ebenfalls ein Mischer mit einer Frequenzverschiebung um ein Viertel der zugeführten Abtastfrequenz ist, eine Frequenzumsetzung des Signals FIR_poly_2_out, das auch durch das Bezugszeichen |4| gekennzeichnet ist, in das Signal upsampling_out, das auch durch das Bezugszeichen |5| gekennzeichnet ist. Hierbei wird der Parametersatz 712 verwendet, der beispielsweise eine Richtung, in welche die Frequenzverschiebung erfolgen soll, kennzeichnet. Das Signal upsampling_out kann eine Wortbreite von 6 Bit pro I-und Q-Komponente aufweisen, die beispielsweise durch ein externes Upsampling-Filter vorgegeben ist. Die Datenrate des Signals upsampling_out beträgt B_Clock, während der Datentyp wiederum komplexwertig ist.

Nachfolgend wird die prinzipielle Funktionsweise des Blocks FIR_poly_1 (d. h. des ersten Polyphasenfilters 702) und des Blocks FIR_poly_2 (d. h. des zweiten Polyphasenfilters 706) näher beschrieben. Jeder dieser Blöcke sorgt im vorliegenden Ausführungsbeispiel für eine Vervierfachung der Abtastrate bei gleichzeitiger Beibehaltung der Signalbandbreite. Um ein Signal um den Faktor 4 überabzutasten, sind zwischen jedem Eingangssample drei Nullen einzufügen ("zero insertion" = Einfügung von Nullen). Die nun entstandene, "Zero-Inserted"-Sequenz wird durch ein Tiefpassfilter geschickt, um die Spiegelspektren bei Vielfachen der Eingangsabtastrate zu unterdrücken. Prinzipbedingt sind alle hier verwendeten Filter reell, d. h. weisen reellwertige Koeffizienten auf. Die zu filternden komplexen Daten können daher stets durch zwei parallele, gleiche Filter geschickt werden, insbesondere eine Aufteilung eines Signals in eine I-Komponente (d.h. einen Realteil des Signals) und eine Q-Komponente (d.h. einen Imaginärteil des Signals), die jeweils allein reellwertige Werte aufweisen, zeichnet sich in diesem Fall deutlich vereinfachend aus, da sich eine Multiplikationen von reellwertigen Eingangssignalen mit reellwertigen Filterkoeffizienten numerisch deutlich einfacher bewerkstelligen lassen, als Multiplikationen von komplexwertigen Eingangswerten mit komplexwertigen Filterkoeffizienten.

Einige bekannte Eigenschaften des Eingangssignals bzw. des zu filternden Spektrums können ausgenutzt werden, um den Rechenaufwand weiterhin zu minimieren. Insbesondere lassen sich durch eine Polyphasenimplementierung und eine Ausnutzung der Symmetrie von Teilfiltern der Polyphasenimplementierung Vorteile nutzen, wie nachfolgend näher erläutert wird.

Eine Polyphasenimplementierung lässt sich vorzugsweise einsetzen, da die Eingangssequenz nur an jeder vierten Stelle einen von 0 verschiedenen Wert aufweist, wie zuvor beschrieben wurde. Stellt man sich ein FIR-Filter in einer "Tapped-Delay-Line"-Struktur vor, so werden für die Berechnung jedes Ausgangswerts nur L/R Koeffizienten verwendet (L = FIR-Filterlänge, R = Überabtastfaktor). Die verwendeten Koeffizienten wiederholen sich periodisch nach genau R Ausgangswerten. Daher lässt sich ein solches FIR-Filter in R Teilfilter der Länge L/R zerlegen. Die Ausgänge der entsprechenden Filter brauchen dann lediglich in der richtigen Reihenfolge zu einem höherratigen Datenstrom gemultiplext werden. Weiterhin ist anzumerken, dass eine Realisierung des FIR-Filters, beispielsweise mit der Funktion "intfilt" des Software-Tools MATLAB, zu einer regelmäßigen Koeffizientenstruktur für das zweite Teilfilter führt (d. h. das zweite Teilfilter weist eine gerade Länge und eine Achsensymmetrie auf). Ferner lässt sich erkennen, dass sich das vierte Teilfilter näherungsweise auf ein einziges Verzögerungselement (Delay-Element) reduzieren lässt, wie nachfolgend ebenfalls näher gezeigt wird.

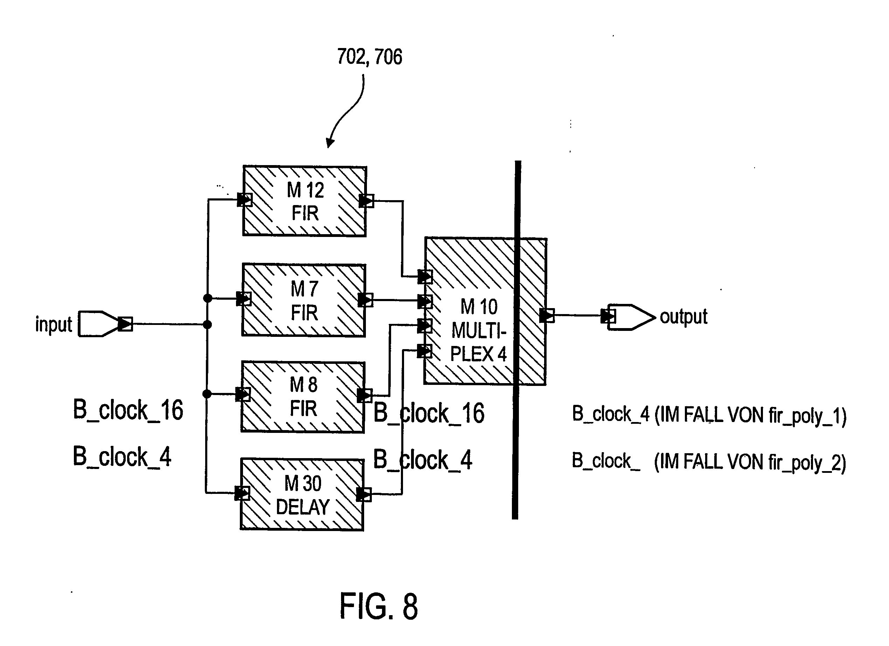

Ein Blockschaltbild einer konkreten Realisierung eines Polyphasenfilters, wie beispielsweise des ersten Polyphasenfilters 702 oder des zweiten Polyphasenfilters 706, ist in Fig. 8 exemplarisch wiedergegeben. Ein derartiges Polyphasenfilter umfasst einen Input, ein erstes FIR-Filter M12, ein zweites FIR-Filter M7, ein drittes FIR-Filter M8, ein Delay-Element M30, einen Vier-auf-Eins-Multiplexer M10 und einen Ausgang. Das erste FIR-Filter M12, das zweite FIR-Filter M7, das dritte FIR-Filter M8 sowie das Delay-Element M30 weisen jeweils einen Eingang und einen Ausgang auf, wobei der Eingang jedes der vier genannten Elemente mit dem Eingang input des Polyphasenfilters verbunden ist. Der Vier-auf-Eins-Multiplexer M10 weist vier Eingänge und einen Ausgang auf, wobei jeder der vier Eingänge mit einem Ausgang eines der FIR-Filter M12, M7, M8 oder dem Ausgang des Delay-Elements M30 verbunden ist. Ferner ist der Ausgang des Vier-auf-Eins-Multiplexers M10 mit dem Ausgang output des Polyphasenfilters verbunden. Ein Eingangsdatenstrom, der über den Eingang input des Polyphasenfilters 702 bzw. 706 demselben zugeführt wird, wird somit parallel auf vier FIR-Filter (d. h. nach Reduktion des Teilfilters 4 auf ein Delay-Element nur noch auf die drei FIR-Filter M12, M7 und M8) gegeben und danach wieder durch den Vier-auf-Eins-Multiplexer M10 gemultiplext. Durch diese Parallelisierung erreicht man eine Veränderung der Portraten zwischen dem Eingang input des Polyphasenfilters und dem Ausgang output des Polyphasenfilters um den Faktor 4.

Bei einer Verwendung der in Fig. 8 dargestellten Struktur für das erste Polyphasenfilter, d. h. das in Fig. 7 dargestellte Polyphasenfilter FIR_poly_1, bedeutet dies eine Erhöhung der Datenrate von B_Clock_16 auf B_Clock_4. Für den Fall der Verwendung der in Fig. 8 dargestellten Figur für das zweite Polyphasenfilter 706, d. h. dem in Fig. 7 dargestellten Filter FIR_poly_2, bedeutet dies eine Datenratenerhöhung von B_Clock_4 auf B_Clock. Ferner lässt sich anmerken, dass ein derartiges Filter, insbesondere die Filterkoeffizienten, beispielsweise mit dem Befehl coeff = intfilt (4, 6, 2/3) des Software-Tools MATLAB generiert werden kann.

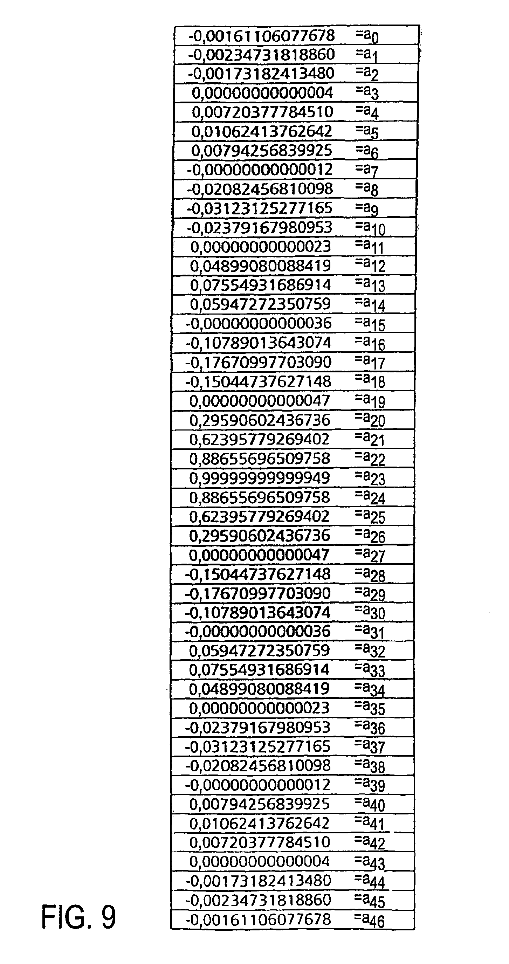

Fig. 9 zeigt eine tabellarische Darstellung von Filterkoeffizienten $a_0$ bis $a_{46}$, wie sie unter Anwendung des zuvor genannten Befehls mit dem Software-Tool MATLAB erhalten werden können. Den einzelnen Teilfiltern, d. h. dem ersten FIR-Filter M12, dem zweiten FIR-Filter M7, dem dritten FIR-Filter M8, sowie dem Delay-Element können nun verschiedene Koeffizienten des in Fig. 9 dargestellten Koeffizientensatzes der Filterkoeffizienten $a_0$ bis $a_{46}$ zugewiesen werden. Beispielsweise lassen sich dem ersten FIR-Filter M12 die Koeffizienten $a_0$, $a_4$, $a_8$, $a_{12}$, ... zuweisen. Dies kann wiederum unter Verwendung eines MATLAB-Befehls coeff1 = coeff(1:4:end) erfolgen. Dem zweiten FIR-Filter M7 können die Koeffizienten $a_1$, $a_5$, $a_9$, $a_{13}$, ... zugewiesen werden, wie dies beispielsweise mit dem MATLAB-Befehl coeff2 = coeff(2: 4:end) möglich ist. Dem dritten FIR-Filter M8 können beispielsweise die Koeffizienten $a_2$, $a_6$, $a_{10}$, $a_{14}$, ... zugewiesen werden, wie dies beispielsweise mit dem MATLAB-Befehl coeff3 = coeff(3:4:end) möglich ist. Dem vierten FIR-Filter (das aus nachstehend beschriebenen Gründen auf ein Delay-Element reduziert werden kann) können die Koeffizienten $a_3$, $a_7$, $a_{11}$, $a_{15}$, ... zugewiesen werden, wie dies beispielsweise mit dem MATLAB-Befehl coeff4 = coeff(4:4:end) möglich ist.

Wie aus der tabellarischen Darstellung in Fig. 9 ersichtlich ist, weisen die dem vierten Teilfilter zugewiesenen Koeffizienten näherungsweise den Wert 0 auf, ausgenommen den Koeffizienten $a_{23}$, der näherungsweise den Wert 1 aufweist. Aus diesem Grund kann unter Vernachlässigung der Koeffizienten, die näherungsweise den Wert 0 haben, das vierte Teilfilter auf eine Delay-Struktur überführt werden, da der Koeffizientensatz des vierten Teilfilters coeff4 nur an der Stelle 6 (sechstes Element des Koeffizientensatzes in MATLAB-Zählweise) mit einem Wert von näherungsweise 1 besetzt ist (siehe $a_{23}$). Daher kann dieser Block durch ein Delay-Element mit Delay = 5 ersetzt werden, was einem Verschieben des Eingangswertes um fünf Elemente entspricht. Ferner weist der Koeffizientensatz coeff2, der dem zweiten Teilfilter M7 zugeordnet ist, eine achsensymmetrische Struktur auf und hat eine gerade Länge, wodurch sich dieses FIR-Filter verkürzen lässt, um zumindest die Zahl der Multiplikationen zu halbieren.

Nachfolgend werden der Aufbau des ersten Mischers 704 sowie des zweiten Mischers 706 näher beschrieben, die den in Fig. 7 dargestellten Blöcken fs_4_Mischer_1 und fs_4_Mischer_2 entsprechen. Prinzipiell lässt sich anmerken, dass ein Mischer ein Signal im Spektralbereich um eine bestimmte Frequenz nach oben oder unten setzt. Die Verschiebung wird dabei stets auf die Abtastfrequenz bezogen. Ein $f_s$/4-Mischer z. B. verschiebt ein Eingangssignal um genau 25 % der Abtastfrequenz und gibt dieses im Frequenzbereich verschobene Signal als Ausgangssignal aus. Eine komplexe Mischung, d. h. eine Mischung eines komplexen Signals, geschieht durch Multiplikation mit einem komplexen Drehterm. Dieser lautet:

$$\texttt{dt[n] = exp[i*2*}\pi\texttt{*}\Delta\texttt{f/f}_s\texttt{*n) mit i = sqrt(-1).}$$

Bei einer Frequenzverschiebung von $\Delta$f = $f_s$/4 reduziert sich ein solcher $f_s$/4-Mischer zu einem einfachen Multiplikator unter Verwendung des Vektors [1; i; -1; -i]. Dies ist exemplarisch bereits in Fig. 5 dargestellt worden. Es lässt sich somit sagen, dass der erste, fünfte, neunte, ... Eingangswert stets mit 1 multipliziert wird, während der zweite, sechste, zehnte, ... Eingangswert stets mit i multipliziert wird. Der dritte, siebte, elfte, ... Eingangswert wird dann stets mit -1 multipliziert und der vierte, achte, zwölfte, ... Eingangswert wird stets mit -j multipliziert. Eine derartige Multiplikation resultiert in einer positiven Frequenzverschiebung.

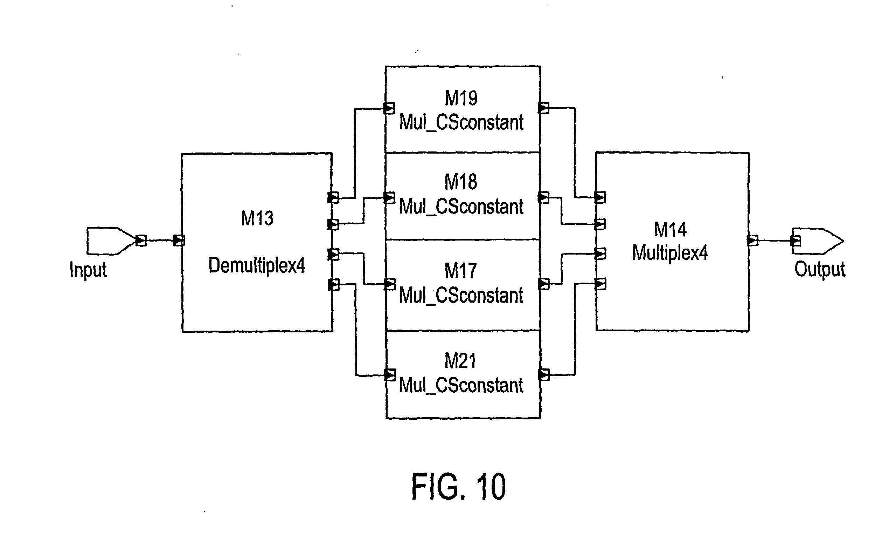

Wie oben ausgeführt wurde, lässt sich eine derartige $f_s$/4-Mischung durch vier einfache Operationen realisieren. Ähnlich wie bei einem Polyphasenfilter kann ein solcher Mischerblock, wie er in Fig. 7 als erster Mischer 704 und als zweiter Mischer 708 dargestellt ist, intern auf einem Viertel der Ausgangsdatenrate arbeiten. Ein derart ausgestalteter Mischer ist in Fig. 10 dargestellt. Ein solcher Mischer umfasst somit einen Mischereingang, als Input bezeichnet, einen Eins-auf-Vier-Demultiplexer M13, ein erstes Multiplikationselement M19, ein zweites Multiplikationselement M18, ein drittes Multiplikationselement M17, ein viertes Multiplikationselement M21, einen Vier-auf-Eins-Multiplexer M14 sowie einen Ausgang, der in Fig. 10 mit der Bezeichnung Output gekennzeichnet ist.

Der Eins-auf-Vier-Demultiplexer M13 umfasst einen Eingang, der mit dem Eingang Input verbunden ist. Ferner umfasst der Eins-auf-Vier-Demultiplexer vier Ausgänge. Die Multiplikationselemente M19, M18, M17 und M21 umfassen jeweils einen Eingang und einen Ausgang. Jeweils ein Eingang eines der Multiplikationselemente ist mit einem anderen Ausgang des Eins-auf-Vier-Demultiplexers M13 verbunden. Der Vier-auf-Eins-Multiplexer M14 umfasst vier Eingänge, wobei jeweils einer der Eingänge des Vier-auf-Eins-Multiplexers M14 mit einem anderen Ausgang eines der Multiplikationselemente verbunden ist. Weiterhin ist der Ausgang des Vier-auf-Eins-Multiplexers M14 mit dem Ausgang Output verbunden.

Empfängt nun ein solcher in Fig. 10 dargestellter Mischer an dessen Eingang Input ein Signal, wird dieses Signal in Blöcke von jeweils vier zusammenhängenden Signalwerten unterteilt, wobei jeweils ein Signalwert einem anderen der Multiplikationselemente M19, M18, M17 und M21 zugewiesen wird. In diesen Multiplikationselementen erfolgt eine nachfolgend näher charakterisierte Multiplikation, wobei das Ergebnis der Multiplikation über die Ausgänge der Multiplikationselemente dem Vier-auf-Eins-Multiplexer M14 zugeführt wird, der aus den zugeführten Werten einen seriellen Datenstrom generiert und diesen über den Ausgang Output ausgibt.

Die dem Mischer über dessen Eingang Input zugeführten Werte sind vorzugsweise komplexe Datenwerte, wobei jedem der Multiplikationselemente M19, M18, M17 und M21 ein komplexer Datenwert durch den Eins-auf-Vier-Demultiplexer M13 zugeführt wird. Für die Multiplikation in jedem der Multiplikationselemente wird nachfolgend eine Multiplikation mit einem Multiplikationsfaktor ausgeführt, wobei der Multiplikationsfaktor beispielsweise dem zuvor genannten Vektor [1; i; -1; -i] entspricht. Wird beispielsweise im ersten Multiplikationselement M19 eine Multiplikation mit dem ersten Koeffizienten des zuvor genannten Vektors (d. h. mit einem Koeffizienten von 1) ausgeführt, bedeutet dies, dass am Ausgang des ersten Multiplikationselements M19 direkt der am Eingang des ersten Multiplikationselements anliegende Wert ausgegeben wird. Wird beispielsweise am zweiten Multiplikationselement M18 eine Multiplikation mit dem zweiten Koeffizienten (d. h. mit i) ausgeführt, bedeutet dies, dass am Ausgang des zweiten Multiplikationselements M18 ein Wert anliegt, der folgendem Zusammenhang entspricht:

$$\text{Ausgang} = -\text{imag (Eingang)} + 1*\text{real (Eingang)},$$

wobei imag (Eingang) den Imaginärteil des Eingangswertes und real (Eingang) den Realteil des Eingangswertes kennzeichnet.

Wird beispielsweise im dritten Multiplikationselement eine Multiplikation mit dem dritten Koeffizienten des zuvor genannten Vektors (d. h. mit -1) durchgeführt, bedeutet dies, dass am Ausgang des dritten Multiplikationselements M17 ein Wert anliegt, der einen in bezug auf den am Eingang anliegenden Wert folgenden Zusammenhang annimmt:

$$\text{Ausgang} = -\text{real (Eingang)} - i*\text{imag (Eingang)}.$$

Wird ferner im vierten Multiplikationselement M21 eine Multiplikation unter Verwendung des vierten Koeffizienten (d. h. mit -i) als Multiplikationsfaktor durchgeführt, bedeutet dies, dass am Ausgang des vierten Multiplikationselements M21 ein Wert ausgegeben wird, der unter Berücksichtigung eines am Eingang des vierten Multiplikationselements anliegenden Werts in folgendem Zusammenhang steht:

$$\text{Ausgang} = \text{imag (Eingang)} - i*\text{real (Eingang)}.$$

Je nach Vorgabe des in Fig. 7 dargestellten Parameterwertes fs_shift_1, der dem ersten Mischer zugeführt wird, oder dem zweiten Parametersatz 712 mit dem Parameterwert fs_shift_2, der dem zweiten Mischer 708 zugeführt wird, wird ein spezieller Vektor ausgewählt, der die einzelnen Konstanten vorgibt. Für den Fall, dass beispielsweise fs_shift_x (mit x= 1 oder 2) zu -1 gewählt wird, d. h. dass eine negative Frequenzverschiebung durchgeführt werden soll, ist ein Vektor zu wählen, der die folgende Koeffizientenabfolge aufweist: [1, -i, -1, i].

Für den Fall, dass der Parameter fs_shift_x zu 0 gewählt wird, d. h. dass keine Frequenzverschiebung im Mischer erfolgen soll, ist ein Koeffizientenvektor mit einer Koeffizientenabfolge von [1, 1, 1, 1] zu wählen, während für den Fall, dass der Parameter fs_shift_x zu 1 gewählt wird (d. h. dass eine positive Frequenzverschiebung erfolgen soll), ein Vektor mit einer Koeffizientenabfolge von [1, i, -1, -i] gewählt wird. Aus den vorstehenden Erläuterungen ergibt sich ebenfalls, dass der erste Parametersatz 710 und der zweite Parametersatz 712 voneinander verschieden gewählt werden können, je nachdem, welche der unterschiedlichen Zielfrequenzen erreicht werden soll.

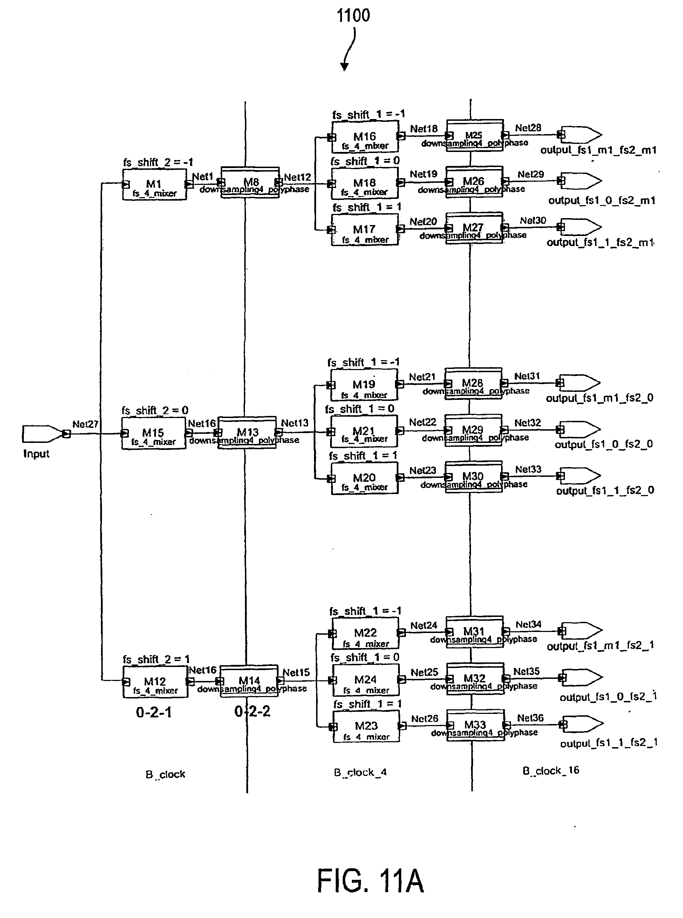

Im folgenden wird näher auf das Downsampling eingegangen, wie es beispielsweise bei der Frequenzumsetzung im Empfänger von einer hohen Aktuellfrequenz in eine niedrige Zielfrequenz erfolgt. Hierzu zeigt Fig. 11A ein Blockschaltbild einer Mischerstufe, wie sie beispielsweise in einem Empfänger verwendet werden kann. Die Mischerstufe 1100 umfasst einen Eingang Input, einen ersten Mischer M1, einen zweiten Mischer M15 und einen dritten Mischer M12, die parallel in einer ersten Mischerebene 0-2-1 angeordnet sind. Ferner umfasst der Mischer 1100 ein erstes Downsampling-Polyphasenfilter M8, ein zweites Downsampling-Polyphasenfilter M13, ein drittes Downsampling-Polyphasenfilter M14, einen vierten Mischer M16, einen fünften Mischer M18, einen sechsten Mischer M17, einen siebten Mischer M19, einen achten Mischer M21, einen neunten Mischer M20, einen zehnten Mischer M22, einen elften Mischer M24 und einen zwölften Mischer M23. Zusätzlich umfasst der Mischer 1100 ein viertes Downsampling-Polyphasenfilter M25, ein fünftes Downsampling-Polyphasenfilter M26, ein sechstes Downsampling-Polyphasenfilter M27, ein siebtes Downsampling-Polyphasenfilter M28, ein achtes Downsampling-Polyphasenfilter M29, ein neuntes Downsampling-Polyphasenfilter M30, ein zehntes Downsampling-Polyphasenfilter M31, ein elftes Downsampling-Polyphasenfilter M32 und ein zwölftes Downsampling-Polyphasenfilter M33.

Ferner umfasst der Mischer 1100 einen ersten Ausgang output_fs1_m1_fs2_m1, einen zweiten Ausgang output_fs1_0_fs2_m1, einen dritten Ausgang output_fs1_1_fs2_m1, einen vierten Ausgang output_fs1_m1_fs2_0, einen fünften Ausgang output_fs1_0_fs2_0, einen sechsten Ausgang output_fs1_1_fs2_0, einen siebten Ausgang output_fs1_m1_fs2_1, einen achten Ausgang output_fs1_0_fs2_1, einen neunten Ausgang output_fs1_1_fs2_1.

Alle Komponenten des beschriebenen Mischers 1100 (bis auf den Eingang Input und die Ausgänge output_...) umfassen jeweils einen Eingang und einen Ausgang. Der Eingang des ersten Mischers M1, des zweiten Mischers M15 und des dritten Mischers M12 sind über das Signal Net27 mit dem Eingang Input des Mischers 1100 verbunden. Der Ausgang des ersten Mischers M1 ist über das Signal Net1 mit dem Eingang des ersten Downsampling-Polyphasenfilters M8 verbunden. Der Ausgang des ersten Polyphasenfilters M8 ist über das Signal Net12 mit den Eingängen des vierten Mischers M16, des fünften Mischers M18 und des sechsten Mischers M17 verbunden. Der Ausgang des vierten Mischers M16 ist über das Signal Net18 mit dem Eingang des vierten Downsampling-Polyphasenfilters M25 verbunden, während der Ausgang des vierten Downsampling-Polyphasenfilters M25 über das Signal Net28 mit dem ersten Ausgang des Mischers 1100 verbunden ist. Der Ausgang des fünften Mischers M18 ist über das Signal Net19 mit dem Eingang des fünften Downsampling-Polyphasenfilters M26 verbunden, während der Ausgang des fünften Downsampling-Polyphasenfilters M26 über das Signal Net29 mit dem zweiten Ausgang des Mischers 1100 verbunden ist. Der Ausgang des sechsten Mischers M17 ist über das Signal Net20 mit dem Eingang des sechsten Downsampling-Polyphasenfilters M27 verbunden, während der Ausgang des sechsten Downsampling-Polyphasenfilters M27 über das Signal Net30 mit dem dritten Ausgang des Mischers 1100 verbunden ist.

Der Ausgang des zweiten Mischers ist über das Signal Net16 mit dem Eingang des zweiten Downsampling-Polyphasenfilters M13 verbunden. Der Ausgang des zweiten Downsampling-Polyphasenfilters M13 ist über das Signal Net13 mit den Eingängen des siebten Mischers M19, des achten Mischers M21 und des neunten Mischers M20 verbunden. Der Ausgang des siebten Mischers M19 ist über das Signal Net21 mit dem Eingang des siebten Downsampling-Polyphasenfilters M28 verbunden, während der Ausgang des siebten Downsampling-Polyphasenfilters M28 über das Signal Net31 mit dem vierten Ausgang verbunden ist. Der Ausgang des achten Mischers M21 ist über das Signal Net22 mit dem Eingang des achten Downsampling-Polyphasenfilters M29 verbunden, während der Ausgang des achten Downsampling-Polyphasenfilters M29 über das Signal Net32 mit dem fünften Ausgang verbunden ist. Der Ausgang des neunten Mischers M20 ist über das Signal Net23 mit dem Eingang des neunten Downsampling-Polyphasenfilters M30 verbunden, während der Ausgang des neunten Downsampling-Polyphasenfilters M30 über das Signal Net33 mit dem sechsten Ausgang verbunden ist.

Der dritte Mischer M12 ist über das Signal Net16 mit dem Eingang des dritten Downsampling-Polyphasenfilters M14 verbunden. Der Ausgang des dritten Downsampling-Polyphasenfilters M14 ist über das Signal Net15 mit den Eingängen des zehnten Mischers M22, des elften Mischers M24 und des zwölften Mischers M23 verbunden. Der Ausgang des zehnten Mischers M22 ist über das Signal Net24 mit dem zehnten Downsampling-Polyphasenfilter M31 verbunden, während der Ausgang des zehnten Downsampling-Polyphasenfilters M31 über das Signal Net34 mit dem siebten Ausgang verbunden ist. Der Ausgang des elften Mischers M24 ist über das Signal Net25 mit dem Eingang des elften Downsampling-Polyphasenfilters M32 verbunden, während der Ausgang des elften Downsampling-Polyphasenfilters M32 über das Signal Net35 mit dem achten Ausgang verbunden ist. Der Ausgang des zwölften Mischers M23 ist über das Signal Net26 mit dem Eingang des zwölften Downsampling-Polyphasenfilters M33 verbunden, während der Ausgang des zwölften Downsampling-Polyphasenfilters M33 über das Signal Net36 mit dem neunten Ausgang verbunden ist.

Ferner sind die Ausgänge des Mischers 1100 mit folgenden Komponenten verbunden:

output_fs1_m1_fs2_m1 mit dem Ausgang des vierten Downsampling-Polyphasenfilters M25
output_fs1_0_fs2_m1 mit dem Ausgang des fünften Downsampling-Polyphasenfilters M26
output_fs1_1_fs2_m1 mit dem Ausgang des sechsten Downsampling-Polyphasenfilters M27
output_fs1_m1_fs2_0 mit dem Ausgang des siebten Downsampling-Polyphasenfilters M28
output_fs1_0_fs2_0 mit dem Ausgang des achten Downsampling-Polyphasenfilters M29
output_fs1_1_fs2_0 mit dem Ausgang des neunten Downsampling-Polyphasenfilters M30
output_fs1_m1_fs2_1 mit dem Ausgang des zehnten Downsampling-Polyphasenfilters M31
output_fs1_0_fs2_1 mit dem Ausgang des elften Downsampling-Polyphasenfilters M32
output_fs1_1_fs2_1 mit dem Ausgang des zwölften Downsampling-Polyphasenfilters M33.

Analog zu dem in Fig. 7 dargestellten Mischer werden in dem in Fig. 11A dargestellten Mischer 1100 ebenfalls drei unterschiedliche Taktfrequenzen eingesetzt. Zum ersten liegt dem am Eingang Input empfangenen Signal eine Abtastfrequenz von B_Clock zugrunde, wobei der erste Mischer M1, der zweite Mischer M15 und der dritte Mischer M12 mit der Abtastfrequenz B_Clock arbeiten. Nachfolgend erfolgt in der Ebene 0-2-2, d. h. durch das erste Downsampling-Polyphasenfilter M8, das zweite Downsampling-Polyphasenfilter M13 und das dritte Downsampling-Polyphasenfilter M14 eine Abtastratenreduktion auf eine neue Abtastrate von B_Clock_4, die einem Viertel der Abtastrate B_Clock entspricht. Dies bedeutet, dass der vierte bis zwölfe Mischer mit einer Abtastrate von B_Clock_4 arbeiten. Nachfolgend wird durch das vierte bis zwölfte Downsampling-Polyphasenfilter eine weitere Abtastratenreduktion auf eine erneute Abtastrate von B_Clock_16, d. h. wiederum eine Viertelung der in dem vierten bis zwölften Mischer verwendeten Abtastrate, verwendet, was einer sechzehntel Abtastfrequenz des am Eingang Input anliegenden Signals entspricht.

Durch die in Fig. 11A dargestellte Mischerstruktur 1100 lassen sich somit gleichzeitig aus dem am Eingang Input des Mischers 1100 empfangenen Signal neun Teilfrequenzbänder extrahieren. Hierzu ist es notwendig, dass die drei Mischer der Ebene 0-2-1 jeweils auf ein anderes Mischungsverhalten eingestellt sind, dass beispielsweise der erste Mischer M1 auf eine Abwärtsmischung, der zweite Mischer M15 auf eine neutrale Frequenzumsetzung (d.h. keine Frequenzverschiebung) und der dritte Mischer M12 auf eine Aufwärtsmischung eingestellt sind. Ferner sollten auch diejenigen Mischer, die mit der Abtastrate B_Clock_4 arbeiten (d. h. insbesondere der vierte bis zwölfte Mischer), zu jeweils drei Mischern gruppiert werden, wobei jede Mischergruppe jeweils einem der Downsampling-Polyphasenfilter der Strukturebene 0-2-2 nachgeschaltet ist. Jeder der drei Mischer einer Mischergruppe (d. h. beispielsweise des vierten, fünften und sechsten Mischers) sollte wiederum voneinander unterschiedlich eingestellt sein, so dass beispielsweise der vierte Mischer wiederum eine Abwärtsmischung, der fünfte Mischer keine Frequenzumsetzung und der sechste Mischer eine Aufwärtsmischung durchführen können. Für die Gruppe des siebten bis neunten Mischers sowie die Gruppe des zehnten bis zwölften Mischers gilt dies analog.

Durch eine solche kaskadierte und zugleich parallel geschaltete Mischeranordnung lassen sich somit zugleich die neun Frequenzbänder aus dem am Eingang Input des Mischers 1100 anliegenden Signal extrahieren, so wie es beispielsweise in Fig. 2 dargestellt ist. Ein Vorteil einer solchen parallelen und kaskadierten Anordnung liegt dann insbesondere darin, dass erstens durch eine numerisch oder schaltungstechnisch einfach umzusetzende Struktur eine Vielzahl von Teilfrequenzbändern zugleich aufgelöst bzw. empfangen werden kann.

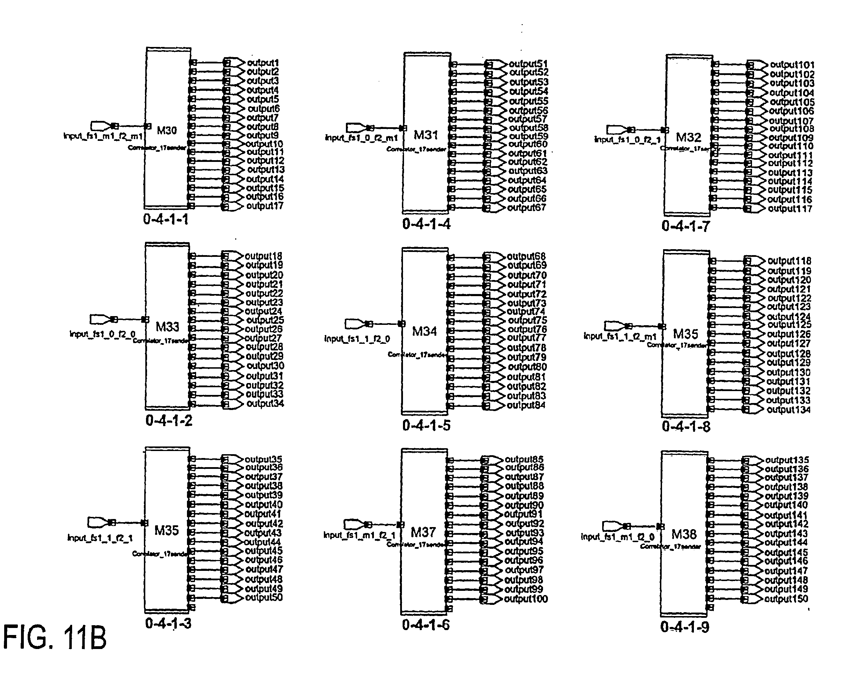

Sollen nun die einzelnen Teilfrequenzbänder, wie sie in Fig. 11A als Ausgangssignale dargestellt sind, mit Daten beaufschlagt werden, können auf den einzelnen Frequenzbändern auch mehrere Signale von unterschiedlichen Bändern übertragen werden, wenn diese geeignet miteinander korreliert werden. Hier zeigt die Fig. 11B 9 Korrelatoren 0-4-1-1 bis 0-4-1-9, die den entsprechenden Ausgangssignalen des in Fig. 11A dargestellten Mischers 1100 darstellen. Hierbei sind die entsprechenden Ausgangssignale output_fs1_m1_fs2_m1 bis output_fs1_1_fs2_1 als Eingangssignale input_fs1_m1_fs2_m1 bis input_fs1_m1_fs_0 zu betrachten. Jeder der Korrelatoren 0-4-1-1 bis 0-4-1-9 hat einen Eingang und 17 Ausgänge, wobei jeder der Ausgänge ein Ausgangssignal output1 bis output150 ausgibt, das sich von den anderen Ausgangssignalen unterscheidet. Durch einen derartigen Aufbau können beispielsweise 150 Referenz-Sequenzen von 150 Sendern auf die neun zur Verfügung stehenden Frequenzbänder aufgeteilt werden. Eine Trennung der einzelnen Referenz-Sequenzen der Sender auf einem Frequenzband kann in diesem Fall über die Durchführung einer Korrelation erfolgen, wobei die erhaltenen 150 Korrelationssignale später dazu benutzt werden können, um beispielsweise Positionen von 150 Tracking-Bursts grob zu bestimmen.

Falls nur ein Frequenzband existieren würde, in dem die 150 Sender liegen, würden 150 verschiedene Referenz-Sequenzen zur Unterscheidbarkeit der einzelnen Sender benötigt. Da die Sender aber auf 9 verschiedene Frequenzbänder aufgeteilt sind, wären theoretisch nur $\left\lceil \frac{150}{9} \right\rceil = 17$ Sequenzen nötig, wobei 6 Frequenzbänder jeweils 17 Sender und 3 Frequenzbänder (die durch die Korrelatoren 0-4-1-3, 0-4-1-6 und 0-4-1-9 belegt werden) nur jeweils 16 Sender beinhalten.

Unter der Annahme, dass die Frequenzbänder für ihre 17 bzw. 16 Sender dieselben Referenz-Sequenzen besitzen, tritt bei einer Simulation eines derartigen Übertragungs-Szenarios folgendes Problem auf:

Es wurden zwei Aquisitions-Bursts ohne gegenseitige Überlappung und ohne Rauschen gesendet, wobei die beiden Aquisitions-Bursts in zwei verschiedenen Frequenzbändern lagen, aber gleiche Referenz-Sequenzen besaßen. Bei bestimmter Wahl der beiden Frequenzbänder wurden bei der Korrelation mit einer Sequenz fälschlicherweise auch Peaks des zweiten gesendeten Bursts detektiert. Und zwar sind das genau die Frequenzbänder, bei denen eine der beiden Rotationsparameter fs_shift_1 oder fs_shift_2 übereinstimmt, denn in diesen Fällen wird das Spiegelspektrum eines Frequenzbandes in den Bereichen der anderen dazugehörigen Frequenzbänder nicht genügend unterdrückt.

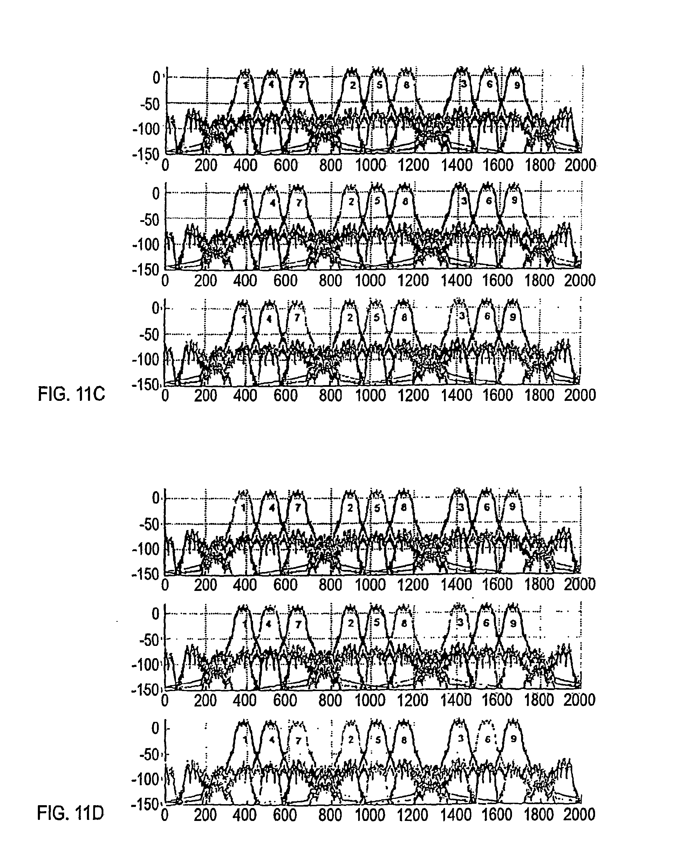

Es gibt zwei Möglichkeiten jeweils drei Frequenzbänder zusammenzufassen, die keinen gemeinsamen Rotationsparameter besitzen und für die damit die gleichen Sequenzen verwendet werden können, ohne dass eine falsche Detektion auftritt (siehe Fig. 11C und Fig. 11D).

Man benötigt also statt 17 Sequenzen 150 / 3 = 50 Sequenzen.

Die gleichen Sequenzen können folgenden Sequenz-Trippeln gegeben werden:

- 1 (fs_shift_1 = -1, fs_shift_2 = -1), 6 (fs_shift_1 = 0, fs_shift_2 = 1), 8 (fs_shift_1 = 1, fs_shift_2 = 0) (siehe Fig. 11C oberstes Teildiagramm ) oder

- 2 (fs_shift_1 = -1, fs_shift_2 = 0), 4 (fs_shift_1 = fs_shift_1 = 0, fs_shift_2 = -1), 9 (fs_shift_1 = 1, fs_shift_2 = 1) (siehe Fig. 11C mittleres Teildiagramm) oder

- 3 (fs_shift_1 = -1, fs_shift_2 = 1), 5 (fs_shift_1 = 0, fs_shift_2 = 0), 7 (fs_shift_1 = -1, fs_shift_2 = -1) (siehe Fig. 11C unterstes Teildiagramm).

oder alternativ können die gleichen Sequenzen den folgenden Frequenz-Trippeln gegeben werden:

- 1(fs_shift_1 = -1, fs_shift_2 = -1), 5 (fs_shift_1 = 0, fs_shift_2 = 0), 9 fs_shift_1 = 1, fs_shift_2 = 1) (siehe Fig. 11D oberstes Teildiagramm ) oder

- 3(fs_shift_1 = -1, fs_shift_2 = 1), 4 (fs_shift_1 = 0, fs_shift_2 = -1), 8 (fs_shift_1 = 1, fs_shift_2 = 0) (siehe Fig. 11D mittleres Teildiagramm ) oder

- 2(fs_shift_1 = -1, fs_shift_2 = 0), 6 (fs_shift_1 0, fs_shift_2 = 1), 7 (fs_shift_1 = -1, fs_shift_2 = -1) (siehe Fig. 11D unterstes Teildiagramm )

Die beiden Figuren 11C und 11D zeigen auf diese Weise zwei Möglichkeiten, jeweils drei Frequenzen mit den gleichen Sequenzen zu besetzen. In den Korrelatoren aus Fig. 11B wurde die zweite Möglichkeit gewählt, so dass die gleichen Korrelationssequenzen in die Blöcke 0-4-1-1 bis 0-1-3 bzw. in den Blöcken 0-4-1-4 bis 0-4-1-6 bzw. in den Blöcken 0-4-1-7 bis 0-4-1-9 verwendet werden. Mit Ausnahme der Eingangssignale in den unterschiedlichen Korrelationssequenzen ist der Aufbau der Blöcke 0-4-1-1 bis 0-4-1-9 identisch. Da die Korrelation nach dem Matched Filter vollzogen wird, besitzen die Korrelationssequenzen im binären Fall nur die Koeffizienten 1 und -1. Für den quaternären Fall lauten die Koeffizienten 1+j, -1+j, 1-j und -1-j. In beiden Fällen müssen die Korrelationssequenzen also im Abtasttakt B_clock_48 vorliegen.

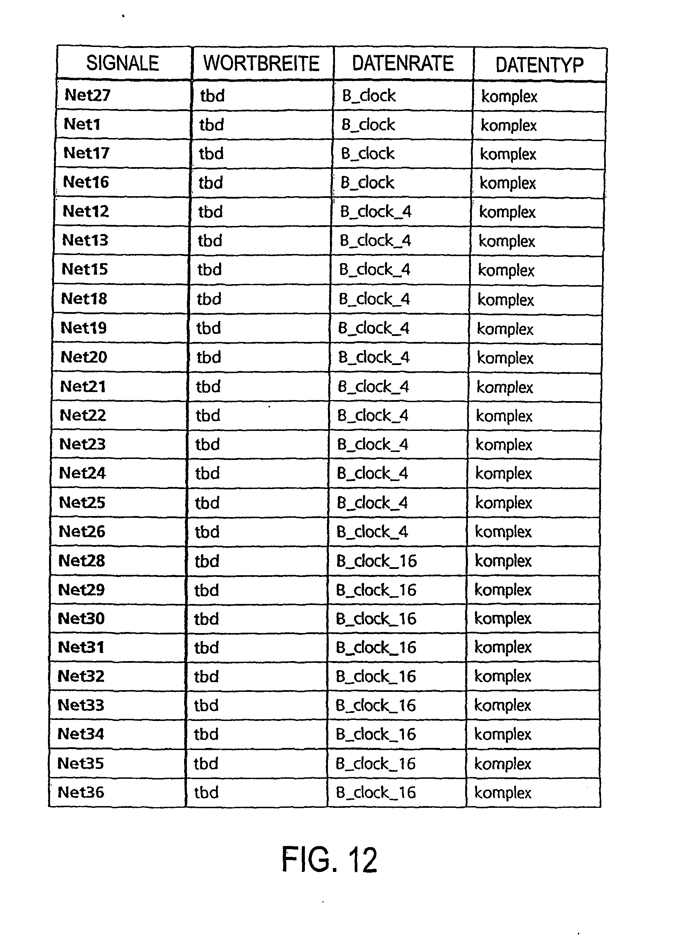

Fig. 12 zeigt eine tabellarische Darstellung der Wortbreite, Datenrate und des Datentyps der in Fig. 11A dargestellten Signale, wobei anzumerken ist, dass die Wortbreite der entsprechenden Signale abhängig von den verwendeten Hardwarekomponenten definiert werden kann (tbd = to be define = noch zu definieren). Für die Signalwerte aller Signale wird ein komplexer Datentyp angenommen.

Zunächst wird ein Signal, das mit einem Abtasttakt B_Clock vom Mischer 1100 empfangen wird unter Verwendung des Parameters fs_shift_2 (d. h. mit den Parameterwerten fs_shift_2 = -1, 0, 1) entsprechend um ein Viertel der Abtastfrequenz $f_s$ heruntergemischt, nicht frequenzumgesetzt oder um ein Viertel der Abtastfrequenz $f_s$ heraufgemischt, wodurch drei verschiedene Signale erhalten werden. Eine genauere Definition des Parameters fs_shift_2 wurde vorstehend diskutiert. Aus dem Signal Net1 wird somit, wie im Blockschaltbild aus Fig. 11A gezeigt ist, das Eingangssignals Net27 mit fs_shift_2 = -1, das Signal Net17 mit fs_shift_2 = 0 und das Signal Net16 mit fs_shift_2 = 1 gemischt. Diese drei Signale werden dann getrennt tiefpassgefiltert und unterabgetastet, wodurch drei Signale mit einem Sampletakt B_Clock_4 erhalten werden.

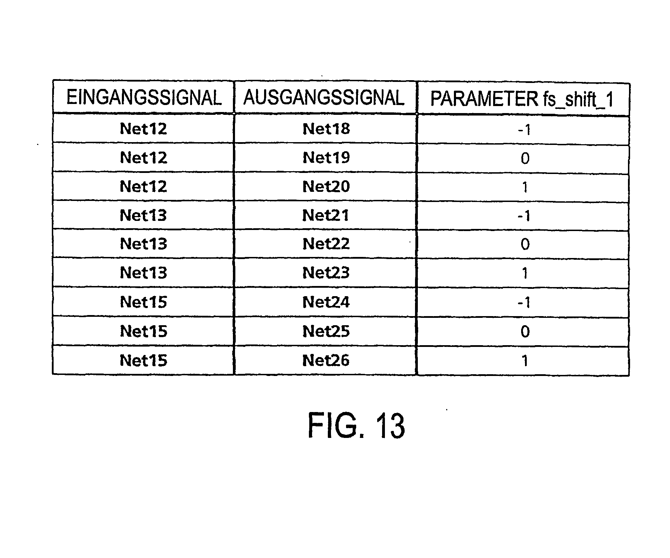

Anschließend werden diese Signale jeweils unter Verwendung des Parameters fs_shift_1 (d. h. der Parameterwerte fs_shift_1 = -1, 0, 1) noch einmal frequenzumgesetzt, wobei nunmehr der Versatz der umgesetzten Frequenz einem Viertel der neuen Abtastfrequenz (in positive und negative Richtung) entspricht oder gleich 0 ist. Die Eingangssignale Net12, Net13 und Net15 werden dabei gemäß der Tabelle in Fig. 13 mit dem Parameter fs_shift_1 gemischt, um die Ausgangssignale Net18, Net19, Net20, Net21, Net22, Net23, Net24, Net25 und Net26 zu erhalten. Schließlich werden die neun resultierenden Signale tiefpassgefiltert und unterabgetastet und somit bei einem Sampletakt von B_Clock_16 über den ersten bis neunten Ausgang nach außen geführt.

Im folgenden wird wieder kurz die Funktionsweise der Mischer am Beispiel der Mischer in der Ebene 0-2-1 sowie der Downsampling-Polyphasenfilter anhand der Downsampling-Polyphasenfilter in der in Fig. 11A dargestellten Ebene 0-2-2 erläutert. Die Mischer in der Ebene 0-2-1 machen das im Sender erfolgte Verschieben des jeweils anliegenden Signals um genau 25 % seiner Abtastfrequenz wieder rückgängig. Die komplexe Mischung geschieht wiederum durch Multiplikation mit einem komplexen Drehterm. Dieser lautet:

$$\mathtt{dt[n] = exp[j*2*\pi*\Delta f/f_s*n)\ mit\ j = sqrt(-1).}$$

Mit einem $\Delta f = -f_s/4$-Mischer reduziert sich dieser Vektor zu [1; -j; -1; j]. Dies bedeutet, dass der erste, fünfte, neunte, ... Eingangswert stets mit -1 multipliziert wird, der zweite, sechste, zehnte, ... Eingangswert stets mit -j multipliziert wird, der dritte, siebte, elfte, ... Eingangswert wird stets mit -1 multipliziert wird und der vierte, achte, zwölfte, ... Eingangswert stets mit j multipliziert wird. Wie aus der obigen Beschreibung zu entnehmen ist, lässt sich diese $-f_s/4$-Mischung durch vier einfache Operationen realisieren. Ähnlich wie bei einem Polyphasenfilter kann dieser Block intern auf einem Viertel der Ausgangsdatenrate arbeiten. Der Aufbau und die Funktion eines solchen $f_s/4$-Mischers ist bereits in Fig. 10 und der hierzu entsprechenden Beschreibung näher dargelegt. Ein solcher dort beschriebener Mischer kann auch für eine Mischung im Empfänger verwendet werden, wenn die Parameter fs_shift_1 und fs_shift_2 sowie die Umsetzung der Abtastrate geeignet gewählt werden.

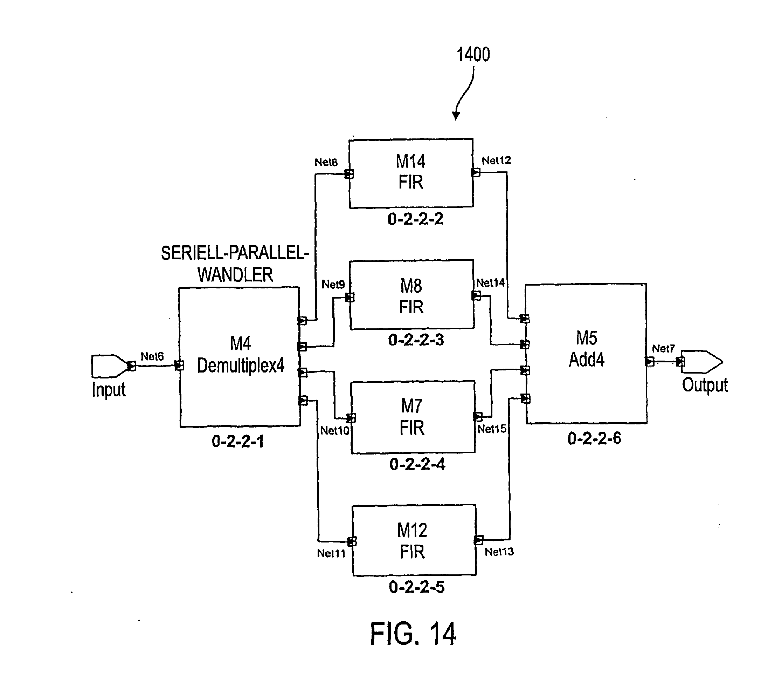

In dem nachfolgenden Abschnitt wird detaillierter auf die konkrete Umsetzung der Downsampling-Polyphasenfilter in der in Fig. 11A dargestellten Ebene 0-2-2 eingegangen. Mit diesen Downsampling-Polyphasenfiltern in der Ebene 0-2-2 wird eine Unterabtastung des Signals zunächst auf den Takt B_Clock_4 und nach dem zweiten $-f_s/4$-Mischen eine Unterabtastung auf den Takt B_Clock_16 erreicht. Bei den in diesem Ausführungsbeispiel vorliegenden Unterabtastungen um den Faktor 4 wird das jeweils anliegende Signal mit einem Tiefpass gefiltert, um auftretende Spiegelspektren zu unterdrücken und danach nur jedes vierte Sample weiterzugeben. Im wesentlichen entspricht der Aufbau eines Downsampling-Polyphasenfilters dem Aufbau eines in Fig. 8 dargestellten Polyphasenfilters, bei dem ein Upsampling durchgeführt wird; an dieser Stelle sollen einige Details vertieft erläutert werden. Hierzu ist in Fig. 14 ein Blockschaltbild einer exemplarischen Struktur eines Downsampling-Polyphasenfilters dargestellt, wie es in der in Fig. 11A dargestellten Ebene 0-2-2 verwendet werden kann.

Fig. 14 zeigt somit ein Downsampling-Polyphasenfilter 1400, das einen Eingang Input, einen Eins-auf-Vier-Demultiplexer 0-2-2-1 (Seriell-Parallel-Wandler), ein erstes FIR-Filter 0-2-2-2, ein zweites FIR-Filter 0-2-2-3, ein drittes FIR-Filter 0-2-2-4, ein viertes FIR-Filter 0-2-2-5, einen Addierer 0-2-2-6 und einen Ausgang Output aufweist. Jedes der FIR-Filter 0-2-2-2 bis 0-2-2-5 umfasst jeweils einen Eingang und einen Ausgang. Ein Eingang des Eins-auf-Vier-Demultiplexers 0-2-2-1 ist über das Signal Net6 mit dem Eingang Input des Downsampling-Polyphasenfilters 1400 verbunden. Ein erster Ausgang des Demultiplexers M4 ist über das Signal Net8 mit dem Eingang des ersten FIR-Filters M14 verbunden. Ein zweiter Ausgang des Demultiplexers M4 ist über das Signal Net9 mit dem zweiten FIR-Filter M8 verbunden. Ein dritter Ausgang des Demultiplexers M4 ist über das Signal Net10 mit dem dritten FIR-Filter M7 verbunden und ein vierter Ausgang des Demultiplexers M4 ist über das Signal Net11 mit dem Eingang des vierten FIR-Filters M12 verbunden. Ferner ist ein erster Eingang des Addierers M5 über das Signal Net12 mit dem Ausgang des ersten FIR-Filters M14, ein zweiter Eingang des Addierers M5 über das Signal Net14 mit dem zweiten FIR-Filter M8, ein dritter Eingang des Addierers M5 mit dem Ausgang des dritten FIR-Filters M7 und ein vierter Eingang des Addierers M5 über das Signal Net13 mit dem Ausgang des vierten FIR-Filters M12 verbunden. Zusätzlich ist ein Ausgang des Addierers M5 über das Signal Net7 mit dem Ausgang Output des Downsampling-Polyphasenfilters 1400 verbunden.

Wie sich aus Fig. 14 zeigt ist, kann ein in der Ebene 0-2-2 benötigtes Tiefpassfilter mit Hilfe eines Polyphasenansatzes realisiert werden, denn ein FIR-Filter der Länge L lässt sich in R Teilfilter der Länge L/R zerlegen, wobei L die FIR-Filterlänge und R den Überabtastfaktor eines Signals angibt. Dazu wird das dem Downsampling-Polyphasenfilter 1400 über dessen Eingang Input zugeführte Signal im Demultiplexer M4 in R = 4 parallele Signalströme aufgeteilt und damit der anliegende Sampletakt geviertelt (d. h. von beispielsweise einem Sampletakt von B_Clock auf B_Clock_4 gebracht bzw. von B_Clock_4 auf B_Clock_16 gebracht). Die einzelnen Signalströme (d. h. die Signale Net8 - Net11) werden danach mit jeweils einem FIR-Filter der Länge L/4 gefiltert und die Ergebnisse über die Signale Net12 - Net15 an den Addierer M5 übertragen. Im Addierer M5 erfolgt eine Summation der Signalwerte der Signale Net12 - Net15.

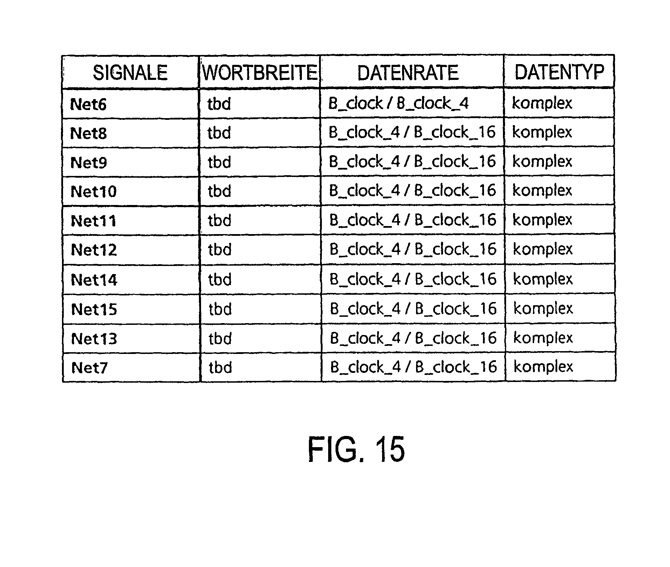

Eine Wortbreite, eine Datenrate und ein Datentyp der in Fig. 14 dargestellten Signale kann der tabellarischen Darstellung der Fig. 15 entnommen werden. Hierbei ist anzumerken, dass eine Wortbreite von den verwendeten Hardwarekomponenten (insbesondere einer Wortbreite eines am Frontend des Empfängers verwendeten Analog-Digital-Wandlers) abhängt. Aus diesem Grund kann gesagt werden, dass die Wortbreite je nach Verwendung der Hardwarekomponente noch zu definieren ist (d. h. in der Spalte "Wortbreite" die Bezeichnung tbd eingefügt ist). In bezug auf die Datenrate lässt sich sagen, dass das in Fig. 14 dargestellte Downsampling-Polyphasenfilter invers zu dem in Fig. 8 dargestellten Filter arbeitet, wodurch sich die Reduktion der Abtastrate des Signals Net6 in bezug auf die Abtastraten der Signale Net7 - Net15 erklären lässt. In bezug auf den Datentyp ist anzumerken, dass jedes der dargestellten Signale als komplexes Signal aufzufassen ist.

In bezug auf die Wahl der Filterkoeffizienten für die einzelnen Filter (d. h. das erste FIR-Filter M14, das zweite FIR-Filter M8, das dritte FIR-Filter M7 und das vierte FIR-Filter M12) wird auf die Ausführungen in bezug auf das in Fig. 8 dargestellte Filter verwiesen, wobei insbesondere die Filterkoeffizienten gemäß der tabellarischen Darstellung in Fig. 9 gewählt werden können. Ferner kann wiederum das vierte FIR-Filter M12 aus den zuvor genannten Gründen als Delay-Element mit einem Delay von 5 Abtastwerten gewählt werden (d. h. das vierte FIR-Filter M12 kann derart ausgestaltet sein, dass lediglich ein Verschieben des empfangenen Eingangswerts um fünf Elemente erfolgt). Ebenfalls kann das zweite FIR-Filter M8 aufgrund der achsensymmetrischen Struktur und der geraden Filterlänge verkürzt werden, um zumindest die Zahl der Multiplikationen zu halbieren.

Im nachfolgenden Abschnitt soll ein weiteres Ausführungsbeispiel des erfindungsgemäßen Ansatzes der Reduktion der Abtastrate bzw. der Samplingrate (d. h. der Downconversion) näher erläutert werden. Hierzu wird als Beispiel eine Abtastratenreduktion um den Ratenfaktor 4 sowie eine Filterung mit einem FIR-Filter mit sechs Koeffizienten ($a_0$,

$a_1$, $a_2$, $a_3$, $a_4$ und $a_5$) gewählt. Als Eingangsfolge wird die Signalwertefolge $x_9$, $x_8$, $x_7$, $x_6$, $x_5$, $x_4$, $x_3$, $x_2$, $x_1$ und $x_0$ verwendet, wobei $x_0$ das erste empfangene Signal oder das erste Sample (= der erste Abtastwert) ist.

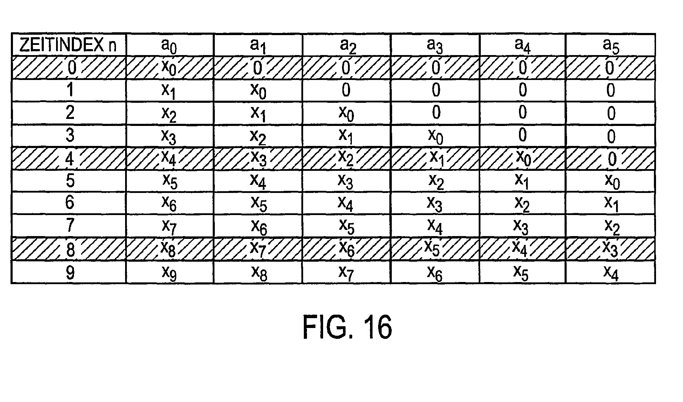

In Fig. 16 ist die zeitliche Zuordnung der Eingangsdaten x zu den Filterkoeffizienten bei der Verwendung des FIR-Filters mit sechs Koeffizienten dargestellt. Der Filterausgang ergibt sich hierbei gemäß der FIR-Filtervorschrift zu einem Ausgangswert FIR_out = $a_0$*$x_5$ + $a_1$*$x_4$ + $a_2$*$x_3$ + $a_3$*$x_2$ + $a_2$ + .... Im Falle des angenommenen Abtastratenreduktionsfaktors von R = 4 werden nur die in der tabellarischen Darstellung aus Fig. 16 dunkel hinterlegten Wertepaare nach der Abtastratenreduktion weiterverwendet, alle anderen werden verworfen.

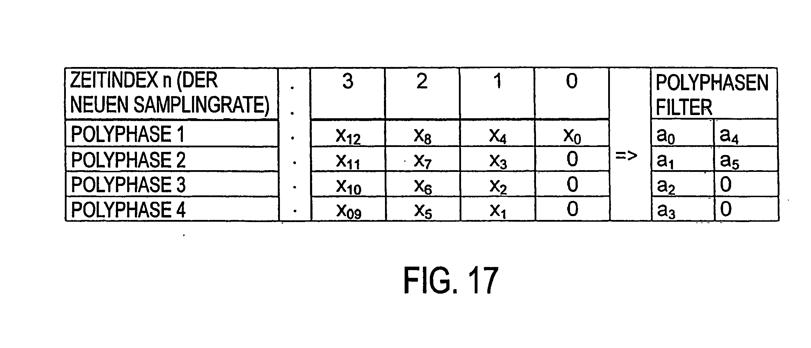

Werden die dunkel hinterlegten Zeilen extrahiert, so lässt sich eine andere Darstellung der Verknüpfung der Eingangswerte und der Filterkoeffizienten zeigen. Eine solche Darstellung ist in Fig. 17 wiedergegeben. Die beiden rechten Spalten, d. h. die Spalten, in denen die Filterkoeffizienten $a_0$ - $a_5$ eingetragen sind, enthalten die Koeffizienten jetzt in einer anderen Anordnung. Es ergeben sich die typischen Strukturen bei FIR-Filtern, die in Polyphasenstruktur implementiert sind. Jeder der einzelnen Polyphasen ("SUB FIR-Filter") besteht aus den Koeffizienten des Originalfilters. Die Zuordnung erfolgt dabei nach folgendem Schema:

Polyphase "1" : $a_{0+i}$*$_{Ratenfaktor}$
Polyphase "2" : $a_{1+i}$*$_{Ratenfaktor}$
Polyphase "3" : $a_{2+i}$*$_{Ratenfaktor}$
Polyphase "Ratenfaktor": $a_{(Ratenfaktor-1)+1}$*$_{Ratenfaktor}$
. . .
mit i = 0, 1, .... .

Im obigen Beispiel bedeutet dies bei einem Ratenfaktor von R = 4 die Zuordnung der Filterkoeffizienten $a_0$ und $a_4$ zur Polyphase 1, der Filterkoeffizienten $a_1$ und $a_5$ zur Polyphase 2, der Filterkoeffizienten $a_2$ und dem Wert 0 zur Polyphase 3 und den Filterkoeffizienten $a_3$ und dem Wert 0 zur Polyphase 4. Sollte die Anzahl der Koeffizienten des FIR-Filters nicht durch den Ratenfaktor ganzzahlig teilbar sein, so werden die fehlenden Koeffizienten durch den Wert 0 ersetzt, wie dies bei den Polyphasen 3 und 4 durchgeführt wurde.

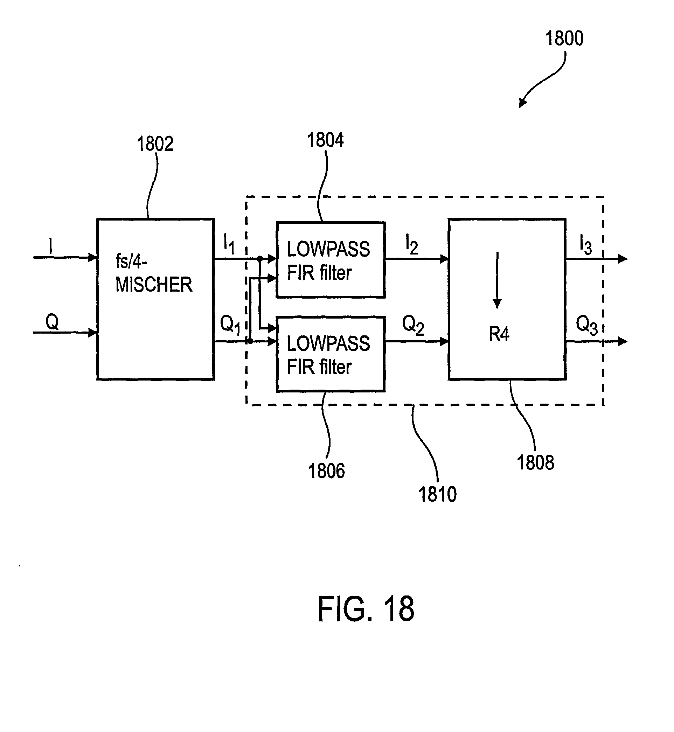

Eine derartige Polyphasenfilterstruktur kann nun effektiv zu einer Frequenzverschiebung um ein Viertel der Abtastfrequenz mit anschließender Abtastratenreduktion verwendet werden. Fig. 18 zeigt ein Blockschaltbild eines Mischers 1800, in dem die prinzipielle Funktionsweise der Frequenzverschiebung eines komplexen Signals mit darauffolgender Abtastratenreduktion um den Faktor R = 4 dargestellt ist. Der Mischer 1800 umfasst einen $f_s$/4-Mischer 1802, ein erstes Tiefpassfilter 1804, ein zweites Tiefpassfilter 1806 und eine Abtastratenreduktionseinheit 1808. Der $f_s$/4-Mischer 1802 umfasst einen ersten Eingang I zum Empfangen einer I-Komponente eines Signals und einen zweiten Eingang Q zum Empfangen einer Q-Komponente eines Signals, wobei die Q-Komponente des Signals orthogonal zur I-Komponente des Signals ist. Ferner umfasst der $f_s$/4-Mischer 1802 einen ersten Ausgang zum Ausgeben einer $I_1$-Komponente eines gemischten Signals und einen zweiten Ausgang zum Ausgeben einer $Q_1$-Komponente des gemischten Signals.

Ferner weist das erste Tiefpassfilter 1804 einen Eingang zum Empfangen der $I_1$-Komponente des frequenzumgesetzten Signals und einen Ausgang zum Ausgeben einer $I_2$-Komponente eines tiefpassgefilterten frequenzumgesetzten Signals auf. Das zweite Tiefpassfilter 1806 umfasst einen Eingang zum Empfangen der $I_1$-Komponente des frequenzumgesetzten Signals und einen Ausgang zum Ausgeben einer $Q_2$-Komponente eines tiefpassgefilterten gemischten Signals. Die Abtastratenreduktionseinheit 1808 umfasst einen ersten Eingang zum Empfangen der $I_2$-Komponente des tiefpassgefilterten gemischten Signals und einen zweiten Eingang zum Empfangen der $Q_2$-Komponente des tiefpassgefilterten gemischten Signals. Ferner umfasst die Abtastratenreduktionseinrichtung 1808 einen ersten Ausgang zum Ausgeben einer $I_3$-Komponente eines abtastratenreduzierten, tiefpassgefilterten gemischten Signals und einen zweiten Ausgang zum Ausgeben einer $Q_3$-Komponente eines abtastratenreduzierten, tiefpassgefilterten gemischten Signals.

Die Funktionsweise des in Fig. 18 dargestellten Mischers 1800 wird nachfolgend näher beschrieben. Die folgenden Ausführungen beziehen sich dabei zunächst auf ein Polyphasenfilter, welche eine Funktionalität des in Fig. 18 dargestellten Blocks 1810 realisieren. Dabei sollen durch die zu realisierenden Polyphasenfilter die Funktionalität des ersten Tiefpassfilters 1804, die Funktionalität des zweiten Tiefpassfilters 1806 und die Funktionalität der Abtastratenreduktionseinrichtung 1808 bereitgestellt werden. Die beiden dargestellten Tiefpassfilter sind hierbei als identisch anzunehmen.

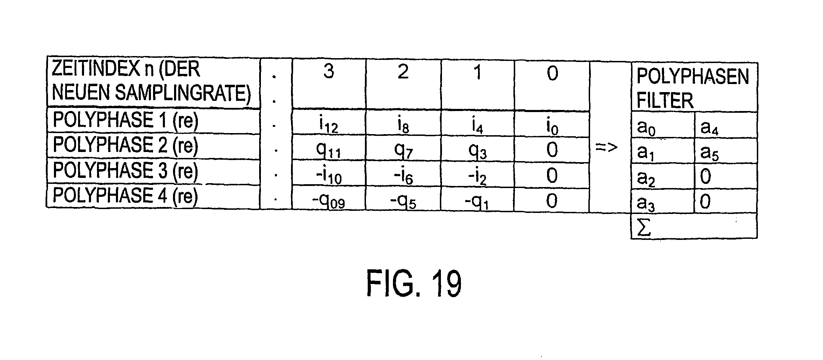

Verwendet man als (komplexe) Eingangsdaten x (=i+jq) für den Mischer 1802 (d.h. die I-Komponente und die Q-Komponente), die in Fig. 17 dargestellten Werte, ergibt sich beispielsweise bei einer Polyphasenstruktur des ersten Tiefpassfilters 1804 eine Zuordnung der Real- (i) und Imaginärteilwerte (q) der in Fig. 17 dargestellten Eingangswerte gemäß der Darstellung in Fig. 19. Die Zuordnung der aus dem Eingangssignal x entstammenden Real- und Imaginärteilwerte i und q auf das frequenzumgesetzte Signal mit den Komponenten $I_1$ und $Q_1$ erfolgt durch den Mischer 1802, der eine Negation und/oder Vertauschung von Real- und Imaginärteilwerten des Eingangssignals x auf das frequen-

zumgesetzte Signal $I_1$, $Q_1$ durchführen kann. Es ist ferner anzumerken, dass die in der Tabelle in Fig. 19 dargestellten Werte Realteilwerten entsprechen, wie sie in der tabellarischen Darstellung in Fig. 4 für eine positive Frequenzverschiebung aufgelistet sind. Die tabellarische Darstellung gemäß Fig. 19 gibt somit die Zuordnung von Werten zu vier verschiedenen Polyphasen wieder, wenn das erste Tiefpassfilter 1804 in einer vierfachen Polyphasenstruktur ausgebildet ist. Die Darstellung in Fig. 19 zeigt somit, wie der Realteil mit einer Polyphasenstruktur eines um $f_s/4$ verschobenen Signals als Eingangssignal berechnet werden kann. Hierbei ist werden die mit den entsprechenden Filterkoeffizienten $a_0$ bis $a_5$ gewichteten Real- bzw. Imaginärteilwerte der einzelnen Polyphasen-Teilfilter (Polyphase1 bis Polyphase4) aufsummiert, um das gefilterte und unterabgetastete Ausgangssignal $I_3$ zu erhalten.

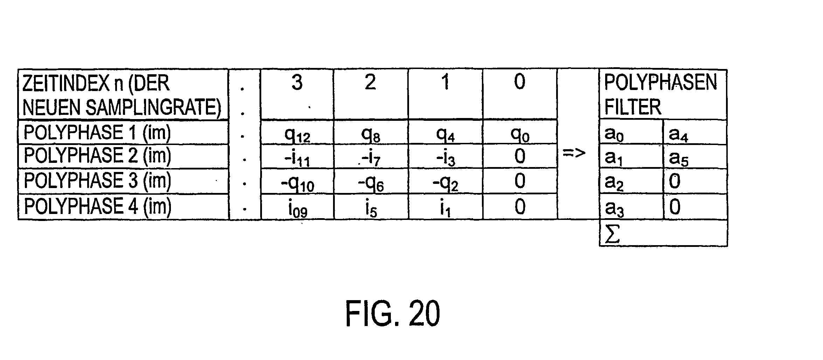

Verwendet man analog zu den obigen Ausführungen für das zweite Tiefpassfilter 1806 ebenfalls eine Polyphasenstruktur so wie die in Fig. 17 dargestellten komplexen Eingangsdaten x mit einem Realteil i und einem Imaginärteil q, dann resultiert als Ergebnis eine Zuordnung der Real- und Imaginärteile der einzelnen Abtastwerte x zu den Polyphasen gemäß der Darstellung in Fig. 20. Hierbei zeigt sich, dass die in Fig. 20 dargestellten Werte den Realteilwerten der in Fig. 4 dargestellten Übersicht bei positiver Frequenzverschiebung entsprechen. Ferner werden wiederum die mit den entsprechenden Filterkoeffizienten $a_0$ bis $a_5$ gewichteten Real- bzw. Imaginärteilwerte der einzelnen Polyphasen-Teilfilter (Polyphase1 bis Polyphase4) aufsummiert, um das gefilterte und unterabgetastete Ausgangssignal $Q_3$ zu erhalten.

Bei genauerer Betrachtung der jeweiligen Eingangsdaten x der Filter, wie sie durch die i- und q-Werte aus den Tabellen in Fig. 19 und 20 ersichtlich sind, fällt sofort auf, dass zu jedem Zeitpunkt, d. h. zu jedem Zeitindex n, die Polyphasen entweder nur mit i- oder mit q-Daten "gefüttert" werden. Aufgrund der Unabhängigkeit der einzelnen Polyphasen können diese umsortiert werden. Zur Berechnung des Realteils und des Imaginärteils des in Fig. 18 dargestellten Mischers 1800 brauchen dann nur die entsprechenden Polyphasenergebnisse summiert werden. Durch eine derartige Ausgestaltung lässt sich somit eine Tiefpassfilterung und eine Unterabtastung durchführen, indem die Eingangswerte mit den Filterkoeffizienten des (Tiefpass-) Filters $a_0$ bis $a_5$ gefiltert werden und zugleich durch die Summation der vier Polyphasenergebnisse auf ein Endergebnis die Unterabtastung durchgeführt wird.

Entsprechend dem in Fig. 18 dargestellten Mischer 1800 kann somit durch die Verwendung von zwei Polyphasenfiltern, die jeweils die Funktionalität des ersten Tiefpassfilters sowie des Abtasters oder die Funktionalität des zweiten Tiefpassfilters 1806 und des Abtastratenumsetzers 1808 umfassen, eine deutliche Vereinfachung der Schaltungsstruktur realisiert werden. So ist beispielsweise die $I_3$-Komponente, wie sie in Fig. 18 dargestellt ist, aus der Summation der Einzelergebnisse der einzelnen Polyphasen gemäß der Darstellung in Fig. 19 und die $Q_3$-Komponente des in Fig. 18 dargestellten Mischers 1800 durch eine Summation der Teilergebnisse der einzelnen Polyphasen gemäß der Summation in Fig. 20 realisierbar.

Zur Erinnerung sei an dieser Stelle angemerkt, dass die Vorzeichen der Eingangsdaten x vom vorgeschalteten Mischer stammen. In Fig. 18 wäre so der Datenstrom, bestehend aus der $I_1$- und der $Q_1$-Komponente als Eingangssignal x für die Tiefpassfilter zu verwenden. Dies betrifft insbesondere die Vorzeichen der in Fig. 19 und 20 dargestellten Polyphasen Polyphase 2 (im), Polyphase 3 (re), Polyphase 3 (im) und Polyphase 4 (re). Ist der Mischer nicht vorhanden, fallen die Vorzeichen weg bzw. wird eine andere Frequenzverschiebung gewählt, Tauschen die Vorzeichen in die Zeilen Polyphase 2 (im) und Polyphase 4 (im) sowie Polyphase 2 (re) und Polyphase 4 (re). Diese Vorzeichen können in die entsprechenden Polyphasen selbst mit aufgenommen werden. Dies ist insbesondere dann interessant, wenn immer eine der beiden Frequenzverschiebungen gewählt wird, d. h. die entsprechenden Koeffizienten negiert werden.

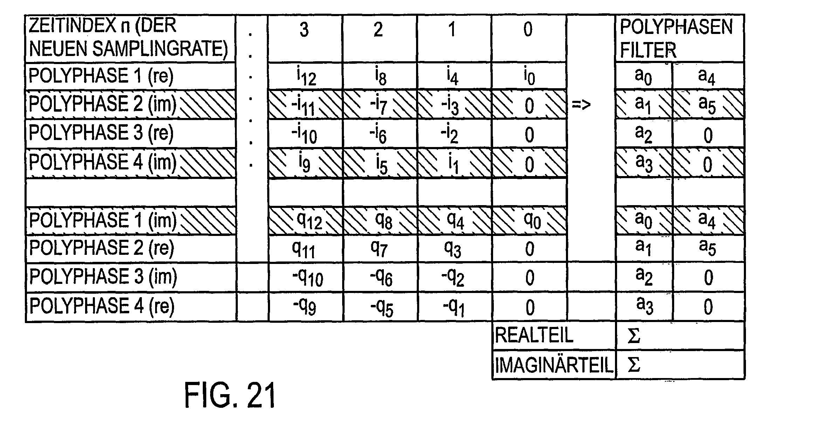

Fig. 21 zeigt eine solche Negation von einzelnen Realteilwerten i und Imaginärteilwerten q der Eingangssignalwerte x, wobei zugleich eine Umsortierung der Real- und Imaginärteilwerte auf einzelne Polyphasen der unterschiedlichen Polyphasenfilter (d. h. des Polyphasenfilters für den Realteil und des Polyphasenfilters für den Imaginärteil) erfolgt. Im folgenden werden die Polyphasen des FIR-Filters mit POLY_FIR_1, ... bezeichnet, wobei sich das Ergebnis der ersten Polyphase, d. h. von POLY_FIR_1 als Summe der mit den Filterkoeffizienten $a_0$ und $a_4$ gewichteten Eingangswerte ergibt. Für die zweite bis vierte Polyphase gelten die obigen Uasführungen analog. Die Ausgänge der Polyphasenfilter werden mit RE/IMAG_P_OUT_1 ... 4 bezeichnet. Die Eingänge der Filter werden durch den Real- und Imaginärteil repräsentiert.

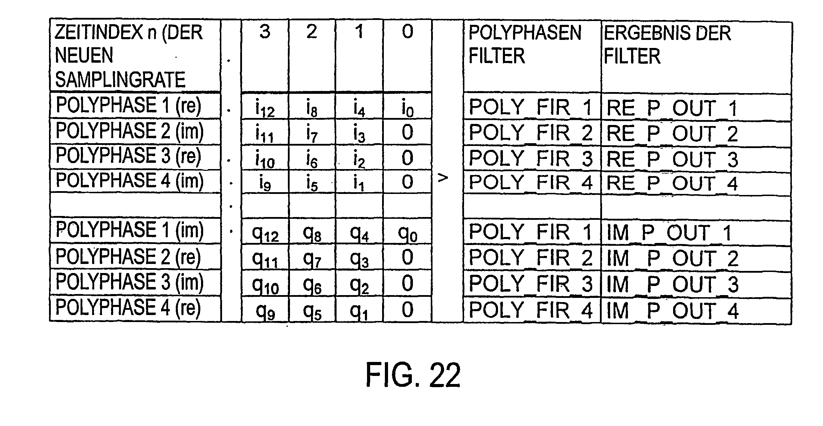

Ein allgemeiner Ansatz der Polyphasenstruktur unter Berücksichtigung einer $f_s/4$-Verschiebung ist in Fig. 22 gezeigt. Hierbei ist wiederum eine Zuordnung der Real- und Imaginärteilwerte zu den einzelnen Polyphasen dargestellt. Weiterhin ist die Bezeichnung der Ergebnisse der einzelnen Polyphasen mit RE_P_OUT_1 ... 4 und IM_P_OUT_1 ... 4 definiert. Auf der Basis der in Fig. 22 definierten Ergebnisse der Polyphasenfilter können nun drei Möglichkeiten betrachtet werden:

- keine Frequenzverschiebung;
- Frequenzverschiebung in positiver Richtung; und
- Frequenzverschiebung in negativer Richtung.

Erfolgt keine Frequenzverschiebung, ergibt sich ein Realteil des resultierenden (unterabgetasteten) Signals, das beispielsweise die $I_3$-Komponente des in Fig. 18 dargestellten Mischers 1800 ist, durch eine Summation der Er-

gbnisse der Polyphasen RE_P_OUT_1, RE_P_OUT_2, RE_P_OUT_3 und RE_P_OUT_4. Hierzu korrespondierend ergibt sich ein Imaginärteil des (unterabgetasteten) Signals, der beispielsweise der $Q_3$-Komponente des in Fig. 18 dargestellten Mischers 1800 entspricht, durch eine Summation der Ergebnisse IM_P_OUT_1, IM_P_OUT_2, IM_P_OUT_3, IM_P_OUT_4.

Wird eine Frequenzverschiebung in positiver Richtung gewählt, lässt sich der Realteil (d. h. der $I_3$-Komponente) durch eine Summation der Polyphasenergebnisse RE_P_OUT_1, IM_P_OUT_2, -RE_P_OUT_3 und -IM_P_OUT_4 ermitteln, während sich der Imaginärteil (d. h. die $Q_3$-Komponente) durch eine Summation der Polyphasenergebnisse IM_P_OUT_1, -RE_P_OUT_2, -IM_P_OUT_3 und RE_P_OUT_4 ergibt. Wird eine Frequenzverschiebung in negativer Richtung angestrebt, lässt sich der Realteil durch eine Summation der Polyphasenergebnisse RE_P_OUT_1, -IM_P_OUT_2, -RE_P_OUT_3 und IM_P_OUT_4 ermitteln, wogegen sich der Imaginärteil durch eine Summation der Polyphasenergebnisse IM_P_OUT_1, RE_P_OUT_2, -IM_P_OUT_3 und -RE_P_OUT_4 ermitteln lässt.

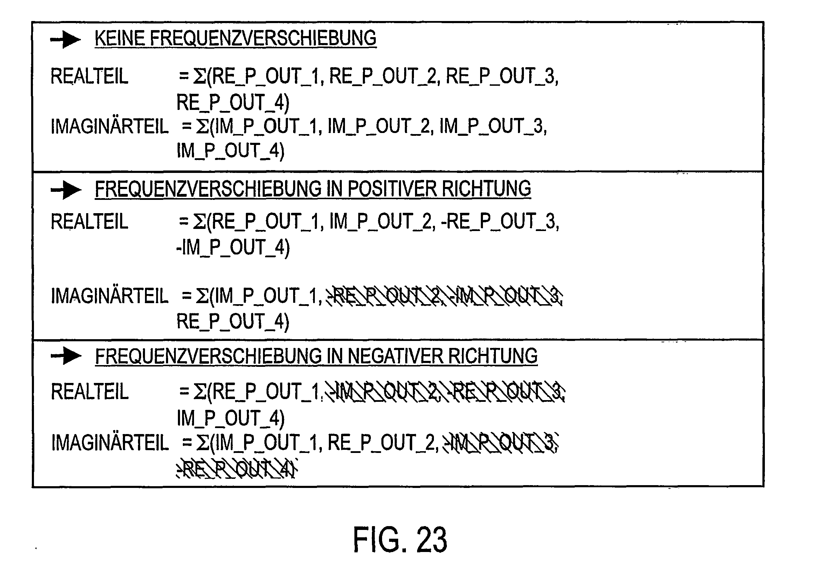

Eine Übersicht über die zu summierenden Polyphasenergebnisse für die Realisierung einer Frequenzverschiebung in die positive Richtung, einer Frequenzverschiebung in negativer Richtung und keiner Frequenzverschiebung ist in Fig. 23 dargestellt.

Hierdurch zeigt sich, dass bereits durch eine Polyphasenfilterstruktur mit einer entsprechenden Negierungs- und Umordnungsmöglichkeit ein Mischer realisierbar ist, der alle Funktionalitäten des in Fig. 18 dargestellten Mischers 1800, insbesondere der Frequenzmischung, der Tiefpassfilterung und der Unterabtastung, bietet. Dies ermöglicht es, die Negation und die Umordnung sowie die Gewichtung mit Filterkoeffizienten zur Realisierung der Tiefpassfilterung in einer beliebigen Reihenfolge durchzuführen, was sich in einer weiteren Flexibilisierung und damit in einer weiteren Verbesserung der Einsetzbarkeit des Mischers auswirkt. Ferner lassen sich durch diese zusätzliche Flexibilisierung ebenfalls Erleichterungen im Schaltungsdesign bzw. in der numerischen Komplexität erreichen, da nunmehr keine strikte Einhaltung der Abfolge der einzelnen Schritte notwendig ist, sondern vielmehr eine schaltungstechnisch oder numerisch effizientere Ausführung der $f_s/4$-Mischung zu ermöglichen.

Abhängig von den Gegebenheiten kann das erfindungsgemäße Verfahren zum spektralen Umsetzen eines Signals in Hardware oder in Software implementiert werden. Die Implementierung kann auf einem digitalen Speichermedium, insbesondere einer Diskette oder CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit einem auf einem maschinenlesbaren Träger gespeicherten Programmcode zur Durchführung des erfindungsgemäßen Verfahrens, wenn das Computerprogrammprodukt auf einem Rechner abläuft. Mit anderen Worten ausgedrückt, kann die Erfindung somit als ein Computerprogramm mit einem Programmcode zur Durchführung des Verfahrens realisiert werden, wenn das Computerprogramm auf einem Computer abläuft.

Es soll eine orthogonale Übertragung realisiert werden, in der die Signale sich nicht gegenseitig beeinträchtigen auch bei dem Vorliegen eines dispersiven (Mehrwege-) Kanal oder nicht idealem Symbol-Timing oder nicht idealer Rahmensynchronisation. Aufgrund dieser Anforderungen ist das OFDM-Verfahren (OFDM = Orthogonal Frequency Division Multiplexing = orthogonaler Frequenzmultiplex) in diesem Fall nicht anwendbar. Weiterhin sollte die Erzeugung derartiger Signale mit einer Struktur geringer Komplexität möglich sein, insbesondere unter Beachtung der Anzahl von benötigten Filterkoeffizienten und unter Berücksichtigung der Taktrate der Filter.

Eine (herkömmliche) Lösung für eine solche Aufgabe wurde in Fig. 25 dargestellt. Wird beispielsweise ein dreifaches FDM-Signal (FDM = Frequency Division Multiplexing = Frequenzmultiplex) benötigt, können spezifische Eigenschaften einer digitalen $f_s/4$-Mischung ausgenutzt werden, wobei $f_s$ die Abtastfrequenz darstellt. Näherer Details der $f_s/4$-Mischung können der vorstehenden Beschreibung entnommen werden. Wenn drei Signale zusammen gemultiplext werden sollen, kann zuerst ein Hochtasten (Upsampling) jedes der Signale von der Originalabtastfrequenz $f_{s,1}$ zu der neuen Abtastfrequenz $f_{s,2} = 4 \times f_{s,1}$ benötigt werden. Zu diesem Zweck werden drei Nullen nach jedem Abtastwert in jedes der drei Signale eingefügt. Es wird dabei angenommen, dass das Signal xplus[k] auf eine Mittenfrequenz von $+f_{s,2}/4$, das Signal xzero[k] auf eine Mittenfrequenz von 0 und das Signal xminus[k] auf eine Mittenfrequenz von $-f_{s,2}/4$ gemischt werden. Eine derartige Anordnung ist in Fig. 25 dargestellt. Nach der Einfügung von Nullen erfolgt ein Verwerfen von Spiegelfrequenzen des Originalsignals durch ein Tiefpass-Filter. Nach diesem Tiefpass-Filter ist der $f_s/4$-Mischer angeordnet, der das Signal in die gewünschte Mittenfrequenz mischt (beispielsweise für das Signal xzero[k]: keine Mischung). Schließlich werden die drei (hochgetasteten, tiefpass-gefilterten und gemischten) Signale zusammenaddiert. Hierdurch ergibt sich das Ausgangssignal y[m], dessen Abtastfrequenz der vierfachen Abtastfrequenz des Originalsignals entspricht. Durch die vorliegende Erfindung lässt sich in einer derartigen Struktur eine Vereinfachung realisieren. Aufgrund der Einfügung von drei Nullen nach jedem gültigen Abtastwert in der Überabtasteinheit, kann das Tiefpass-Filter in vier Phasen einer Polyphasen-Struktur aufgeteilt werden. Alle diese Filter (d.h. diese Phasen der Polyphasen-Struktur), die im Durchschnitt ein Viertel der Länge des Originaltiefpass-Filters aufweisen, können parallel bei einer Taktrate der Originalabtastfrequenz $f_{s,1}$ betrieben werden. Die Ausgangssignale der einzelnen Phasen der Polyphasen-Struktur werden dann mit spezifischen Konstanten (1 oder j, oder -1 oder -j) multipliziert, um den $f_s/4$-Mischer zu erhalten, bevor die durch den $f_s/4$-Mischer erhaltenen Ausgangssignale (zeitlich) gemultiplext und zusammenaddiert werden.

Eine derartige Signalkonvertiererstruktur ist in Fig. 1A dargestellt. Eine Untersuchung der Struktur in Fig. 1A und die Anwendung von einfachen Regeln für lineare Systeme offenbart, dass die Position der Multiplizierer (mit den Multiplikationsfaktoren 1, j, -1 oder -j) und die Polyphasen-Filter vertauscht werden können. Weiterhin wurde erkannt, dass zu einem Zeitpunkt jeweils immer ein Ausgang von beispielsweise allen drei Phase 0-Filtern zu dem Ausgangssignal y[m] summiert wird, und im nächsten Zeitpunkt alle drei Signale des Phase 1-Filters summiert werden, dann alle drei Ausgangssignale des Phase 2-Filters und schließlich alle Ausgangswerte des Phase 3-Filters zu einem Zeitpunkt summiert werden. Dies führt dazu, dass auch die Summation vor die Polyphasen-Filter gezogen werden kann, so dass ich eine Struktur eines Signalkonvertierers ergibt, wie sie in Fig. 1B dargestellt ist.

Die in Fig. 1B dargestellte Struktur bietet den Vorteil, dass lediglich vier Polyphasen-Filter benötigt werden, die in ihrer Komplexität einem einzigen Tiefpass-Filter anstatt von drei Tiefpass-Filtern entspricht. Hierbei ist anzumerken, dass die Multiplikation mit den Faktoren 1, j, -1 und -j in einer einfachen Art durch Vertauschung bzw. Multiplexing und Negation durchführbar ist - eine tatsächliche Ausführung einer Multiplikation ist somit nicht notwendig.

Mit einer einfachen Hochtast-Filter-$f_s/4$-Mischung-Summierungseinheit, wie sie beispielsweise in den Figuren 1A und 1B vorstehend dargestellt ist, kann ein Frequenzmultiplex von maximal drei Signalen erfolgen. Werden mehrere solcher Strukturen kaskadiert, beispielsweise für den Fall, dass der Ausgang y[m] der ersten Stufe der Eingang der zweiten Stufe wird, beispielsweise das Signal xplus [m], lässt sich ein Frequenz-Multiplexschema von maximal 3 x 3 = 9 Signalen erzeugen. In diesem Fall werden lediglich 4 x 3 = 16 Polyphasenfilter benötigt, die vier Tiefpass-Filtern entsprechen anstatt 3 x 3 + 3 = 12 Tiefpass-Filtern nach einer herkömmlichen Implementierung. Verständlicher Weise kann auch eine willkürliche Anzahl (z. B. 3 oder mehrere) solcher Hochtast-Filter-$f_s/4$-Mischer-Summierungsstufen kaskadiert werden, um die Anzahl von Signalen in einem Frequenzmultiplexschema zu erhöhen.

**Patentansprüche**

1.  Signalkonvertierer (100; 150) zum Konvertieren eines Startsignals (xplus[k]) in ein Endsignal (y[m]), mit folgenden Merkmalen:

    einer Einrichtung zum Kopieren (102) des Startsignals (xplus[k]), um vier kopierte Startsignalen (104a bis 104d) zu erhalten, wobei jedes der vier kopierten Startsignale als ein Zweigsignal in einen von vier Verarbeitungszweigen (110, 112, 114, 116) einspeisbar ist;
    wobei das Zweigsignal ein komplexes Signal mit einem Realteil und einem Imaginärteil ist;
    einer ersten Zweigverarbeitungseinrichtung in dem ersten Verarbeitungszweig (110) zum Verarbeiten eines ersten Zweigsignals (104a) gemäss einer ersten Verarbeitungsvorschrift, um ein erstes verarbeitetes Zweigsignal zu erhalten;
    einer zweiten Zweigverarbeitungseinrichtung in einem zweiten Verarbeitungszweig (112) zum Verarbeiten eines zweiten Zweigsignals (104b) gemäss einer zweiten Verarbeitungsvorschrift und unter Verwendung einer komplexen Linksdrehoperation, um ein zweites verarbeitetes Zweigsignal zu erhalten;
    einer dritten Zweigverarbeitungseinrichtung in einem dritten Verarbeitungszweig (114) zum Verarbeiten eines dritten Zweigsignals (104c) gemäss einer dritten Verarbeitungsvorschrift und unter Verwendung einer Negation, um ein drittes verarbeitetes Zweigsignal zu erhalten;
    einer vierten Zweigverarbeitungseinrichtung in einem vierten Verarbeitungszweig (116) zum Verarbeiten eines vierten Zweigsignals (104d) gemäss einer vierten Verarbeitungsvorschrift und unter Verwendung einer komplexen Rechtsdrehoperation, um ein viertes verarbeitetes Zweigsignal zu erhalten;
    wobei die erste, zweite, dritte und vierte Verarbeitungsvorschriften ausgebildet sind, um eine Tiefpass-Polyphasen-Filterung der Zweigsignale zu bewirken;
    und wobei ferner die komplexe Linksdrehoperation oder die komplexe Rechtsdrehoperation eine Realteil-Imaginärteil-Vertauschungsoperation mit einer Negation des Realteils oder des Imaginärteils umfasst;
    einer Auswahleinrichtung (2516) zum sequentiellen Auswählen des ersten verarbeiteten Zweigsignals und dann des zweiten verarbeiteten Zweigsignals, und dann das dritte verarbeitete Zweigsignal und dann das vierte verarbeitete Zweigsignal, um das Endsignal zu erhalten, wodurch das Endsignal eine im Vergleich zum Startsignal vierfache Abtastrate hat.

2.  Signalkonvertierer (100; 150) zum Konvertieren eines Startsignals (xminus[k]) in ein Endsignal (y[m]), mit folgenden Merkmalen:

    einer Einrichtung zum Kopieren (142) des Startsignals (minus[k]), um vier kopierte Startsignalen zu erhalten, wobei jedes der vier kopierten Startsignale als ein Zweigsignal in einen von vier Verarbeitungszweigen einspeisbar ist;

wobei das Zweigsignal ein komplexes Signal mit einem Realteil und einem Imaginärteil ist;

einer ersten Zweigverarbeitungseinrichtung in dem ersten Verarbeitungszweig zum Verarbeiten eines ersten Zweigsignals gemäss einer ersten Verarbeitungsvorschrift, um ein erstes verarbeitetes Zweigsignal zu erhalten;

einer zweiten Zweigverarbeitungseinrichtung in einem zweiten Verarbeitungszweig zum Verarbeiten eines zweiten Zweigsignals gemäss einer zweiten Verarbeitungsvorschrift und unter Verwendung einer komplexen Rechtsdrehoperation, um ein zweites verarbeitetes Zweigsignal zu erhalten;

einer dritten Zweigverarbeitungseinrichtung in einem dritten Verarbeitungszweig zum Verarbeiten eines dritten Zweigsignals gemäss einer dritten Verarbeitungsvorschrift und unter Verwendung einer Negation, um ein drittes verarbeitetes Zweigsignal zu erhalten;

einer vierten Zweigverarbeitungseinrichtung in einem vierten Verarbeitungszweig zum Verarbeiten eines vierten Zweigsignals gemäss einer vierten Verarbeitungsvorschrift und unter Verwendung einer komplexen Linksdrehoperation, um ein viertes verarbeitetes Zweigsignal zu erhalten;

wobei die erste, zweite, dritte und vierte Verarbeitungsvorschriften ausgebildet sind, um eine Tiefpass-Polyphasen-Filterung der Zweigsignale zu bewirken;

und wobei ferner die komplexe Linksdrehoperation oder die komplexe Rechtsdrehoperation eine Realteil-Imaginärteil-Vertauschungsoperation mit einer Negation des Realteils oder des Imaginärteils umfasst;

einer Auswahleinrichtung (2520) zum sequentiellen Auswählen des ersten verarbeiteten Zweigsignals und dann des zweiten verarbeiteten Zweigsignals, und dann das dritte verarbeitete Zweigsignal und dann das vierte verarbeitete Zweigsignal, um das Endsignal zu erhalten, wodurch das Endsignal eine im Vergleich zum Startsignal vierfache Abtastrate hat.

3. Signalkonvertierer (150) gemäß Anspruch 1 oder 2, der ferner folgende Merkmale umfasst:

eine weitere Einrichtung (132) zum Kopieren eines zweiten Startsignals (xzero[k]), um eine Mehrzahl von kopierten zweiten Startsignalen zu erhalten;

einen Zweigaddierer (152) in jedem Verarbeitungszweig (110, 112, 114, 116), wobei der Zweigaddierer (152) ausgebildet ist, um eines der Mehrzahl von kopierten zweiten Startsignalen oder ein von der Mehrzahl von kopierten zweiten Startsignalen abgeleitetes Signal mit dem kopierten Startsignal (104a, 104b, 104c, 104d) in dem Verarbeitungszweig oder einem von dem kopierten Startsignal (xplus[k]) abgeleiteten Signal zu addieren, um ein Additionssignal zu erhalten, wobei der Zweigaddierer (152) ferner so angeordnet ist, um das Additionssignal gemäß der Verarbeitungsvorschrift für den Verarbeitungszweig zu verarbeiten.

4. Signalkonvertierer (150) gemäß Anspruch 3, bei dem der Zweigaddierer (152) ferner ausgebildet ist, um zu bewirken, dass das von dem kopierten zweiten Startsignal abgeleitete Signal einem in der komplexen Zahlenebene rechts- oder linksgedrehten kopierten zweiten Startsignal entspricht.

5. Signalkonvertierer (150) gemäß Anspruch 4, bei dem ein erster Zweigaddierer (152) ausgebildet ist, um ein erstes von dem kopierten zweiten Startsignal abgeleitetes Signal bereitzustellen und bei dem ein zweiter Zweigaddierer (152) ausgebildet ist, um ein zweites von dem zweiten kopierten Startsignal abgeleitetes Signal bereitzustellen, wobei sich das erste von dem kopierten Startsignal abgeleitete Signal und das zweite, von dem kopierten Startsignal abgeleitete Signal voneinander unterscheiden.

6. Signalkonvertierer (150) gemäß einem der Ansprüche 3 bis 5, der ferner folgendes Merkmal umfasst:

eine dritte Einrichtung (142) zum Kopieren eines dritten Startsignals (xminus[k]), um eine Mehrzahl von kopierten dritten Startsignalen zu erhalten, wobei jeder Zweigaddierer (152) ausgebildet ist, um eines der Mehrzahl von kopierten dritten Startsignalen oder ein von dem kopierten dritten Startsignal abgeleitetes Signal mit dem kopierten Startsignal, dem von dem kopierten Startsignal abgeleiteten Signal, dem kopierten zweiten Startsignal, dem von dem kopierten zweiten Startsignal abgeleiteten Signal oder dem Additionssignal zu addieren, um ein weiteres Additionssignal bereitzustellen, wobei der Zweigaddierer so angeordnet ist, um das weitere Additionssignal gemäß der Verarbeitungsvorschrift für den Zweig zu verarbeiten.

7. Signalkonvertierer (150) gemäß einem der Ansprüche 3 bis 6, bei dem der Zweigaddierer (152) ferner ausgebildet ist, um zu bewirken, dass das von dem kopierten dritten Startsignal abgeleitete Signal einem in der komplexen Zahlenebene rechts- oder linksgedrehten kopierten dritten Startsignal entspricht.

8. Signalkonvertierer (150) gemäß Anspruch 7, bei dem der Zweigaddierer (152) ausgebildet ist, um eine erste komplexe Drehoperation auszuführen, um aus dem kopierten zweiten Startsignal das von dem kopierten zweiten Startsignal abgeleitete Signal zu erhalten und eine zweite komplexe Drehoperation auszuführen, um aus dem kopierten dritten Startsignal das von dem kopierten dritten Startsignal abgeleitete Signal zu erhalten, wobei sich die erste Drehoperation von der zweiten Drehoperation unterscheidet.

9. Signalkonvertierer (100) gemäß einem der Ansprüche 1 bis 2, der ferner folgendes Merkmal umfasst:

eine weitere Einrichtung (132) zum Kopieren eines zweiten Startsignals (xzero[k]), um eine Mehrzahl von kopierten zweiten Startsignalen zu erhalten, wobei ein kopiertes zweites Startsignal als Pfadsignal in einen Gewichtungspfad einspeisbar ist;

eine erste Pfadgewichtungseinrichtung in einem ersten Gewichtungspfad zum Gewichten eines ersten Pfadsignals gemäß einer ersten Gewichtungsvorschrift, um ein erstes gewichtetes Pfadsignal zu erhalten;

eine zweite Pfadgewichtungseinrichtung in einem zweiten Gewichtungspfad zum Gewichten eines zweiten Pfadsignals gemäß einer zweiten Gewichtungsvorschrift, um ein zweites gewichtetes Pfadsignal zu erhalten, wobei sich die erste Gewichtungsvorschrift von der zweiten Gewichtungsvorschrift unterscheidet und die erste und zweite Gewichtungsvorschrift ausgebildet sind, um eine Tiefpass-Polyphasenfilterung der Pfadsignale zu bewirken;

eine weitere Auswahleinrichtung zum sequentiellen Auswählen des ersten gewichteten Pfadsignals und dann des zweiten gewichteten Pfadsignals, um ein weiteres Endsignal (2532) zu erhalten; und

eine Einrichtung (2528) zum Summieren des Endsignals (2530) und des weiteren Endsignals (2532), um ein Ausgabesignal (y[m]) bereitzustellen.

10. Signalkonvertierer (100) gemäß Anspruch 9, bei dem eine Pfadgewichtungseinrichtung ausgebildet ist, um eine zusätzliche Gewichtungsoperation durchzuführen, wobei die zusätzliche Gewichtungsoperation eine Negation, eine komplexe Linksdrehoperation oder eine komplexe Rechtsdrehoperation umfasst.

11. Signalkonvertierer (100) gemäß Anspruch 9 oder 10, bei dem die weitere Einrichtung (132) zum Kopieren ausgebildet ist, um aus dem zweiten Startsignal (xzero[k]) ferner ein drittes kopiertes zweites Startsignal und ein viertes kopiertes zweites Startsignal zu bestimmen,

wobei jedes des vier kopierten zweiten Startsignale als Pfadsignal in einen von vier Gewichtungspfaden einspeisbar ist, wobei der Signalkonvertierer (100) ferner eine dritte Pfadgewichtungseinrichtung in einem dritten Gewichtungspfad aufweist, um das dritte kopierte zweite Startsignal gemäß einer dritten Gewichtungsvorschrift zu gewichten, um ein drittes gewichtetes Pfadsignal zu erhalten und eine vierte Pfadgewichtungseinrichtung in einem vierten Gewichtungspfad aufweist, um das vierte kopierte zweite Startsignal gemäß einer vierten Gewichtungsvorschrift zu gewichten, um ein viertes gewichtetes Pfadsignal zu erhalten,

und wobei die weitere Einrichtung zum Auswählen (2518) ausgebildet ist, um nach dem zweiten gewichteten Pfadsignal das dritte gewichtete Pfadsignal und dann das vierte gesichtete Pfadsignal auszuwählen, um das weitere Endsignal (2532) zu erhalten, das im Vergleich zum zweiten Startsignal (xzero[k]) eine 4-fache Abtastrate aufweist.

12. Signalkonvertierer (100) gemäß Anspruch 11, bei der sich die erste Pfadgewichtungseinrichtung von der ersten Verarbeitungsvorrichtung und die zweite Pfadgewichtungseinrichtung von der zweiten Verarbeitungsvorrichtung unterscheidet.

13. Verfahren zum Konvertieren eines Startsignals (xplus[k]) in ein Endsignal (y[m]), mit folgenden Schritten:

Kopieren (102) des Startsignals (xplus[k]), um vier kopierte Startsignalen (104a bis 104d) zu erhalten, wobei jedes der vier kopierten Startsignale als ein Zweigsignal in einen von vier Verarbeitungszweigen (110, 112, 114, 116) einspeisbar ist;

wobei das Zweigsignal ein komplexes Signal mit einem Realteil und einem Imaginärteil ist;

Verarbeiten eines ersten Zweigsignals (104a) gemäss einer ersten Verarbeitungsvorschrift in einer ersten Zweigverarbeitungseinrichtung in dem ersten Verarbeitungszweig (110), um ein erstes verarbeitetes Zweigsignal zu erhalten;

Verarbeiten eines zweiten Zweigsignals (104b) gemäss einer zweiten Verarbeitungsvorschrift in einer zweiten Zweigverarbeitungseinrichtung in einem zweiten Verarbeitungszweig (112) und unter Verwendung einer komplexen Linksdrehoperation, um ein zweites verarbeitetes Zweigsignal zu erhalten;

Verarbeiten eines dritten Zweigsignals (104c) gemäss einer dritten Verarbeitungsvorschrift in einer dritten Zweigverarbeitungseinrichtung in einem dritten Verarbeitungszweig (114) und unter Verwendung einer Negation, um ein drittes verarbeitetes Zweigsignal zu erhalten;

Verarbeiten eines vierten Zweigsignals (104d) gemäss einer vierten Verarbeitungsvorschrift in einer vierten Zweigverarbeitungseinrichtung in einem vierten Verarbeitungszweig (116) und unter Verwendung einer komplexen Rechtsdrehoperation, um ein viertes verarbeitetes Zweigsignal zu erhalten;

wobei die erste, zweite, dritte und vierte Verarbeitungsvorschriften ausgebildet sind, um eine Tiefpass-Polyphasen-Filterung der Zweigsignale zu bewirken;
und wobei ferner die komplexe Linksdrehoperation oder die komplexe Rechtsdrehoperation eine Realteil-Imaginärteil-Vertauschungsoperation mit einer Negation des Realteils oder des Imaginärteils umfasst;
sequentiellen Auswählen des ersten verarbeiteten Zweigsignals und dann des zweiten verarbeiteten Zweigsignals, und dann das dritte verarbeitete Zweigsignal und dann das vierte verarbeitete Zweigsignal in einer Auswahleinrichtung (2516), um das Endsignal zu erhalten, wodurch das Endsignal eine im Vergleich zum Startsignal vierfache Abtastrate hat.

14. Verfahren zum Konvertieren eines Startsignals (xminus[k]) in ein Endsignal (y[m]), mit folgenden Schritten:

Kopieren (142) des Startsignals (xminus[k]), um vier kopierte Startsignalen zu erhalten, wobei jedes der vier kopierten Startsignale als ein Zweigsignal in einen von vier Verarbeitungszweigen einspeisbar ist;
wobei das Zweigsignal ein komplexes Signal mit einem Realteil und einem Imaginärteil ist;
Verarbeiten eines ersten Zweigsignals gemäss einer ersten Verarbeitungsvorschrift in einer ersten Zweigverarbeitungseinrichtung in dem ersten Verarbeitungszweig, um ein erstes verarbeitetes Zweigsignal zu erhalten;
Verarbeiten eines zweiten Zweigsignals gemäss einer zweiten Verarbeitungsvorschrift in einer zweiten Zweigverarbeitungseinrichtung in einem zweiten Verarbeitungszweig und unter Verwendung einer komplexen Rechtsdrehoperation, um ein zweites verarbeitetes Zweigsignal zu erhalten;
Verarbeiten eines dritten Zweigsignals gemäss einer dritten Verarbeitungsvorschrift in einer dritten Zweigverarbeitungseinrichtung in einem dritten Verarbeitungszweig und unter Verwendung einer Negation, um ein drittes verarbeitetes Zweigsignal zu erhalten;
Verarbeiten eines vierten Zweigsignals gemäss einer vierten Verarbeitungsvorschrift in einer vierten Zweigverarbeitungseinrichtung in einem vierten Verarbeitungszweig und unter Verwendung einer komplexen Linksdrehoperation, um ein viertes verarbeitetes Zweigsignal zu erhalten;

wobei die erste, zweite, dritte und vierte Verarbeitungsvorschriften ausgebildet sind, um eine Tiefpass-Polyphasen-Filterung der Zweigsignale zu bewirken;
und wobei ferner die komplexe Linksdrehoperation oder die komplexe Rechtsdrehoperation eine Realteil-Imaginärteil-Vertauschungsoperation mit einer Negation des Realteils oder des Imaginärteils umfasst;
sequentiellen Auswählen des ersten verarbeiteten Zweigsignals und dann des zweiten verarbeiteten Zweigsignals, und dann das dritte verarbeitete Zweigsignal und dann das vierte verarbeitete Zweigsignal in einer Auswahleinrichtung (2520), um das Endsignal zu erhalten, wodurch das Endsignal eine im Vergleich zum Startsignal vierfache Abtastrate hat.

15. Computerprogramm mit Programmcode zur Durchführung des Verfahrens gemäß Anspruch 13 oder 14, wenn das Computerprogramm auf einem Computer abläuft.

**Claims**

1. Signal converter (100; 150) for converting a start signal (xplus[k]) into an end signal (y[m]), comprising the following features:

a copier (102) for copying the start signal (xplus[k]), to obtain four copied start signals (104a to 104d), wherein each of the four copied start signals may be fed into one of four processing branches (110, 112, 114, 116) as a branch signal;
wherein the branch signal is a complex signal with a real part and an imaginary part;
a first branch processor in the first processing branch (110) for processing a first branch signal (104a) according to a first processing rule, to obtain a first processed branch signal;
a second branch processor in a second processing branch (112) for processing a second branch signal (104b), according to a second processing rule and using a complex anticlockwise rotation operation, to obtain a second processed branch signal;
a third branch processor in a third processing branch (114) for processing a third branch signal (104c), according to a third processing rule and using a negation, to obtain a third processed branch signal;

a fourth branch processor in a fourth processing branch (116) for processing a fourth branch signal (104d), according to a fourth processing rule and using a complex clockwise rotation operation, to obtain a fourth processed branch signal;

wherein the first, second, third and fourth processing rules are configured so as to cause low-pass polyphase filtering of the branch signals;

and wherein further, the complex anticlockwise rotation operation or the complex clockwise rotation operation comprises a real-part imaginary-part transposition operation with a negation of the real part or the imaginary part;

a selector (2516) for sequential selection of the first processed branch signal, then of the second processed branch signal, then the third processed branch signal, and then the fourth processed branch signal, to obtain the end signal, so that the end signal has four times the sampling rate of the start signal.

2. Signal converter (100; 150) for converting a start signal (xminus[k]) into an end signal (y[m]), comprising the following features:

a copier (142) a device for copying the start signal (xminus[k]), to obtain four copied start signals, wherein each of the four copied start signals may be fed into one of four processing branches as a branch signal;

wherein the branch signal is a complex signal with a real part and an imaginary part;

a first branch processor in the first processing branch for processing a first branch signal according to a first processing rule, to obtain a first processed branch signal;

a second branch processor in a second processing branch for processing a second branch signal, according to a second processing rule and using a complex clockwise rotation operation, to obtain a second processed branch signal;

a third branch processor in a third processing branch for processing a third branch signal, according to a third processing rule and using a negation, to obtain a third processed branch signal;

a fourth branch processor in a fourth processing branch for processing a fourth branch signal, according to a fourth processing rule and using a complex anticlockwise rotation operation, to obtain a fourth processed branch signal;

wherein the first, second, third and fourth processing rules are configured so as to cause low-pass polyphase filtering of the branch signals;

and wherein further, the complex anticlockwise rotation operation or the complex clockwise rotation operation comprises a real-part imaginary-part transposition operation with a negation of the real part or the imaginary part;

a selector (2520) for sequential selection of the first processed branch signal, then of the second processed branch signal, then the third processed branch signal, and then the fourth processed branch signal, to obtain the end signal, wherein the end signal has four times the sampling rate of the start signal.

3. Signal converter (150) according to either claim 1 or claim 2, further comprising the following features:

a further device (132) for copying a second start signal (xzero[k]), to obtain a plurality of copied second start signals;

a branch adder (152) in each processing branch (110, 112, 114, 116), wherein the branch adder (152) is configured so as to add one of the plurality of copied second start signals or a signal derived from the plurality of copied second start signals to the copied start signal (104a, 104b, 104c, 104d) in the processing branch or a signal derived from the copied start signal (xplus[k]), to obtain an addition signal, wherein the branch adder (152) is further arranged so as to process the addition signal according to the processing rule for the processing branch.

4. Signal converter (150) according to claim 3, wherein the branch adder (152) is further configured so as to cause the signal derived from the copied second start signal to correspond to a copied second start signal rotated clockwise or anticlockwise in the plane of complex numbers.

5. Signal converter (150) according to claim 4, wherein a first branch adder (152) is configured so as to provide a first signal derived from the copied second start signal, and

wherein a second branch adder (152) is configured so as to provide a second signal derived from the second copied start signal, wherein the first signal derived from the copied start signal and the second signal derived from the copied start signal are different from each other.

6. Signal converter (150) according to claim 3, further comprising the following feature:

a third copier (142) for copying a third start signal (xminus[k]), to obtain a plurality of copied third start signals, wherein each branch adder (152) is configured so as to add one of the plurality of copied third start signals or a signal derived from the copied third start signal to the copied start signal, the signal derived from the copied start signal, the copied second start signal, the signal derived from the copied second start signal or the addition signal, in order to provide a further addition signal, wherein the branch adder is arranged so as to process the further addition signal according to the processing rule for the branch.

7.  Signal converter (150) according to any one of claims 3 to 6, wherein the branch adder (152) is further configured so as to cause the signal derived from the copied third start signal to correspond to a copied third start signal rotated clockwise or anticlockwise in the plane of complex numbers.

8.  Signal converter (150) according to claim 7, wherein the branch adder (152) is configured so as to perform a first complex rotation operation to obtain from the copied second start signal the signal derived from the copied second start signal, and to perform a second complex rotation operation to obtain from the copied third start signal the signal derived from the copied third start signal, wherein the first rotation operation is different from the second rotation operation.

9.  Signal converter (100) according to either claim 1 or claim 2, further comprising the following feature:

    a further copier (132) for copying a second start signal (xzero[k]), to obtain a plurality of copied second start signals, wherein a copied second start signal may be fed to a weighting path as a path signal;
    a first path weighting device in a first weighting path, for weighting a first path signal according to a first weighting rule, to obtain a first weighted path signal;
    a second path weighting device in a second weighting path, for weighting a second path signal according to a second weighting rule to obtain a second weighted path signal, wherein the first weighting rule is different from the second weighting rule and the first and second weighting rules are configured to cause low-pass polyphase filtering of the path signals;
    a further selector for sequential selection of the first weighted path signal and then of the second weighted path signal, to obtain a further end signal (2532); and
    a device (2528) for summing the end signal (2530) and the further end signal (2532) to provide an output signal (y[m]).

10. Signal converter (100) according to claim 9, wherein a path weighting device is configured so as to perform an additional weighting operation, wherein the additional weighting operation includes a negation, a complex anticlockwise rotation operation or a complex clockwise rotation operation.

11. Signal converter (100) according to either claim 9 or claim 10, wherein the further copier (132) is configured so as further to determine a third copied second start signal and a fourth copied second start signal from the second start signal,
    wherein each of the four copied second start signals may be fed as a path signal to one of four weighting paths, wherein the signal converter (100) further comprises a third path weighting device in a third weighting path, in order to weight the third copied second start signal according to a third weighting rule, to obtain a third weighted path signal, and comprises a fourth path weighting device in a fourth weighting path, in order to weight the fourth copied second start signal according to a fourth weighting rule, to obtain a fourth weighted path signal,
    and wherein the further selector (2518) is configured so as to select, after the second weighted path signal, the third weighted path signal and then the fourth weighted path signal, to obtain the further end signal (2532) which has four times the sampling rate of the second start signal (xzero[k]).

12. Signal converter (100) according to claim 11, wherein the first path weighting device is different from the first processing device and the second path weighting device is different from the second processing device.

13. Method for converting a start signal (xplus[k]) into an end signal (y[m]), comprising the following steps:

    copying (102) the start signal (xplus[k]), to obtain four copied start signals (104a to 104d), wherein each of the four copied start signals may be fed into one of four processing branches (110, 112, 114, 116) as a branch signal; wherein the branch signal is a complex signal with a real part and an imaginary part;
    processing a first branch signal (104a) in a first branch processor in the first processing branch (110) according to a first processing rule, to obtain a first processed branch signal;

processing a second branch signal (104b) in a second branch processor in a second processing branch (112), according to a second processing rule and using a complex anticlockwise rotation operation, to obtain a second processed branch signal;

processing a third branch signal (104c) in a third branch processor in a third processing branch (114), according to a third processing rule and using a negation, to obtain a third processed branch signal;

processing a fourth branch signal (104d) in a fourth branch processor in a fourth processing branch (116), according to a fourth processing rule and using a complex clockwise rotation operation, to obtain a fourth processed branch signal;

wherein the first, second, third and fourth processing rules are configured so as to cause low-pass polyphase filtering of the branch signals;

and wherein further, the complex anticlockwise rotation operation or the complex clockwise rotation operation comprises a real-part imaginary-part transposition operation with a negation of the real part or the imaginary part;

sequential selection of the first processed branch signal, then of the second processed branch signal, then the third processed branch signal, and then the fourth processed branch signal, in a selector (2516), to obtain the end signal, so that the end signal has four times the sampling rate of the start signal.

14. Method for converting a start signal (xminus[k]) into an end signal (y[m]), comprising the following steps:

copying (142) the start signal (xminus[k]), to obtain four copied start signals, wherein each of the four copied start signals may be fed into one of four processing branches as a branch signal;

wherein the branch signal is a complex signal with a real part and an imaginary part;

processing a first branch signal in a first branch processor in the first processing branch according to a first processing rule, to obtain a first processed branch signal;

processing a second branch signal in a second branch processor in a second processing branch, according to a second processing rule and using a complex clockwise rotation operation, to obtain a second processed branch signal;

processing a third branch signal in a third branch processor in a third processing branch, according to a third processing rule and using a negation, to obtain a third processed branch signal;

processing a fourth branch signal in a fourth branch processor in a fourth processing branch, according to a fourth processing rule and using a complex anticlockwise rotation operation, to obtain a fourth processed branch signal;

wherein the first, second, third and fourth processing rules are configured so as to cause low-pass polyphase filtering of the branch signals;

and wherein further, the complex anticlockwise rotation operation or the complex clockwise rotation operation comprises a real-part imaginary-part transposition operation with a negation of the real part or the imaginary part;

sequential selection of the first processed branch signal, then of the second processed branch signal, then the third processed branch signal, and then the fourth processed branch signal, in a selector (2520), to obtain the end signal, so that the end signal has four times the sampling rate of the start signal.

15. Computer program with program code for performing the method according to either claim 13 or claim 14 when the computer program runs on a computer.

**Revendications**

1. Convertisseur de signal (100 ; 150) pour la conversion d'un signal de départ (xplus[k]) en un signal final (y[m]), présentant les caractéristiques suivantes :

un dispositif pour la copie (102) du signal de départ (xplus[k]), pour obtenir quatre signaux de départ (104a à 104d), copiés, chacun des quatre signaux de départ copiés pouvant être injecté comme un signal de branche dans l'une des quatre branches de traitement (110, 112, 114, 116) ;

le signal de branche étant un signal complexe avec une partie réelle et une partie imaginaire ;

un premier dispositif de traitement de branche dans la première branche de traitement (110) pour le traitement d'un premier signal de branche (104a) selon une première spécification de traitement, afin d'obtenir un premier signal de branche traité ;

un second dispositif de traitement de branche dans une seconde branche de traitement (112) pour le traitement d'un second signal de branche (104b) selon une seconde spécification de traitement et avec l'utilisation d'une opération complexe de rotation à gauche, afin d'obtenir un second signal de branche traité ;

un troisième dispositif de traitement de branche dans une troisième branche de traitement (114) pour le traitement d'un troisième signal de branche (104c) selon une troisième spécification de traitement et avec l'utilisation d'une négation, afin d'obtenir un troisième signal de branche traité ;

un quatrième dispositif de traitement de branche dans une quatrième branche de traitement (116) pour le traitement d'un quatrième signal de branche (104d) selon une quatrième spécification de traitement et avec l'utilisation d'une opération complexe de rotation à droite, afin d'obtenir un quatrième signal de branche traité ;

la première, la deuxième, la troisième et la quatrième spécification de traitement étant conçues pour obtenir un filtrage à polyphases avec un filtre passe-bas des signaux de branche ;

et l'opération complexe de rotation à gauche ou bien l'opération complexe de rotation à droite comprenant également une opération de permutation partie réelle-partie imaginaire avec une négation de la partie réelle ou de la partie imaginaire ;

un dispositif de sélection (2516) pour la sélection séquentielle du premier signal de branche traité et ensuite du second signal de branche traité, et ensuite le troisième signal de branche traité et ensuite le quatrième signal de branche traité, afin d'obtenir le signal final, le signal final ayant un taux de balayage quadruple par rapport au signal de départ.

2. Convertisseur de signal (100 ; 150) pour la conversion du signal de départ (xminus[k]) en un signal final (y[m]), présentant les caractéristiques suivantes :

un dispositif pour la copie (142) du signal de départ (minus[k]), afin d'obtenir quatre signaux de départ copiés, chacun des quatre signaux de départ copiés pouvant être injecté sous forme d'un signal de branche dans l'une des quatre branches de traitement ;

le signal de branche étant un signal complexe avec une partie réelle et une partie imaginaire ;

un premier dispositif de traitement de branche dans la première branche de traitement pour le traitement d'un premier signal de branche selon une première spécification de traitement, afin d'obtenir un premier signal de branche traité ;

un second dispositif de traitement de branche dans une seconde branche de traitement pour le traitement d'un second signal de branche selon une seconde spécification de traitement et avec l'utilisation d'une opération complexe de rotation à droite, afin d'obtenir un second signal de branche traité ;

un troisième dispositif de traitement de branche dans une troisième branche de traitement pour le traitement d'un troisième signal de branche selon une troisième spécification de traitement et avec l'utilisation d'une négation pour obtenir un troisième signal de branche traité ;

un quatrième dispositif de traitement de branche dans une quatrième branche de traitement pour le traitement d'un quatrième signal de branche selon une quatrième spécification de traitement et avec l'utilisation d'une opération complexe de rotation à gauche, afin d'obtenir un quatrième signal de branche traité ;

la première, la deuxième, la troisième et la quatrième spécification de traitement étant conçues pour obtenir un filtrage à polyphases avec un filtre passe-bas des signaux de branche ;

et l'opération complexe de rotation à gauche ou l'opération complexe de rotation à droite comprenant une opération de permutation partie réelle-partie imaginaire avec une négation de la partie réelle ou de la partie imaginaire ;

un système de sélection (2520) pour la sélection séquentielle du premier signal de branche traité et ensuite du second signal de branche traité, et ensuite le troisième signal de branche traité et ensuite le quatrième signal de branche traité, afin d'obtenir le signal final, le signal final ayant un taux de balayage quadruple par rapport au signal de départ.

3. Convertisseur de signal (150) selon la revendication 1 ou 2, qui comprend également les caractéristiques suivantes :

un autre dispositif (132) pour la copie d'un second signal de départ (xzero[k]), afin d'obtenir une pluralité de seconds signaux de départ copiés ;

un additionneur de branche (152) dans chaque branche de traitement (110, 112, 114, 116), l'additionneur de branche (152) étant conçu pour additionner l'un de la pluralité de seconds signaux de départ copiés ou un signal déduit de la pluralité de seconds signaux de départ copiés avec le signal de départ (104a, 104b, 104c, 104d) copié dans la branche de traitement ou un signal déduit du signal de départ (xplus[k]) copié, afin d'obtenir un signal d'addition, l'additionneur de branche (152) étant disposé également pour traiter le signal d'addition selon la spécification de traitement pour la branche de traitement.

4. Convertisseur de signal (150) selon la revendication 3, dans lequel l'additionneur de branche (152) est conçu également pour obtenir que le signal déduit du second signal de départ copié corresponde à un second signal de départ copié tourné à droite ou à gauche dans le plan numérique complexe.

5. Convertisseur de signal (150) selon la revendication 4, dans lequel un premier additionneur de branche (152) est conçu pour mettre à disposition un premier signal déduit du second signal de départ copié et dans lequel un second additionneur de branche (152) est conçu pour mettre à disposition un second signal déduit du second signal de départ copié, le premier signal déduit du signal de départ copié et le second signal déduit du signal de départ copié se différenciant l'un de l'autre.

6. Convertisseur de signal (150) selon l'une quelconque des revendications 3 à 5, qui comprend également les caractéristiques suivantes :

   un troisième dispositif (142) pour la copie d'un troisième signal de départ (xminus[k]), afin d'obtenir une pluralité de troisièmes signaux de départ copiés, chaque additionneur de branche (152) étant conçu pour additionner un de la pluralité de troisièmes signaux de départ copiés ou un signal déduit du troisième de signal de départ copié avec le signal de départ copié, le signal déduit du signal de départ copié, le second signal de départ copié, le signal déduit du second signal de départ copié ou le signal d'addition, afin de mettre à disposition un autre signal d'addition, l'additionneur de branche étant disposé pour traiter l'autre signal d'addition selon la spécification de traitement pour la branche.

7. Convertisseur de signal (150) selon l'une quelconque des revendications 3 à 6, dans lequel l'additionneur de branche (152) est conçu également pour obtenir que le signal déduit du troisième signal de départ copié corresponde à un troisième signal de départ copié, tourné à droite ou à gauche dans le plan numérique complexe.

8. Convertisseur de signal (150) selon la revendication 7, dans lequel l'additionneur de branche (152) est conçu pour exécuter une première opération de rotation complexe, pour obtenir à partir du second signal de départ copié le signal déduit du second signal de départ copié et de réaliser une seconde opération de rotation complexe, afin d'obtenir à partir du troisième signal de départ copié le signal déduit du troisième signal de départ copié, la première opération de rotation se différenciant de la seconde opération de rotation.

9. Convertisseur de signal (100) selon l'une quelconque des revendications 1 à 2, qui comprend également la caractéristique suivante :

   un second dispositif (132) pour la copie d'un second signal de départ (xzéro[k]), afin d'obtenir une pluralité de seconds signaux de départ copiés, un second signal de départ copié pouvant être injecté comme signal de chemin dans un chemin de pondération ;
   un premier dispositif de pondération de chemin dans un premier chemin de pondération pour la pondération d'un premier signal de chemin selon une première spécification de pondération, afin d'obtenir un premier chemin de signal pondéré ;
   un second dispositif de pondération de chemin dans un second chemin de pondération pour la pondération d'un second signal de chemin selon une seconde spécification de pondération, afin d'obtenir un second signal de chemin pondéré, la première spécification de pondération se différenciant de la seconde spécification de pondération et la première et la seconde spécification de pondération étant conçues pour obtenir un filtrage à polyphases avec filtre passe-bas des signaux de chemin ;
   un autre dispositif de sélection pour la sélection séquentielle du premier signal de chemin pondéré et ensuite du second signal de chemin pondéré, afin d'obtenir un autre signal terminal (2532) ; et
   un dispositif (2528) pour la totalisation du signal final (2530) et de l'autre signal (2532), afin de mettre à disposition un signal de sortie (y[m]).

10. Convertisseur de signal (100) selon la revendication 9, dans lequel un dispositif de pondération de chemin est conçu pour effectuer une opération de pondération supplémentaire, l'opération de pondération supplémentaire comprenant une négation, une opération complexe de rotation à gauche ou une opération complexe de rotation à droite.

11. Convertisseur de signal (100) selon la revendication 9 ou 10, dans lequel l'autre dispositif (132) pour la copie est conçu pour déterminer à partir du second signal de départ (xzéro[k]) également un troisième, second signal de départ copié et un quatrième, second signal de départ copié, chacun des quatre seconds signaux de départ copiés pouvant être injectés comme signal de chemin dans l'un des quatre chemins de pondération, le convertisseur de signal (100) présentant également un troisième dispositif de pondération de chemin dans un troisième chemin de pondération, afin de pondérer le troisième, second signal de départ copié selon une troisième spécification de pondération, afin d'obtenir un troisième signal de chemin pondéré et présentant un quatrième dispositif de pondération de chemin dans un quatrième chemin de pondération, afin de pondérer le quatrième, second signal de départ copié selon une quatrième spécification de pondération, afin d'obtenir un quatrième signal de chemin pondéré,

et l'autre dispositif de sélection (2518) étant conçu pour sélectionner après le deuxième signal de chemin pondéré le troisième signal de chemin pondéré et ensuite le quatrième signal de chemin pondéré, afin d'obtenir l'autre signal final (2532), qui présente un taux de balayage quadruple par rapport au second signal de départ (xzéro[k]).

**12.** Convertisseur de signal (100) selon la revendication 11, sur lequel le premier dispositif de pondération de chemin se différencie du première dispositif de traitement et le second dispositif de pondération de chemin se différencie du second dispositif de traitement.

**13.** Procédé pour la conversion d'un signal de départ (xplus[k]) en un signal final (y[m]), comprenant les étapes suivantes :

copie (102) du signal de départ (xplus[k]), afin d'obtenir quatre signaux de départ (104a à 104d) copiés, chacun des quatre signaux de départ copiés pouvant être injecté comme un signal de branche dans l'une de quatre branches de traitement (110, 112, 114, 116) ;
le signal de branche étant un signal complexe avec une partie réelle et une partie imaginaire ;
traitement d'un premier signal de branche (104a) selon une première spécification de traitement dans un premier dispositif de traitement de branche dans la première branche de traitement (110) pour obtenir un premier signal de branche traité ;
traitement d'un second signal de branche (104b) selon une seconde spécification de traitement dans un second dispositif de traitement de branche dans une seconde branche de traitement (112) et avec l'utilisation d'une opération complexe de rotation à gauche, afin d'obtenir un second signal de branche traité ;
traitement d'un troisième signal de branche (104c) selon une troisième spécification de traitement dans un troisième dispositif de traitement de branche dans une troisième branche de traitement (114) et avec l'utilisation d'une négation, afin d'obtenir un troisième signal de branche traité ;
traitement d'un quatrième signal de branche (104d) selon une quatrième spécification de traitement dans un quatrième dispositif de traitement de branche dans une quatrième branche de traitement (116) et avec l'utilisation d'une opération complexe de rotation à droite, afin d'obtenir un quatrième signal de branche traité ;
la première, la deuxième, la troisième et la quatrième spécification de traitement étant conçues pour obtenir un filtrage à polyphases avec filtre passe-bas des signaux de branche ;
et l'opération complexe de rotation à gauche ou l'opération complexe de rotation à droite comprenant également une opération de permutation partie réelle-partie imaginaire avec une négation de la partie réelle ou de la partie imaginaire ;
sélection séquentielle du premier signal de branche traité et ensuite du second signal de branche traité, et ensuite le troisième signal de branche traité et ensuite le quatrième signal de branche traité dans un dispositif de sélection (2516), afin d'obtenir le signal final, le signal final ayant un taux de balayage quadruple par rapport au signal de départ.

**14.** Procédé pour la conversion d'un signal de départ (xminus[k]) en un signal final (y[m]), comprenant les étapes suivantes :

copie (142) du signal de départ (xminus[k]), pour obtenir quatre signaux de départ copiés, chacun des quatre signaux de départ copiés pouvant être injectés comme un signal de branche dans l'une de quatre branches de traitement ;
le signal de branche étant un signal complexe avec une partie réelle et une partie imaginaire ;
traitement d'un premier signal de branche selon une première spécification de traitement dans un premier dispositif de traitement de branche dans la première branche de traitement, afin d'obtenir un premier signal de branche traité ;
traitement d'un second signal de branche selon une seconde spécification de traitement dans un second dispositif de traitement de branche dans une seconde branche de traitement et avec l'utilisation d'une opération complexe de rotation à droite, afin d'obtenir un second signal de branche traité ;
traitement d'un troisième signal de branche selon une troisième spécification de traitement dans un troisième dispositif de traitement de branche dans une troisième branche de traitement et avec l'utilisation d'une négation, afin d'obtenir un troisième signal de branche traité ;
traitement d'un quatrième signal de branche selon une quatrième spécification de traitement dans un quatrième dispositif de traitement de branche dans une quatrième branche de traitement et avec l'utilisation d'une opération complexe de rotation à gauche, afin d'obtenir un quatrième signal de branche traité ;

la première, la deuxième, la troisième et la quatrième spécification de traitement étant conçues pour obtenir un filtrage à polyphases avec filtre passe-bas des signaux de branche ;

et l'opération complexe de rotation à gauche ou l'opération complexe de rotation à droite comprenant une opération de permutation partie réelle-partie imaginaire avec une négation de la partie réelle ou de la partie imaginaire ;

sélection séquentielle du premier signal de branche traité et ensuite du second signal de branche traité, et ensuite le troisième signal de branche traité et ensuite le quatrième signal de branche traité dans un dispositif de sélection (2520), afin d'obtenir le signal final, le signal final ayant un taux de balayage quadruple par rapport au signal de départ.

**15.** Programme informatique avec code de programme pour la mise en oeuvre du procédé selon la revendication 13 ou 14 lorsque le programme informatique se déroule sur un ordinateur.

FIG. 1A

FIG. 1B

FIG. 2

| ZEITINDEX n | POSITIVE FREQUENZVERSCH. | | NEGATIVE FREQUENZVERSCH. | |
|:---:|:---:|:---:|:---:|:---:|
| | $\cos(n\pi/2)$ | $\sin(n\pi/2)$ | $\cos(-n\pi/2)$ | $\sin(-n\pi/2)$ |
| 0 | 1 | 0 | 1 | 0 |
| 1 | 0 | 1 | 0 | -1 |
| 2 | -1 | 0 | -1 | 0 |
| 3 | 0 | -1 | 0 | 1 |

# FIG. 3

| ZEITINDEX n | POSITIVE FREQUENZVERSCH. | | NEGATIVE FREQUENZVERSCH. | |
|---|---|---|---|---|
| | Re{y[n]} | Im{y[n]} | Re{y[n]} | Im{y[n]} |
| 0 | i[0] | q[0] | i[0] | q[0] |
| 1 | -q[1] | i [1] | q[1] | -i [1] |
| 2 | -i [2] | -q[2] | -i [2] | -q[2] |
| 3 | q[3] | -i [3] | -q[3] | i [3] |
| 4 | i [4] | q[4] | i [4] | q[4] |
| 5 | -q[5] | i [5] | q[5] | -i [5] |
| 6 | -i [6] | -q[6] | -i [6] | -q[6] |
| 7 | q[7] | -i [7] | -q[7] | i [7] |
| 8 | i [8] | q[8] | i [8] | q[8] |
| 9 | -q[9] | i [9] | q[9] | -i [9] |
| 10 | -i [10] | -q[10] | -i [10] | -q[10] |
| 11 | q[11] | -i [11] | -q[11] | i [11] |
| 12 | i [12] | q[12] | i [12] | q[12] |
| 13 | -q[13] | i [13] | q[13] | i [13] |

# FIG. 4

500

... | x[5] | x[4] | x[3] | x[2] | x[1] | x[0] | x[-1] | x[-2] | x[-3] | ...

MULTIPLIKATIONS-
STEUEREINRICHTUNG

504

⊗ → ... | y[0] | y[-1] | y[-2] | y[-3] | ...

506 — | $C_3$ | $C_2$ | $C_1$ | $C_0$ | — 502

MULTIPLIKATIONSFAKTOR-
STEUEREINRICHTUNG

508

| $C_0=1$ | | $C_0=1$ | | $C_0=1$ |
| $C_1=-i$ | | $C_1=1$ | | $C_1=i$ |
| $C_2=-1$ | | $C_2=1$ | | $C_2=-1$ |
| $C_3=i$ | | $C_3=1$ | | $C_3=-i$ |

510a

510c

NEGATIVE
FREQUENZ-
VERSCHIE-
BUNG

KEINE
FREQUENZ-
VERSCHIE-
BUNG

POSITIVE
FREQUENZ-
VERSCHIE-
BUNG

510b

FIG. 5

602
602a
I
602b
impulsformer_out

600
UPSAMPLING-BLOCK
FREQUENZZUTEILUNG
PARAMETER:    fs_shift_1
              fs_shift_2
Q

604a
I′
604
Q′
604b
upsampling_out

FIG. 6

|1| FIR_poly_1 |2| fs_4_mixer_1 |3| FIR_poly_2 |4| fs_4_mixer_2 |5|

B_clock_16    B_clock_4    B_clock_4    B_clock

parameter fs_shift_1

parameter fs_shift_2

602  702  704  600  706  708  604

710  712

**FIG. 7**

FIG. 8



| | |
|---|---|
| -0,00161106077678 | $=a_0$ |
| -0,00234731818860 | $=a_1$ |
| -0,00173182413480 | $=a_2$ |
| 0,00000000000004 | $=a_3$ |
| 0,00720377784510 | $=a_4$ |
| 0,01062413762642 | $=a_5$ |
| 0,00794256839925 | $=a_6$ |
| -0,00000000000012 | $=a_7$ |
| -0,02082456810098 | $=a_8$ |
| -0,03123125277165 | $=a_9$ |
| -0,02379167980953 | $=a_{10}$ |
| 0,00000000000023 | $=a_{11}$ |
| 0,04899080088419 | $=a_{12}$ |
| 0,07554931686914 | $=a_{13}$ |
| 0,05947272350759 | $=a_{14}$ |
| -0,00000000000036 | $=a_{15}$ |
| -0,10789013643074 | $=a_{16}$ |
| -0,17670997703090 | $=a_{17}$ |
| -0,15044737627148 | $=a_{18}$ |
| 0,00000000000047 | $=a_{19}$ |
| 0,29590602436736 | $=a_{20}$ |
| 0,62395779269402 | $=a_{21}$ |
| 0,88655696509758 | $=a_{22}$ |
| 0,99999999999949 | $=a_{23}$ |
| 0,88655696509758 | $=a_{24}$ |
| 0,62395779269402 | $=a_{25}$ |
| 0,29590602436736 | $=a_{26}$ |
| 0,00000000000047 | $=a_{27}$ |
| -0,15044737627148 | $=a_{28}$ |
| -0,17670997703090 | $=a_{29}$ |
| -0,10789013643074 | $=a_{30}$ |
| -0,00000000000036 | $=a_{31}$ |
| 0,05947272350759 | $=a_{32}$ |
| 0,07554931686914 | $=a_{33}$ |
| 0,04899080088419 | $=a_{34}$ |
| 0,00000000000023 | $=a_{35}$ |
| -0,02379167980953 | $=a_{36}$ |
| -0,03123125277165 | $=a_{37}$ |
| -0,02082456810098 | $=a_{38}$ |
| -0,00000000000012 | $=a_{39}$ |
| 0,00794256839925 | $=a_{40}$ |
| 0,01062413762642 | $=a_{41}$ |
| 0,00720377784510 | $=a_{42}$ |
| 0,00000000000004 | $=a_{43}$ |
| -0,00173182413480 | $=a_{44}$ |
| -0,00234731818860 | $=a_{45}$ |
| -0,00161106077678 | $=a_{46}$ |

FIG. 9

48

FIG. 10

1100

FIG. 11A

FIG. 11B

FIG. 11C

FIG. 11D

| SIGNALE | WORTBREITE | DATENRATE | DATENTYP |
|---------|------------|-----------|----------|
| Net27 | tbd | B_clock | komplex |
| Net1 | tbd | B_clock | komplex |
| Net17 | tbd | B_clock | komplex |
| Net16 | tbd | B_clock | komplex |
| Net12 | tbd | B_clock_4 | komplex |
| Net13 | tbd | B_clock_4 | komplex |
| Net15 | tbd | B_clock_4 | komplex |
| Net18 | tbd | B_clock_4 | komplex |
| Net19 | tbd | B_clock_4 | komplex |
| Net20 | tbd | B_clock_4 | komplex |
| Net21 | tbd | B_clock_4 | komplex |
| Net22 | tbd | B_clock_4 | komplex |
| Net23 | tbd | B_clock_4 | komplex |
| Net24 | tbd | B_clock_4 | komplex |
| Net25 | tbd | B_clock_4 | komplex |
| Net26 | tbd | B_clock_4 | komplex |
| Net28 | tbd | B_clock_16 | komplex |
| Net29 | tbd | B_clock_16 | komplex |
| Net30 | tbd | B_clock_16 | komplex |
| Net31 | tbd | B_clock_16 | komplex |
| Net32 | tbd | B_clock_16 | komplex |
| Net33 | tbd | B_clock_16 | komplex |
| Net34 | tbd | B_clock_16 | komplex |
| Net35 | tbd | B_clock_16 | komplex |
| Net36 | tbd | B_clock_16 | komplex |

# FIG. 12

| EINGANGSSIGNAL | AUSGANGSSIGNAL | PARAMETER fs_shift_1 |
|:---:|:---:|:---:|
| Net12 | Net18 | -1 |
| Net12 | Net19 | 0 |
| Net12 | Net20 | 1 |
| Net13 | Net21 | -1 |
| Net13 | Net22 | 0 |
| Net13 | Net23 | 1 |
| Net15 | Net24 | -1 |
| Net15 | Net25 | 0 |
| Net15 | Net26 | 1 |

# FIG. 13

EP 1 825 646 B1

1400

M14
FIR

Net8        Net12

0-2-2-2

SERIELL-PARALLEL-
WANDLER

M8
FIR

Net9        Net14

0-2-2-3

M4
Demultiplex4

Net6

Input

M5
Add4

Net7

Output

0-2-2-1

M7
FIR

Net10        Net15

0-2-2-4

0-2-2-6

M12
FIR

Net11        Net13

0-2-2-5

FIG. 14

| SIGNALE | WORTBREITE | DATENRATE | DATENTYP |
|---------|-----------|-----------|----------|
| Net6 | tbd | B_clock / B_clock_4 | komplex |
| Net8 | tbd | B_clock_4 / B_clock_16 | komplex |
| Net9 | tbd | B_clock_4 / B_clock_16 | komplex |
| Net10 | tbd | B_clock_4 / B_clock_16 | komplex |
| Net11 | tbd | B_clock_4 / B_clock_16 | komplex |
| Net12 | tbd | B_clock_4 / B_clock_16 | komplex |
| Net14 | tbd | B_clock_4 / B_clock_16 | komplex |
| Net15 | tbd | B_clock_4 / B_clock_16 | komplex |
| Net13 | tbd | B_clock_4 / B_clock_16 | komplex |
| Net7 | tbd | B_clock_4 / B_clock_16 | komplex |

# FIG. 15

| ZEITINDEX n | $a_0$ | $a_1$ | $a_2$ | $a_3$ | $a_4$ | $a_5$ |
|---|---|---|---|---|---|---|
| 0 | $x_0$ | 0 | 0 | 0 | 0 | 0 |
| 1 | $x_1$ | $x_0$ | 0 | 0 | 0 | 0 |
| 2 | $x_2$ | $x_1$ | $x_0$ | 0 | 0 | 0 |
| 3 | $x_3$ | $x_2$ | $x_1$ | $x_0$ | 0 | 0 |
| 4 | $x_4$ | $x_3$ | $x_2$ | $x_1$ | $x_0$ | 0 |
| 5 | $x_5$ | $x_4$ | $x_3$ | $x_2$ | $x_1$ | $x_0$ |
| 6 | $x_6$ | $x_5$ | $x_4$ | $x_3$ | $x_2$ | $x_1$ |
| 7 | $x_7$ | $x_6$ | $x_5$ | $x_4$ | $x_3$ | $x_2$ |
| 8 | $x_8$ | $x_7$ | $x_6$ | $x_5$ | $x_4$ | $x_3$ |
| 9 | $x_9$ | $x_8$ | $x_7$ | $x_6$ | $x_5$ | $x_4$ |

FIG. 16

| ZEITINDEX n (DER NEUEN SAMPLINGRATE) | . . | 3 | 2 | 1 | 0 | | POLYPHASEN FILTER | |
|---|---|---|---|---|---|---|---|---|
| POLYPHASE 1 | . | $x_{12}$ | $x_8$ | $x_4$ | $x_0$ | | $a_0$ | $a_4$ |
| POLYPHASE 2 | . | $x_{11}$ | $x_7$ | $x_3$ | 0 | => | $a_1$ | $a_5$ |
| POLYPHASE 3 | . | $x_{10}$ | $x_6$ | $x_2$ | 0 | | $a_2$ | 0 |
| POLYPHASE 4 | . | $x_{09}$ | $x_5$ | $x_1$ | 0 | | $a_3$ | 0 |

## FIG. 17

FIG. 18

| ZEITINDEX n (DER NEUEN SAMPLINGRATE) | . | 3 | 2 | 1 | 0 | | POLYPHASEN FILTER | |
|---|---|---|---|---|---|---|---|---|
| POLYPHASE 1 (re) | . | $i_{12}$ | $i_8$ | $i_4$ | $i_0$ | | $a_0$ | $a_4$ |
| POLYPHASE 2 (re) | . | $q_{11}$ | $q_7$ | $q_3$ | 0 | => | $a_1$ | $a_5$ |
| POLYPHASE 3 (re) | . | $-i_{10}$ | $-i_6$ | $-i_2$ | 0 | | $a_2$ | 0 |
| POLYPHASE 4 (re) | . | $-q_{09}$ | $-q_5$ | $-q_1$ | 0 | | $a_3$ | 0 |
| | | | | | | | $\Sigma$ | |

## FIG. 19

EP 1 825 646 B1

| ZEITINDEX n (DER NEUEN SAMPLINGRATE) | . | 3 | 2 | 1 | 0 | | POLYPHASEN FILTER | |
|---|---|---|---|---|---|---|---|---|
| | . | . | | | | | | |
| POLYPHASE 1 (im) | . | $q_{12}$ | $q_8$ | $q_4$ | $q_0$ | | $a_0$ | $a_4$ |
| POLYPHASE 2 (im) | . | $-i_{11}$ | $-i_7$ | $-i_3$ | 0 | => | $a_1$ | $a_5$ |
| POLYPHASE 3 (im) | . | $-q_{10}$ | $-q_6$ | $-q_2$ | 0 | | $a_2$ | 0 |
| POLYPHASE 4 (im) | . | $i_{09}$ | $i_5$ | $i_1$ | 0 | | $a_3$ | 0 |
| | | | | | | | $\Sigma$ | |

FIG. 20

EP 1 825 646 B1

| ZEITINDEX n (DER NEUEN SAMPLINGRATE) | . . . | 3 | 2 | 1 | 0 | | POLYPHASEN FILTER | |
|---|---|---|---|---|---|---|---|---|
| POLYPHASE 1 (re) | . | $i_{12}$ | $i_8$ | $i_4$ | $i_0$ | | $a_0$ | $a_4$ |
| POLYPHASE 2 (im) | . | $-i_{11}$ | $-i_7$ | $-i_3$ | 0 | => | $a_1$ | $a_5$ |
| POLYPHASE 3 (re) | . | $-i_{10}$ | $-i_6$ | $-i_2$ | 0 | | $a_2$ | 0 |
| POLYPHASE 4 (im) | . | $i_9$ | $i_5$ | $i_1$ | 0 | | $a_3$ | 0 |
| | | | | | | | | |
| POLYPHASE 1 (im) | | $q_{12}$ | $q_8$ | $q_4$ | $q_0$ | | $a_0$ | $a_4$ |
| POLYPHASE 2 (re) | | $q_{11}$ | $q_7$ | $q_3$ | 0 | | $a_1$ | $a_5$ |
| POLYPHASE 3 (im) | | $-q_{10}$ | $-q_6$ | $-q_2$ | 0 | | $a_2$ | 0 |
| POLYPHASE 4 (re) | | $-q_9$ | $-q_5$ | $-q_1$ | 0 | | $a_3$ | 0 |
| | | | | | REALTEIL | | $\Sigma$ | |
| | | | | | IMAGINÄRTEIL | | $\Sigma$ | |

FIG. 21

EP 1 825 646 B1

| ZEITINDEX n (DER NEUEN SAMPLINGRATE | | 3 | 2 | 1 | 0 | | POLYPHASEN FILTER | ERGEBNIS DER FILTER |
|---|---|---|---|---|---|---|---|---|
| POLYPHASE 1 (re) | · | $i_{12}$ | $i_8$ | $i_4$ | $i_0$ | | POLY_FIR_1 | RE_P_OUT_1 |
| POLYPHASE 2 (im) | | $i_{11}$ | $i_7$ | $i_3$ | 0 | | POLY_FIR_2 | RE_P_OUT_2 |
| POLYPHASE 3 (re) | · | $i_{10}$ | $i_6$ | $i_2$ | 0 | | POLY_FIR_3 | RE_P_OUT_3 |
| POLYPHASE 4 (im) | · | $i_9$ | $i_5$ | $i_1$ | 0 | > | POLY_FIR_4 | RE_P_OUT_4 |
| | · | | | | | | | |
| POLYPHASE 1 (im) | · | $q_{12}$ | $q_8$ | $q_4$ | $q_0$ | | POLY_FIR_1 | IM_P_OUT_1 |
| POLYPHASE 2 (re) | | $q_{11}$ | $q_7$ | $q_3$ | 0 | | POLY_FIR_2 | IM_P_OUT_2 |
| POLYPHASE 3 (im) | | $q_{10}$ | $q_6$ | $q_2$ | 0 | | POLY_FIR_3 | IM_P_OUT_3 |
| POLYPHASE 4 (re) | | $q_9$ | $q_5$ | $q_1$ | 0 | | POLY_FIR_4 | IM_P_OUT_4 |

## FIG. 22

| |
|---|
| ➤ <u>KEINE FREQUENZVERSCHIEBUNG</u> |
| REALTEIL $= \Sigma$(RE_P_OUT_1, RE_P_OUT_2, RE_P_OUT_3, RE_P_OUT_4)<br>IMAGINÄRTEIL $= \Sigma$(IM_P_OUT_1, IM_P_OUT_2, IM_P_OUT_3, IM_P_OUT_4) |
| ➤ <u>FREQUENZVERSCHIEBUNG IN POSITIVER RICHTUNG</u> |
| REALTEIL $= \Sigma$(RE_P_OUT_1, IM_P_OUT_2, -RE_P_OUT_3, -IM_P_OUT_4)<br><br>IMAGINÄRTEIL $= \Sigma$(IM_P_OUT_1, ~~-RE_P_OUT_2, -IM_P_OUT_3~~, RE_P_OUT_4) |
| ➤ <u>FREQUENZVERSCHIEBUNG IN NEGATIVER RICHTUNG</u> |
| REALTEIL $= \Sigma$(RE_P_OUT_1, ~~-IM_P_OUT_2, -RE_P_OUT_3~~, IM_P_OUT_4)<br>IMAGINÄRTEIL $= \Sigma$(IM_P_OUT_1, RE_P_OUT_2, ~~-IM_P_OUT_3~~, ~~-RE_P_OUT_4~~) |

<p style="text-align:center"><strong>FIG. 23</strong></p>

EP 1 825 646 B1

FIG. 24A

EP 1 825 646 B1

2400a

2422　2406a　2404　2418　2408　2402　2412

2410

| ÜBER-ABTASTER | | TP-FILTER | | MISCHER |

2424　2416

FIG. 24B

FIG. 25

EP 1 825 646 B1

67

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **SAMUELI H et al.** A VLSI Architecture for a High-Speed All-Digital Quadrature Modulator and Demodulator for Digital Radio Applications. *IEEE JOURNAL ON SELECTED AREAS IN COMMUNICATIONS*